(19) **Europäisches Patentamt**
**European Patent Office**
**Office européen des brevets**

(11) **EP 3 446 339 B1**

(12) **EUROPEAN PATENT SPECIFICATION**

(45) Date of publication and mention
of the grant of the patent:
**17.08.2022 Bulletin 2022/33**

(21) Application number: **17716938.0**

(22) Date of filing: **18.04.2017**

(51) International Patent Classification (IPC):
***H01L 31/0352*** (2006.01)   ***H01L 31/18*** (2006.01)

(52) Cooperative Patent Classification (CPC):
**H01L 31/035281; H01L 31/1864;** Y02E 10/52;
Y02P 70/50

(86) International application number:
**PCT/EP2017/059194**

(87) International publication number:
**WO 2017/182472 (26.10.2017 Gazette 2017/43)**

(54) **SOLAR PHOTOVOLTAIC MODULE**

FOTOVOLTAISCHES SOLARMODUL

MODULE SOLAIRE PHOTOVOLTAÏQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.04.2016 EP 16165872**

(43) Date of publication of application:
**27.02.2019 Bulletin 2019/09**

(73) Proprietor: **Ecole Polytechnique Fédérale de Lausanne (EPFL)**
**1015 Lausanne (CH)**

(72) Inventors:
• **LÖPER, Philipp**
**4053 BASEL (CH)**
• **STÜCKELBERGER, Josua**
**8057 Zürich (CH)**
• **BALLIF, Christophe**
**2000 Neuchâtel (CH)**
• **HAUG, Franz-Joseph**
**2072 Saint-Blaise (CH)**
• **WYSS, Philippe**
**1400 Yverdon (CH)**

(74) Representative: **e-Patent SA**
**Rue Saint-Honoré 1**
**Case postale 2510**
**2001 Neuchâtel (CH)**

(56) References cited:
**FR-A1- 2 962 852**   **US-A1- 2011 186 111**
**US-A1- 2012 000 525**

EP 3 446 339 B1

## Description

## Technical Field

The present invention relates to the field of solar cells. More particularly, the present invention relates to a solar photovoltaic module comprising a silicon based photovoltaic element comprising a heterogeneous layer.

## Background of the invention

Today's solar cell production is dominated by two major silicon solar cell structures. These are aluminum-back surface field (Al-BSF) solar cells and passivated emitter and rear solar cells (PERC), together accounting for >80% of the world production in 2014: SEMI (2015, 31.08.2015). International Technology Roadmap forPhotovoltaics(ITRPV): http://www.itrpv.net/Reports/Downloads/2014/.

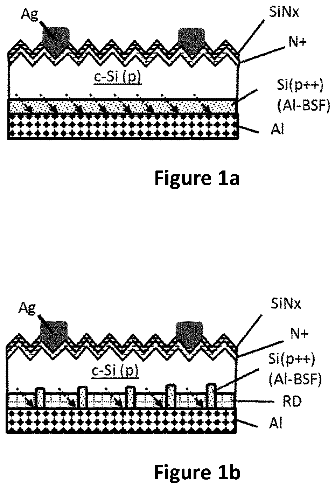

As sketched in Figure 1a and 1b, PERC cells are very similar to Al-BSF cells, but have improved performance due to a dielectric layer on the rear side, which passivates the silicon wafer surface and, if thick enough, acts as internal mirror.

Passivation of the silicon wafer surface or the silicon wafer by a certain element or process means here that the application of this element or process improves the minority charge carrier lifetime of the silicon wafer.

Silicon wafer means a sheet or layer of silicon material of at least 1 micrometer thickness. The sheet can be obtained by cutting from a larger block of silicon material, by a lift-off process from a thicker sheet, directly by crystallization of some silicon melt, or by other techniques.

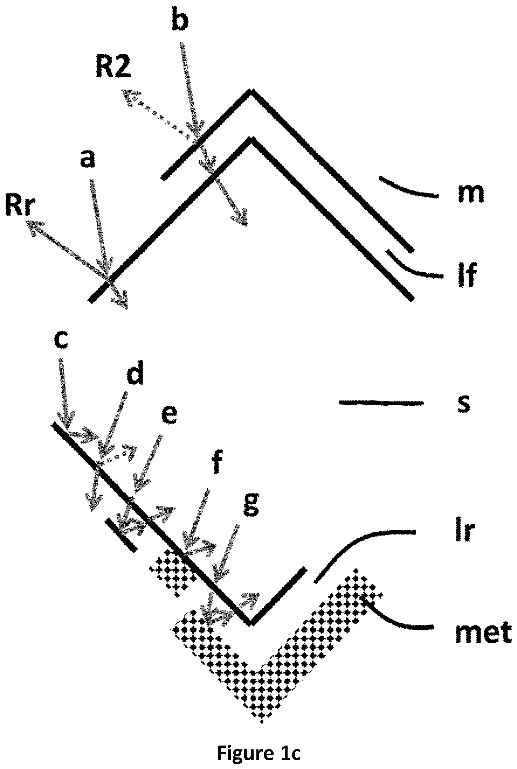

The optical functionalities of a layer on a substrate such as its use as anti-reflective layer or as internal mirror are caused by a refractive index difference between the substrate (refractive index $n_s$), the layer, and an outer medium (refractive index $n_0$). Refractive index refers to the real part of the refractive index hereinafter. Refractive index values cited hereinafter refer to a wavelength of 633nm if not specified otherwise. Here, the outer medium can be air, the encapsulation, or some other transparent material, and reflection or transmission for incidence under an angle refers to the average over both polarization directions. When light impinges directly from the medium m facing the substrate s (case a in figure 1c , a high difference in refractive index results in high reflection (Rr in figure 1c). For example, for light incident from air on a glass substrate having a refractive index of 1.5 the reflection is 4%. In the case of an air/ silicon substrate interface with said substrate having a refractive index of ca. 3.5 the reflection is about 30%. The insertion of a layer or layer stack (If in Figure 1c) having a refractive index between the refractive indices of the medium and the substrate reduces the reflection R2 (case b in figure 1c: R2)

For a chosen design-wavelength, the refractive index of the layer is ideally equal to the square-root of the product of the refractive indices of the outer medium and the substrate, and the thickness t of the layer is ideally equal to a quarter of the effective wavelength in the layer (the effective wavelength in the layer is the wavelength in air divided by the refractive index of the layer). For example, for incidence from air on silicon and a design wavelength of 600 nm, the layer should ideally have a refractive index of 1.87 and the ideal layer thickness should be about 80 nm. If there is a stack of two layers between the incident medium and the substrate, then the ideal refractive index is given by

$$ {n_1^2}\big/{n_2^2} = {n_0}\big/{n_S} $$

and the ideal thickness of each layer is equal to a quarter of the effective wavelength in this layer, $n_1$ being the refractive index of the layer oriented towards the incident medium and $n_2$ being the refractive index of the layer oriented towards the substrate.

At the rear side, there may be an outer medium, a single layer, a combination of a layer and a transparent conducting layer, a metal, or a combination of a layer and a metal, or in general a stack comprising several of the elements mentioned before. When light impinges from the substrate directly on a medium with lower refractive index than the substrate, there is a critical angle for total internal reflection, said angle being defined relative to the normal at the substrate. Light incident with a greater angle than said critical angle is totally reflected back into the substrate (case c in figure 1c) whereas light incident with a smaller angle than said critical angle is partially reflected (case d in figure 1c). The amount of partially reflected light depends on the refractive indices of the medium and of the substrate in the same way as described before. The insertion of a layer or layer stack (Ir in Figure 1c) between the substrate s and the medium can be used to reduce the amount of reflection in the same way as above (case e in figure 1c). When the rear side of the substrate is covered by a metal layer (met in Figure 1c), the reflection coefficient depends on the refractive index of the substrate and on the extinction coefficient of the metal. Said reflection coefficient is defined as the fraction of reflected to the incident light of the reflective surface. Such a reflection coefficient is usually very high and does not depend much on the angle of incidence (case f in figure 1c). For example, for a wavelength of 1200 nm, about 98% are reflected at the interface between a silicon substrate and a silver layer whereas about 88% are reflected at the interface between silicon and aluminum. In both cases, the reflection assumes a broad minimum at an incident angle of about 65° due to the excitation of the free electron plasma in the metal. The insertion of a layer (Ir in Figure 1c) between a metal layer and the substrate, having a refractive index lower than the refractive index of the substrate increases the reflection coefficient (case g in figure 1c). At the same time, the reflectance minimum assumes a lower value, and its spectral width is narrowed and its spectral position is shifted to lower angles. The value of the minimum is reduced when the layer is not fully dielectric but is a layer having a non-zero extinction coefficient. For a layer thickness equal to, or greater than the decay length of the plasma excitation, the angle at which a minimum reflection occurs approaches the value of the critical angle of the interface between the substrate and the layer. For layers thicker than a quarter of the effective wavelength in the layer, the reflection at low angles (i.e. near to normal) is reduced due to Fabry-Perot resonances.

In a standard process the open circuit voltage (Voc) is limited to 640mV. In comparison with standard processes PERC cells have improved Voc, typically between 660mV and 680mV and have improved optical properties because of the embedded dielectric layer. The wording "improved optical properties" means that the internal light reflection at the rear side is higher, which leads to a higher short circuit current (Jsc). The internal reflection is caused by the refractive index difference between the silicon absorber and the adjacent layer, which in case of commercial PERC cells typically is a layer stack comprising AlOx, SiNx and SiOx layers, which all have a refractive index lower than silicon. On the other hand PERC cells require 2 additional process steps.

The fabrication of PERC solar cells starts with boron doped wafers (p-type) that are textured and cleaned, and usually relies on at least one high-temperature steps. The first one is the diffusion of the n-type front contact in an atmosphere of POCl3 at temperatures of ca. 850°C. This step massively improves the lifetime of minority charge carriers in many silicon wafers, for example in multicrystalline, polycrystalline, quasi-monocrystalline, and other type of silicon wafers, which is linked to the gettering of impurities.

"Multicrystalline material" refers to any material consisting of more than one crystal grain hereinafter, in case of the material being a silicon wafer to multicrystalline, polycrystalline, quasi-monocrystalline, and other type of silicon wafers.

Contacts are defined as the elements which collect the charge carriers from the solar cell and provide them to an external electrical circuit. Electron contacts is also referred to as n-type contact , and hole contacts are also referred to as p-type contacts.

Solar cells have at least two contacts of opposite polarity, at least one electron contact and at least one hole contact.

Figure 1 (a) illustrates the concept of a standard p-type c-Si solar cell with texture and silicon nitride (SiNx) anti-reflective coating at the front. The rear includes an aluminium back surface field AI-BSF. The aluminum back surface field rear side suffers from strong surface recombination. The recombination is indicated by arrows in Figure 1.

After applying a silicon nitride (SiNx) anti-reflection coating to the front, the rear side is cleaned and coated with a rear dielectric layer (for example a AlOx/SiNx stack, RD in Figure 1b) for surface passivation. After patterning the rear dielectric passivation layer, front- and back-metallization is applied by screen-printing of silver- and aluminium-pastes, respectively. Subsequently, the second high-temperature step, also referred to as "co-firing" is employed, during which several crucial processes take place: S. W. Glunz , R. Preu, and D. Biro, "Crystalline silicon solar cells: state-of-the-art and future developments," in Comprehensive renewable energy. vol. 1, A. Sayigh, Ed., ed Oxford: Elsevier, 2012, pp. 353-87. Firstly, the glass frit of the front metallization sinters through the SiNx anti-reflection coating to establish the front contact. Secondly, some hydrogen is released from the SiNx layer and partly diffuses into the silicon wafer where it passivates broken silicon bonds and other defects, again a process that is indispensable in case of multicrystalline wafers and also beneficial for monocrystalline material. Hereinafter "hydrogen" refers to atomic or molecular hydrogen, deuterium or tritium which can be neutral or charged. The firing step typically involves rapid ramping to a peak temperature, typically a few seconds at ca. 850°C.

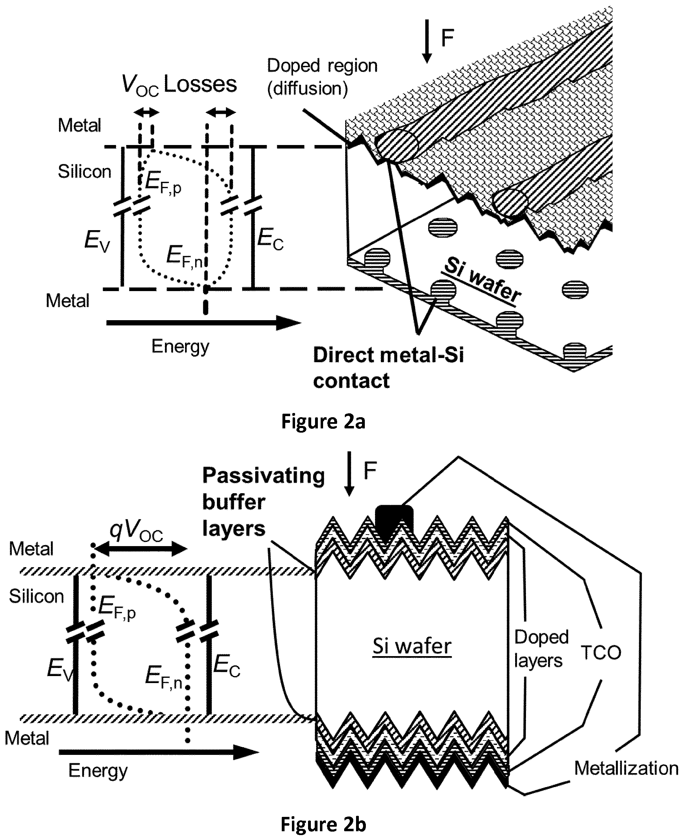

Figure 2 a-b illustrate the band structure and schematic of solar cells with direct metal-Si (a) and passivated (b) contacts. The direct Si-metal contact (present in almost all industrial metallization schemes) is extremely recombinative, leading to unacceptable voltage losses (Voc Losses) of >60 mV: A. Cuevas, "Physical model of back line-contact front-junction solar cells," Journal of Applied Physics, vol. 113, p. 164502, 2013 (Ref. A.Cuevas hereafter).

The recombination can be suppressed by a passivating buffer layer (hatched), enabling ultimately high voltages of up to 750 mV.

As mentioned already above, the major efficiency limitation of AI-BSF and also PERC solar cells arises from charge carrier recombination at the metal contacts. The surface recombination velocity is extremely high ($>10^5$ cm/s) at such direct metal-Si contacts, leading to a drop in the minority charge carriers quasi-Fermi levels ($E_{F,p}$ and $E_{F,n}$ in Fig. 2 a and Fig. 2b ) and consequently to a voltage loss, which can be >60 mV (Ref. A.Cuevas). In order to avoid such a voltage (and thus efficiency) loss, the interface between the absorber (Si wafer) and the metal has to be electrically passivated (Fig. 2b). Thin buffer layers (hatched in Fig. 2b), suppress the recombination of minority charge carriers by displacing the metal contact from the Si wafer. At the same time, the buffer layer is sufficiently conductive to extract the majority charge carriers, which are selectively contacted by a doped layer on top.

A prime example of passivated contacts is found in a-Si:H/c-Si heterojunction (SHJ) solar cells, pioneered by Sanyo/Panasonic over the past 2 decades ("Heterojunction with Intrinsic Thin layer", HIT™), and continuously optimized until reaching efficiencies up to 24.7% in 2013 as described in: K. Masuko, M. Shigematsu, T. Hashiguchi, D. Fujishima, M. Kai, N. Yoshimura, et al., "Achievement of More Than 25% Conversion Efficiency With Crystalline Silicon Heterojunction Solar Cell," IEEE Journal of Photovoltaics, vol. 4, pp. 1433-1435, November 2014 2014. (Referenced as K.Masuko hereafter).

Even though impressive results have been obtained with SHJ solar cells, they feature two major drawbacks: Due to the temperature sensitivity of a-Si:H , SHJ solar cells cannot be heat-treated at temperatures above 300°C, which renders them incompatible with industrial metallization schemes: S. De Wolf and M. Kondo, "Boron-doped a-Si:H/c-Si interface passivation: Degradation mechanism," Applied Physics Letters, vol. 91, pp. 112109/1-3, 2007 and S. De Wolf, A. Descoeudres, Z. C. Holman, and C. Ballif, "High-efficiency silicon heterojunction solar cells: a review," Green, vol. 2, DOI 10.1515/green-2011-0039, 2012.

Moreover, higher amounts of silver are required per produced Watt compared to, e.g., PERC cells. The second drawback arises from parasitic light absorption in the a-Si:H films and transparent conductive oxides (TCOs), which induces current losses of about 3 mA/cm2. These absorption effects cannot be reduced any more by further decreasing the film thickness because a certain minimum thickness of the a-Si:H layer is needed for good junction properties.

More recently, passivating contacts that are compatible with high-temperature processes, for instance with diffusion or firing, called high-temperature passivating contacts hereinafter, have been realized based on thermally annealed doped Si layers as described in the following publications:

- O. Schultz-Wittmann and D. DeCeuster, "high-efficiency solar cell structures and methods of manufacture" ," 2009 (referenced as O.Schultz herafter).
- O. Schultz-Wittmann and D. DeCeuster, "shielded electrical contact and doping through a passivating dielectric layer in a high-efficiency crystalline solar cell", " 2011, referenced as O.Schultz herafter.
- F. Feldmann and M. Hermle, "photoactive semiconductor component and method for producing a photoactive semiconductor component"," 2015 , referenced as F.Feldmann and M.Hermle hereafter.

So far high-temperature passivating contacts have been employed as rear contacts as described in : F. Feldmann, M. Bivour, C. Reichel, M. Hermle, and S. W. Glunz, "Passivated rear contacts for high-efficiency n-type Si solar cells providing high interface passivation quality and excellent transport characteristics," Solar Energy Materials and Solar Cells, vol. 120, Part A, pp. 270-274, 2014/01// 2014, referenced as F.Feldmann and B.Bivour hereafter.

Every solar cell requires at least one contact for electrons, usually doped n-type, and one for holes, usually doped p-type. If the solar cell features a high-temperature passivating contact, this contact can either be prepared with n-type or with p-type doping, and can be present on either side of the solar cell. If the solar cell features high-temperature passivating contacts both for electrons and holes, typically one high-temperature passivating contact will feature n-type doping and one high-temperature passivating contact will feature p-type doping, and either can be applied on either side of the solar cell. In an embodiment both contacts are on the same side, preferably on the rear side and preferably arranged in an interdigitated back contact (IBC) design.

All variants are possible for both p-type and n-type wafer doping.

"Interdigitated" is understood hereinafter as usually employed for back contacted solar cells, for example described in F. Granek and C. Reichel, "Back-contact back-junction silicon solar cells under UV illumination," Solar Energy Materials and Solar Cells, vol. 94, pp. 1734-40, 2010, referred to as Granek et al hereinafter.

Table I summarizes the variants for solar cells with contacts on both sides.

|  | Doping type | Doping type | Doping type | Doping type |
| --- | --- | --- | --- | --- |
| Wafer | p-type | p-type | n-type | n-type |
| Front side layer stack | p-type | n-type | p-type | n-type |
| Rear side layer stack | n-type | p-type | n-type | p-type |

**Table** I Combinations of doping type of the wafer and the front side and rear side doped layer stack for both-sides contacted solar cells.

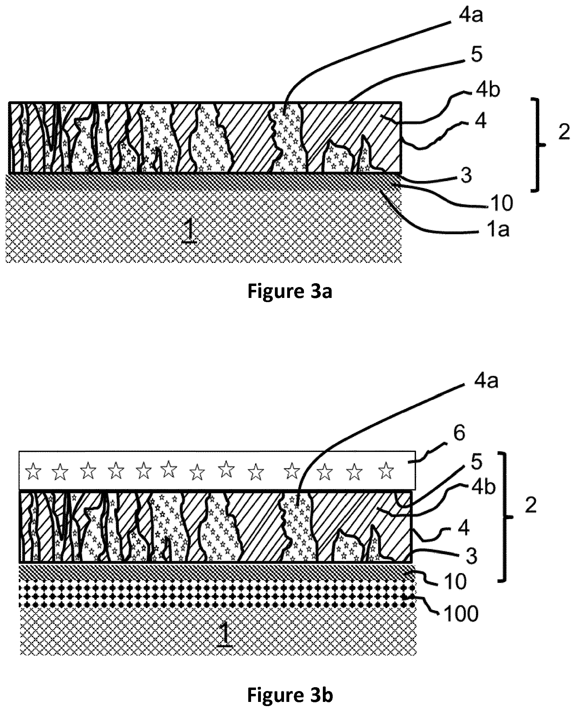

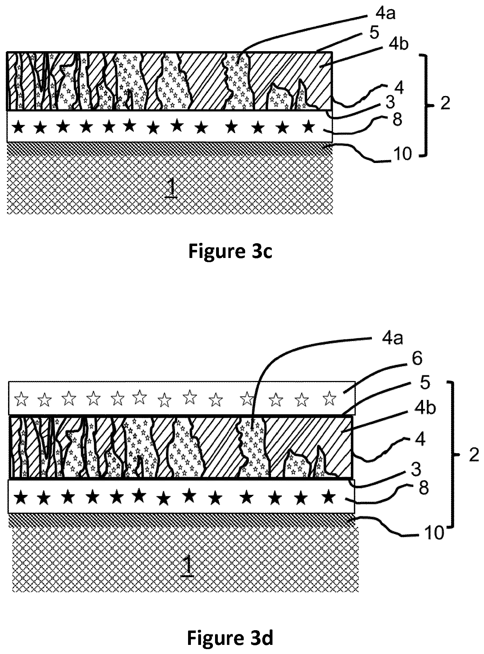

It is understood here that the front side means the incident light side, the rear side is opposite to the front side. In case of light incident on both sides of the solar cell the front side is defined as the side to which the maximum light is impinging. Silicon solar cells usually feature a surface texture as sketched for example in Figure 2 a (front side textured, texture not to scale) and b (front and rear side textured, texture not to scale). The front side F of Fig. 2 is defined as the incident light side. Other examples for surface texture of silicon solar cells can be found in S. W. Glunz , R. Preu, and D. Biro, "Crystalline silicon solar cells: state-of-the-art and future developments," in Comprehensive renewable energy. vol. 1, A. Sayigh, Ed., ed Oxford: Elsevier, 2012, pp. 353-87; see e.g. Figures. 3, 4, 14, 23, 25, 26 therein. Surface texture is omitted here and hereinafter for simplicity. All figures, descriptions and claims are however meant to also include surfaces with any surface textures.

High temperature-stable passivating contacts are commonly based on thin silicon oxide buffer layers capped with a doped silicon-based passivation layer. Instead of doping the Si passivation layer during deposition, it can also be doped from external sources (implantation, diffusion). The Si passivation layer can be amorphous, or also partially crystalline in the as-deposited state. "As-deposited" state refers to the state of the respective structure or layer after deposition before any other process, especially any further thermal treatment, is carried out. After growth or deposition of the layer stack, including preferably a SiOx buffer layer, a thermal annealing step is performed, during which the silicon passivation layer crystallizes partially and dopants diffuse from the doped Si layer through the thin silicon oxide layer into the Si wafer. This creates a highly doped region in the wafer next to the wafer surface. The benefit of such a highly doped region is twofold: It reduces charge carrier recombination at the wafer surface, and it provides a lateral charge carrier transport path, which relaxes the lateral transport requirements to the layer stack. On top of the doped Si layer, typically a transparent conductive oxide (TCO) is deposited and acts as internal rear reflector, capped with a metal electrode . The wafer can be of opposite or the same doping type (see table I). Correspondingly, the contact works as p/n- or high-low junction. Contacts employing a thin silicon oxide layer and a doped silicon layer have been employed as rear contacts in Si solar cells with very high efficiencies of 25.1%.

However, such high-temperature compatible passivating contacts feature several drawbacks (1-6):

1. For an efficient passivation of the silicon wafer, a low density of interface defect states is required. The thin silicon oxide layer prepared on the wafer surface does not provide a sufficiently low interface defect density in the as-deposited state, i.e. does not passivate the silicon wafer.

2. During the long thermal treatment needed to establish the passivating contact, hydrogen effuses from the doped Si layer, and a subsequent re-hydrogenation step, during which hydrogen from an external source is supplied to the layer stack, is necessary to achieve a low interface defect density and thus good passivation F. Feldmann, M. Bivour, C. Reichel, H. Steinkemper, M. Hermle, and S. W. Glunz, Solar Energy Materials and Solar Cells, vol. 131, pp. 46-50, 2014.

3. In most cases the Si layer is not fully crystalline even after annealing, but partially amorphous. This is described in:

F. Feldmann, M. Simon, M. Bivour, C. Reichel, M. Hermle, and S. W. Glunz, "Efficient carrier-selective p- and n-contacts for Si solar cells," Solar Energy Materials and Solar Cells, vol. 131, pp. 100-104.
Owing to the higher absorption coefficient of amorphous silicon compared to crystalline silicon, the amorphous material causes increased shadowing losses by parasitic absorption, i.e. a decreased short circuit current density. For this reason such contacts have so far only been employed on the solar cell rear side.

4. The oxide buffer layer, which is a tunnel layer, has to be chosen very thin in order to allow for efficient electrical transport. As such thin layers can rupture during a thermal treatment, the thermal treatment deteriorates the said oxide buffer layer properties. As this restricts the annealing temperature and time, it is difficult to fully crystallize the deposited silicon layer while keeping excellent surface passivation properties. As the tunnel oxide buffer layer is very thin, it does not provide good surface passivation to the silicon wafer after the thermal treatment, but needs to be re-hydrogenated.

5. As the refractive index of amorphous or partially crystalline Si is very similar to the refractive index of the Si wafer, it does not act as an internal reflector. This limits the performance of the contact when employed on the rear side, or requires additional layers such as a transparent conductive oxide (TCO), and additional process steps, such as planarization, which further increase costs and process complexity.

6. Diffusion of dopants through the tunnel oxide can deteriorate the electrical properties of the tunnel oxide layer, especially resulting in reduced passivation of the silicon wafer. Moreover, diffusion of dopants to the silicon wafer creates a highly doped region inside the silicon wafer, which generally increases charge carrier recombination and so reduces the efficiency of the solar cell .. In the highly doped region, recombination of charge carriers by the Auger effect occurs, reducing the open-circuit voltage, and also free-carrier absorption, reducing the short circuit current.

It has been proposed, as described in O.Schultz and F.Feldmann, to alloy the Si layer with carbon (C) for improved optical properties. However, carbon can react with the silicon oxide buffer layer, and effuse from the layer in the form of carbon oxide, deteriorating the silicon oxide buffer layer properties.

Alloying with nitrogen (N) or oxygen (O), i.e. layers of composition SiNxOy, SiCxOy, has also been proposed (Ref. O.Schultz), but this approach is limited to very low O concentration due to the insulating nature of SiOx. In this case, the optical functionality would be provided by the doped layer itself. For example, when a doped layer with refractive index lower than silicon and appropriately chosen thickness, is applied on the rear side between the silicon absorber wafer and the metallization it would increase reflectance compared to a case without doped layer, as explained above. However, the high doping concentration would still cause free carrier absorption, thus reducing short circuit current density.

**Summary**

The present invention solves the described limitations of prior art photovoltaic cells, and in particular enables a passivating contact of a photovoltaic cell that meets all functional requirements, which are:

- surface passivation;
- electrical contact to one charge carrier type (charge-carrier selectivity);
- electrical conductivity;
- transparency;
- low refractive index,

and is suitable for application to the front side and the rear side of solar cells.

The object of the invention is attained by a solar cell comprising a silicon layer having a first surface and a second surface opposite to said first surface. The solar cell comprises further a heterogeneous layer arranged on said first surface and/or on said second surface, having a front surface and a back surface opposite to each other. Said back surface is oriented to the side of said first surface.

The heterogeneous layer comprises an electrically low-conducting matrix made of silicon oxide. This matrix has a refractive index being lower than 3 and has electrically conducting inclusions of a conductive material, namely silicon filaments extending through the heterogenous layer. At least a portion of said inclusions being electrically interconnected such that they form a charge carrier transport path from said back surface to said front surface, so that said back surface is electrically connected to said front surface.

In an embodiment the heterogeneous layer has a higher electrical conductivity in a direction intersecting the plane of said heterogeneous layer.

In an embodiment the solar cell comprises a first heterogeneous layer arranged on said first surface and a second heterogeneous layer on said second surface.

In an embodiment said silicon light absorber layer comprises at least one highly doped layer of the same doping type than the passivating contact layer stack characterized in that the highly doped region also comprises impurities of the doping type opposite to the doping type of the heterogeneous layer, the peak concentration of said impurities of said opposite doping type being at least a factor of 2 lower than the peak concentration of said impurities of said same doping type.

The invention is also achieved by a method of fabrication of the solar cell as described before and comprises the steps of:

a) providing a doped silicon wafer having a doping concentration smaller than $1E17 cm^{-3}$;
b) applying a surface texture on at least one side of the silicon wafer;
c) cleaning the silicon wafer in a chemical solution;
d) growing a layer stack containing at least one heterogeneous layer comprising said electrically low-conducting matrix and said electrically-conducting inclusions, preferably by a PECVD or LPCVD or sputtering technique;
e) providing a first annealing step within a temperature range of 300°C-1100°C during 1s to 600min.

In an embodiment during step d) or e), or after step e), hydrogen or fluorine is transmitted through the heterogeneous layer to the silicon wafer absorber, or to at least one of any layer deposited on the silicon wafer absorber.

In an embodiment hydrogen or fluorine is distributed by a capping layer and/or by the heterogeneous layer to at least one of the layers deposited on said silicon absorber, and/or to said first surface or said second surface and/or to the inside of the silicon absorber wafer.

In an embodiment between step c) and d) additional steps are carried out, comprising the steps c1-c2:

c1) removing a surface oxide layer created by the cleaning carried out in set c);
c2) arranging a thin buffer layer on said first surface or said second surface, said thin buffer layer preferentially comprising one of the materials: Si-based oxides (such as SiOx, SiOxNy, SiOxCy which may also contain further elements), Si-based nitrides (such as SiNx, SiOxNy, SiNxCy), AlOx, HfOx, AlHfOx, AlNx, TiNx, ZrOx, Y2Ox, AlSiOx, HfSiOx, AlHfSiOx, amorphous Si compounds such as a-Si, a-SiCx, a-SiNx, a-SiOx, of which at least one compound may contain hydrogen, fluorine, phosphorous, boron, and other elements.

In an embodiment step c2) is replaced or followed by a further step c3) comprising the exposition of said first surface and/or said second surface to HNO3 and/or UV light and/or 03, and/or an oxygen-containing plasma and/or 02 and/or or H2O.

In an embodiment step d) comprises arranging a capping layer on the formed layer stack.

In an embodiment after step e) further steps e1-e2 are carried out:

e1) arranging at least one capping layer on said formed layer stack;

e2) performing a second annealing step within a temperature range of 300° C-1100°C during 1s to 600min, wherein hydrogen or fluorine is distributed from a capping layer or the heterogeneous layer to anyone of the layers deposited on said silicon absorber, or to said first surface (1a) or said second surface or to the inside of the silicon absorber wafer.

In an embodiment, before step e) or e1) or e2), a hydrogen containing layer is arranged on said second surface and said hydrogen containing layer releases hydrogen during at least one of steps e1 or e2, and the hydrogen is transmitted by said silicon absorber 1 to said first surface.

In an embodiment, before step e) or e1) or e2) a fluorine containing layer is arranged on said second surface and said fluorine containing layer releases fluorine during at least one of steps e1 or e2, and the fluorine is transmitted by said silicon absorber 1 to said first surface.

In an embodiment of the method a step is comprised of removing at least partially said capping layer after transmitting hydrogen and/or fluorine through the heterogeneous layer to the silicon wafer absorber or any layer formed on the silicon wafer absorber.

In an embodiment after step c) further steps are carried out comprising defining sites of preferential growth of said inclusions on said first surface, preferably by treating said first surface with an oxygen-containing plasma.

List of Figures

- Figure 1 a-b illustrates different solar cell structures;
- Figure 1c illustrates the refraction and reflection of light on interfaces of solar cell layers;
- Figure 2 a illustrates the band structure and schematic of a solar cell with direct metal-Si contacts (a); Figure 2 b illustrates a solar cell with passivating contacts as for example silicon heterojunction contacts;
- Figures 3 a-d illustrates different embodiments of the invention;
- Figures 4 a-d illustrates different embodiments of the invention;
- Figures 5 a-b illustrates different embodiments of the invention comprising a heterogeneous layer realized as heterogeneous multilayer;
- Figures 6a-e illustrates several possible layer stacks with a heterogeneous layer and a separation layer;
- Figures 7-20 illustrate different embodiments of the invention;
- Figure 21a illustrates the application of the heterogeneous layer to an interdigitated back contact solar cell;
- Figure 21b illustrates another application of the heterogeneous layer to an interdigitated back contact solar cell.
- Figure 22 illustrates a symmetrical test sample used for experimental optimization and analysis of the properties of a passivating contact layer stack comprising a heterogeneous layer and a conductive layer on both sides of the wafer;
- Figure 23 illustrates High-resolution transmission electron (HRTEM) micrographs of the contact structure;
- Figure 24 illustrates Transmission electron micrographs in high angle annular dark field (HAADF) of the structure in the state as-deposited state ;
- Figure 25 illustrates Transmission electron micrographs in high angle annular dark field (HAADF) of the structure in the annealed state;
- Figure 26 illustrates Transmission electron micrographs in high angle annular dark field (HAADF) and electron dispersive x-ray (EDX) mode in the as-deposited state (a), annealed at 850°C (b) and annealed at 900°C (c);
- Figure 27 illustrates Implied open-circuit voltage and emitter saturation current density for several annealing dwell temperatures for samples prepared with p-type wafers (a) and n-type wafers (b);
- Figure 28a illustrates Raman spectra of the layer stack annealed at different temperatures;
- Figure 28b illustrates the peak positions of Raman spectra of Figure 28a;
- Figures 29 a-b illustrate the sheet resistance (a) and specific contact resistivity (b) of the layer stack on a p-type wafer metallized with Al pads;
- Figure 30 illustrates secondary ion mass spectroscopy (SIMS) profiles of the highly doped region in the Si wafer directly underneath the wafer surface;

- Figure 31 illustrates the emitter saturation current density for different PH3 flows during PECVD deposition and different dwell temperatures of the annealing step performed after PECVD deposition.;
- Figure 32 illustrates the specific contact resistivity for different PH3 flows during PECVD deposition and different dwell temperatures of the annealing step performed after PECVD deposition;
- Figures 33a-b illustrate electrochemical capacitance voltage (ECV) profiles of the highly doped region in the Si wafer directly underneath the wafer surface for n-type wafers (a) and p-type wafers (b), respectively;
- Figure 34a illustrates the emitter saturation current density as function of the surface recombination velocity (SRV) as simulated by EDNA 2;
- Figure 34b illustrates the dependence of the SRV (determined from figure 34a) on relative PH3 flux.;
- Figure 34c illustrates the SRV (determined from figure 34a) as a function of phosphorous concentration at the wafer surface compared with literature results for dielectric layers;
- Figure 35 shows in (a) the Electron energy-loss spectroscopy (EELS) spectra of c-Si and phase-separated Si/SiOx regions which are used to produce an image shown in (b2 and c2) and in (b1 and c1) scanning TEM (STEM) high-angle annular dark field (HAADF) images for as-deposited state (b) and after an annealing at 850 °C (c). In (d) the corresponding structure is sketched;
- Figure 36 illustrates phosphorous ECV doping profiles measured on samples prepared with different wafer polarities and wafer doping concentrations with and without a buffer layer;
- Figure 37 illustrates the reflectance of a layer stack for varying heterogeneous layer thicknesses on an n-type wafer (a) and on a p-type wafer (b), respectively;
- Figure 38 illustrates the implied open circuit voltage (iVOC) (left axis) and the sheet resistance (RSH) (right axis) for varying heterogeneous layer thicknesses on a p-type wafer (a) and on an n-type wafer (b), respectively;
- Figure 39a illustrates a possible embodiment comprising a heterogeneous multilayer;
- Figure 39b illustrates ECV profiles measured on samples with different heterogeneous multilayers ;
- Figure 40 illustrates the refractive index n and the extinction coefficient k of an embodiment of the heterogeneous layer compared to standard materials;
- Figure 41 illustrates the internal quantum efficiency IQE of a co-diffused cell with a passivating contact layer stack of the invention as front side contact as proof of concept;
- Figure 42 illustrates improvement of the minority carrier lifetime using a capping layer acting as hydrogen donor layer;
- Figure 43 illustrates the improvement in minority carrier lifetime with higher anneal dwell temperatures for a boron doped layer stack;
- Figure 44 illustrates the influence of an intrinsic interlayer on the doping profile for several anneal dwell temperature;
- Figure 45 shows the effective minority carrier lifetimes for varying annealing dwell times (a) and the respective ECV profiles (b);
- Figure 46 illustrates boron profiles measured by ECV on different wafer polarities with and without a buffer layer;
- Figure 47 depicts thickness maps of the silicon oxide buffer layer prepared on a p-type wafer (a) and on n-type wafer (b), respectively;
- Figure 48a shows the effective minority charge carrier lifetime for samples comprising heterogeneous multilayers;
- Figure 48b shows the effective minority charge carrier lifetime for varying CO2 flow during PECVD deposition;
- Figure 49 shows the influence of different preparation methods for the buffer layer on its thickness (a), its passivation quality (b) and the diffusion through it (c).

**Detailed description**

The solar cell of the invention comprises a silicon layer 1, also defined as silicon absorber 1, having a first surface 1a and a second surface 1b opposed to said first surface 1a.

In order to solve the problems of photovoltaic cells of prior art, the photovoltaic cell of the invention comprises a light absorbing substrate, also defined as light absorbing silicon layer 1, and at least a passivating contact layer stack 2, also defined as passivating layer stack 2 or layer stack 2 comprising at least a heterogeneous passivation layer, also defined as heterogeneous layer 4, also defined as heterogeneous multilayer 4. A heterogeneous layer 4 is always present to the side of said surface 1a. Said passivating layer stack 2 may comprise a passivation layer 10, also defined as buffer layer 10 that may be a silicon oxide passivation layer that may be at least a doped silicon-based passivation layer. Said passivating layer stack may comprise at least one or two conductive layers 6, 8. The conductive layers 6, 8 may be of the same material as the conductive phase 4a or the heterogeneous layer 4, but in general the conductive layers 6, 8 can also be of a different material. The heterogeneous layer 4 is arranged on said first surface 1a and/or on said second surface 1b, and has a front surface 5 and a back surface 3 opposite to said front surface 5. Said back surface 3 is arranged to the side of said first surface 1a. As further described, layers may be adapted between said back surface 3 and said first surface 1a.

The heterogeneous layer 4 comprises a non conducting matrix 4b. This matrix 4b has a refractive index lower than 3, preferentially lower than 2.6. The heterogeneous layer further comprises inclusions 4a of at least one conductive material in said matrix 4b, and at least some of said inclusions 4a extending from said front surface 5 to said back surface 3 of the heterogeneous layer so that said front surface 5 to said back surface 3 are electrically connected.

During the manufacturing process described further, the heterogeneous layer 4 allows to transfer hydrogen or fluorine from said front surface 5 to said back surface 3 during the manufacturing process of the solar cell.

As further described also in the method of fabrications, the role of hydrogen can also be fulfilled by fluorine, potentially also other elements such as oxygen, nitrogen.

At least one layer of the solar cell contains hydrogen, and may be a capping layer or is a hydrogen donor layer.

"Heterogeneous layer" refers in this document to a layer composed of at least two separate phases of different materials, e.g. Si and SiNx, or Si and SiOx, which are mixed heterogeneously. The wording phase is understood as a portion of the heterogeneous layer. The portion of the passivating layer stack 2 in which the phases 4a, 4b are mixed, meaning that the conducting phase 4a is embedded in the non-conducting phase 4b is defined as heterogeneous layer 4 and is illustrated in Fig 3a. The heterogeneous layer 4 comprises a low conducting phase 4b, which may be non-conducting, and is defined as a low conducting matrix 4b and also defined as matrix 4b hereafter, and comprises a second, electrically conducting phase 4a, defined as conducting phase 4a or phase 4a, which is defined as the inclusions. Otherwise said conductive phase 4a is present as an inclusion in the low conducting matrix 4b.

It is understood that the heterogeneous layer 4 may comprise a plurality of different types of non conducting portions and/or a plurality of plurality of different types of conducting portions. For example, a heterogeneous layer may comprise a silicon oxide matrix portion, an amorphous silicon conductive portion and a crystalline silicon conductive portion. As another example, a heterogeneous layer may contain a silicon nitride matrix portion and a silicon oxide matrix portion and amorphous or crystalline silicon conductive portions. The conductive portion can also change over the thickness of the heterogeneous layer, which could also be expressed as a graded heterogeneous layer. For example, for a silicon conductive portion, the conductive portion could be mainly amorphous silicon on one side of the heterogeneous layer, and mainly crystalline silicon on the other side of the heterogeneous layer. The heterogeneous layer could thus also be described as a layer with graded crystallinity. In general, the conductive phase 4a will dominate the electrical conductivity of the heterogeneous layer 4 in a sagittal direction. The wording sagittal direction is defined as the direction of charge carrier flow in the solar cell, i.e. from the silicon wafer 1 to a charge collecting electrode, which is preferably from one side of the heterogeneous layer 4 to its opposite side. Sagittal means here any direction that defines an angle relative to the plane of the heterogeneous layer 4.

The conductive phase 4a is percolating, i.e. forms an electrically interconnected network throughout the heterogeneous layer, preferentially in sagittal direction which enables charge carrier transport through the heterogeneous layer 4 in sagittal direction. More precisely, the heterogeneous layer 4 comprises at least one path of preferred electrical conductivity that extends from one side of the heterogeneous layer to the other side, enabling to make an electrical contact between the two sides.

The heterogeneous structure of the heterogeneous layer 4 is typically formed during the growth of the layer and/or a subsequent annealing step. The annealing step can be a thermal anneal, or also a rapid thermal anneal, flash lamp anneal, laser anneal, electron beam anneal or similar. If the heterogeneous layer 4 features a mixed-phase structure, meaning including said phases 4a and 4b, already in the as-deposited state, annealing can lead to further phase separation or also to phase de-separation.

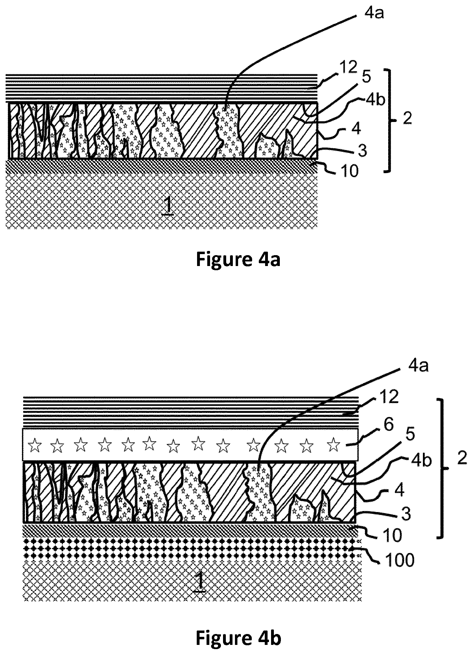

The matrix 4a and the conductive phase 4b may have the form of non regular pillars or non regular filaments through the heterogeneous layer 4 as sketched for several different possible size ratios in Figure 3a. For example, the conductive phase 4a can be silicon (Si) or microcrystalline Si ($\mu$c-Si) and the matrix phase 4b silicon oxide (SiOx). On the heterogeneous layer a first full area conductive layer 6 can be deposited and/or a second conductive layer 8 can be arranged underneath the heterogeneous layer as sketched in Figure 3b-d and Figure 4b-d.

Depending on the realization of the heterogeneous layer 4, it might be possible to attain all required functionalities of the contact, i.e. passivation of the silicon wafer 1, charge carrier selectivity, electrical transport from the silicon wafer to the metallization, transparency and a low refractive index, with this layer. The refractive index of the heterogeneous layer is the effective refractive index, usually evaluated based on a mathematical model of the heterogeneous portion of the layer. An appropriately chosen matrix 4b material can also provide passivation of the silicon absorber wafer surface as additional benefit. Experiments have proven that for $SiO_x$ as matrix material, re-hydrogenation after the thermal treatment might not be necessary. This holds for the case with and also without a buffer layer 10 arranged between the heterogeneous layer 4 and the silicon absorber 1.

In many cases, however, hydrogenation improves the contact properties. It has been demonstrated that in those cases in which without hydrogenation after the thermal treatment the wafer interface is not well passivated, the addition of fluorine to the layer stack enhances passivation even without further hydrogenation during the manufacturing. Fluorine can be added already in the growth of the layer stack, for example using a fluorine compound as precursor gas or target, or afterwards for example by ion implantation.

Adding fluorine already in the growth of the layers of the solar cell of the invention is advantageous because it reduces the total number of process steps as described in the method section further. During thermal treatment, the fluorine can then be redistributed and can diffuse to the interface between the wafer and the layer which is in contact with the wafer 1, enhancing so the passivation of the wafer surface 1a, 1b.

Apart from hydrogen, also other elements or compounds may passivate the layers of the solar cell, for example the silicon wafer or any interface between any layers of the solar cell. These are preferably hydrogen, fluorine, nitrogen, or oxygen, referred to as passivating species hereinafter. The incorporation of any of these passivating species is part of the invention. For example said passivating species may be incorporated in the layer stack 2 such that they are distributed during the thermal treatment to enhance passivation of the silicon absorber wafer. The process of providing passivating species is consequently defined here as "hydrogenation", "fluorination", "nitrogenation", "oxygenation", etc.

Adding the passivating species, preferably hydrogen or fluorine, to the layer stack 2 or the silicon wafer 1 of the solar cell can also have additional effects: The passivating species, preferably hydrogen or fluorine, can bond to dopant impurities, deactivating the dopant. Moreover, the passivating species, preferably hydrogen or fluorine can bond to fixed charges and influence the fixed charge density. It is part of the invention that hydrogenation or fluorination is utilized to adapt the doping, fixed charges, or band bending. For example, the buffer layer 10, or the heterogeneous layer or the conductive layer might contain fixed charges. Fixed charges induce an electronic band bending in the silicon wafer 1. For example, fixed charges of the same polarity as the silicon wafer (for example negative charges on a n-type wafer) can deplete the surface-near region in the wafer, which is detrimental for passivation. Neutralization of the fixed charges by hydrogenation or fluorination can thus lead to more beneficial band bending and thus better passivation of the silicon wafer.

Part of the invention is that at least one layer of the layer stack deposited on the light absorbing silicon substrate 1 contains hydrogen or fluorine in a concentration of at least $10^{16}$ cm$^{-3}$, and acts as hydrogen or fluorine donor layer to hydrogenate the light absorbing silicon substrate 1 and/or the interface between the light absorbing silicon substrate 1 and a buffer layer 10, and/or the interface between the light absorbing silicon substrate 1 and/or any of the adjacent layers of the substrate 1, for instance the heterogeneous layer 4. The hydrogen or fluorine may also be distributed to several of the other layers of the layer stack of the light absorbing silicon substrate 1. One possibility is that the heterogeneous layer 4 itself contains hydrogen or fluorine and releases this during the solar cell fabrication process to hydrogenate or fluorinate said elements, as described further in the method of manufacturing. It is understood that hydrogenation and fluorination can also be beneficially combined, either being carried out during the same or in different process steps. For example, the silicon wafer interfaces 1a, 1b can be fluorinated beneficially from some of the layers of the layer stack 2 during some of the at least one thermal treatments. Afterwards, a hydrogen containing layer can be prepared on the silicon wafer and release hydrogen in a further thermal treatment, and hydrogenate the silicon wafer and/or the layer stack 2.

It has to be noticed that in embodiments, when a buffer layer 10 is not included, the interface between the wafer and the layer stack is also hydrogenated or fluorinated.

Alternatively, an additional layer 12 can act as hydrogen or fluorine donor, this additional layer may be arranged on the heterogeneous layer to the side away from the absorber layer 1, and is referred to as a capping layer 12, as illustrated in Figure 4a-d.

Alternatively, it is advantageous to utilize the high diffusivity of hydrogen in silicon to distribute hydrogen from the other side of the light absorbing silicon layer to said layer stack 2. More particular, a hydrogen containing layer, can be arranged on the side of the light absorbing silicon layer opposed to the side on which the layer stack 2 is arranged. During manufacturing of the solar cell said hydrogen containing layer can release hydrogen, and the hydrogen can be transmitted through the light absorbing silicon layer to the layer stack 2, where the hydrogen can hydrogenate electronic defect states at the interface between the light absorbing silicon substrate 1 and a buffer layer 10, or the interface between the light absorbing silicon substrate 1 and any adjacent layer, for instance the heterogeneous layer.

1) A low refractive index can be attained thanks to its non conducting portion (e.g. SiOx), while maintaining the sagittal conductivity of the layer thanks to the percolating network of the conductive phase (e.g. Si).

2) The layer can be doped, in which case it can act as doping source for the wafer 1 during an annealing step. Both the conductive phase and the matrix phase can store dopants and also act as dopant source. This effect relies on the following physical phenomenon: The segregation coefficient k for the dopant can be $\neq 1$ for the materials in A and B, with A being the wafer or one other layer in the layer stack or of the conductive phase of the heterogeneous layer or the conductive layer, and B being the matrix phase of the heterogeneous layer.

$$k = {C_{eq,A}}\big/{C_{eq,B}}$$

$C_{eq,A}$ is the equilibrium concentration of the dopant in material A, and $C_{eq,B}$ is the equilibrium concentration of the dopant in material B.

For k>1, dopants can be expelled from B to A during a thermal treatment, resulting in a step in the doping profile. This effect can be utilized for instance

I) to expel dopants during a thermal treatment from one of the phases of the heterogeneous layer to the other, which can for example foster conductivity in the latter. Preferentially to expel dopants from the matrix phase 4b to the conductive phase 4a, fostering conductivity in the conductive phase 4a;

II) to expel dopants during a thermal treatment from one of the phases of the heterogeneous layer 4 to the silicon wafer 1, creating a dopant profile in the wafer which can be influenced with the properties of the heterogeneous layer

III) to expel dopants during a thermal treatment from one of the phases of the heterogeneous layer to the conductive layer, potentially useful to increase doping concentration in the latter.

3) Consequently, the doping profile can depend on the properties (composition, doping, thickness) of the heterogeneous layer. The layer can thus be tuned towards achieving a specific doping profile in the wafer or some other adjacent layer without changing the conditions of the thermal treatments. This renders the passivation contact layer stack very versatile and facilitates process integration.

4) During deposition dopants can be preferentially included in the matrix, the matrix thus acting as a reservoir of dopants and acting as a dopant source during annealing treatment. In addition, for segregation coefficients k>1 and the matrix portion being material B in above equation and material A being the wafer or another layer in the layer stack, dopants will segregate from B to A during the at least one thermal treatment, the matrix phase 4b thus acting as a dopant source even if initially both materials are equally doped. Both effects (preferential inclusion and segregation of dopants) together illustrate the potential use of the matrix portion as dopant source. One application is to create a doping profile in an initially only lowly doped (<1E17cm$^{-3}$;the symbol E in this document meaning the exponential based on 10, i.e. 1Ex meaning $1.10^x$ ) light absorbing silicon layer during a thermal treatment by diffusion of dopant impurities from the layer stack as doping source, attaining dopant surface concentrations in the light absorbing silicon layer that are higher than the doping concentration in the layer stack, preferentially even five times higher than the doping concentration in the layer stack.

5) A beneficial application of the doping source effect is for example overcompensation of a doping profile in the wafer of opposed polarity, which can be especially beneficial when the heterogeneous layer is applied in an interdigitated back contact (IBC) solar cell. Overcompensation is understood as doping an already doped region, possible an already highly doped region, with opposed polarity resulting in a change of polarity in that region. For example, a n-type doped region can be doped so heavily with p-type dopants that the resulting polarity is p-type. For example, in the solar cell manufacturing process a full-area doping profile of some polarity, for example p-type, could be defined on one side of a silicon wafer. Next, the layer stack comprising the heterogeneous layer can be grown in some areas of the same surface, preferentially in a interdigitated pattern, with dopants of the other polarity, for example n-type. During a subsequent annealing step, the layer stack acts as doping source, doping the wafer so highly n-type that the previously present p-type doping is overcompensated. For example, growth of the n-type layer stack on a full-area p-type doped surface in a pattern of parallel lines, followed by an annealing step during which dopants diffuse from the n-type doped layer stack to the p-type doped region, would result in alternating p- and n-type regions in the silicon wafer.

6) The heterogeneous layer can also be undoped. In this case, some of the layers deposited directly or indirectly on the heterogeneous layer possibly contain dopants which partially diffuse through the heterogeneous layer and to the wafer during the thermal treatment. Consequently, the doping profile in the wafer can depend on the properties (composition, doping, thickness) of the heterogeneous layer. This effect can be used to adjust the doping profile in the silicon wafer while keeping the conditions of the thermal treatment constant. This renders the passivation contact layer stack very versatile and facilitates process integration.

7) The heterogeneous layer can advantageously be prepared such that for given thermal treatments diffusion of dopants from some layer in said layer stack 2 towards said light absorbing silicon layer 1 is reduced or even completely suppressed. This prevents the negative effects of the highly doped region present in state of the art embodiments such as free carrier absorption or Auger recombination.

8) The material of the matrix phase might be chosen such that it exhibits a higher binding energy for hydrogen (fluorine) than the binding energy of hydrogen (fluorine) in the conductive phase, which means a higher rupture temperature of hydrogen-related bonds, i.e. an increased thermal stability thanks to the addition of the matrix phase. Moreover, during growth of the heterogeneous layer, hydrogen or fluorine might eventually be build-in preferentially in the matrix phase, the matrix phase thus including more hydrogen or fluorine than the conductive phase. The matrix phase can thus act as a hydrogen or fluorine reservoir or source during thermal treatments. In summary, the matrix phase potentially increases the hydrogen or fluorine content and the thermal stability of hydrogen or fluorine bonding with respect to a layer without the matrix phase.

9) The heterogeneous layer includes a large density of grain boundaries, and impurity diffusion often proceeds faster along grain boundaries than through bulk material. Therefore, hydrogen or fluorine diffusion from the capping layer to the wafer interface can be enhanced thanks to the heterogeneous nature of the layer, when compared to a layer consisting only of the conductive phase. The non conducting portion 4b can support a buffer layer, for example a silicon oxide buffer layer, during annealing, especially if the matrix phase consists of the same material as the buffer layer. The heterogeneous structure can prevent failure of a buffer layer 10 induced by e.g. thermal annealing such as the faillure described in: G. R. Wolstenholme, N. Jorgensen, P. Ashburn, and G. R. Booker, Journal of Applied Physics, vol. 61, pp. 225-233, 1987/01/01/ 1987. This extends the annealing temperature range at which good surface passivation can be obtained.

10) The heterogeneous layer 4 can eventually render the need of a buffer layer 10 superfluous. The invention thus explicitly also includes structures analogous to any of the possible embodiments but without the buffer layer 10.

11) Thanks to the heterogeneous structure thermally induced effusion of compounds from the layer is distributed over a broader temperature range, which has several beneficial effects. More in detail, for the material being amorphous silicon and the effusing compound hydrogen, effusion typically takes place between 100°C and 400°C, with the effusion rate being greatest at 350°C. The effective temperature range of effusion is understood here as the full width at half maximum, i.e. the temperature range in which the effusion rate is higher than the maximum effusion rate divided by 2. The matrix phase can store the effusing compound, have a stronger binding energy, and also hindering diffusion of the compound through the layer, thus hindering effusion. The thermally induced evolution of some compounds from the two phases can also be tuned such that the temperature ranges of release are different for the two phases, thus reducing thermally induced evolution at a certain temperature. All effects will lead to a broader effective temperature range of effusion. For example, hydrogen is released from amorphous silicon mainly at temperatures between 150°C and 400°C. Silicon nitride layers release hydrogen at temperatures of 600-800°C. In a heterogeneous layer consisting for example of a SiNx matrix phase and a amorphous silicon conductive phase, hydrogen that evolves during a thermal treatment from the amorphous silicon can be stored in the SiNx phase. As the SiNx phase released hydrogen at higher temperatures, the total temperature range of hydrogen release of the heterogeneous layer is broader than the temperature range of hydrogen release from amorphous silicon.

12) In general the passivating contact layer stack 2 can contain stress. In a layer stack, the stress in one layer can be compensated by the stress in another layer, which is a known effect. The heterogeneous layer offers a novel possibility to tune and eventually minimize stress: The matrix phase and the conductive phase can be chosen such that their stresses compensate each other in the same layer, or that the stress contained in one phase is released thanks to the other phase. Stress release can happen especially during one of the at least one thermal treatments, for example as the phases reorganize. Reorganization of the phases means chemical changes such as effusion or diffusion of some compounds or changed chemical bonding, or structural changes such as clustering, phase separation, crystallization, grain growth, Ostwald ripening, etc. More in detail, phase separation means the evolution of a mixed, possibly non-stoichiometric phase towards several phases which are for example closer to their stoichiometric composition, for example for SiOx as matrix phase the separation of SiOx to Si and SiO2, $SiOx \rightarrow x/2\ SiO2 + \frac{1}{2}(2-x)\ Si$.

13) Passivating contacts based on a tunnel oxide buffer layer and a doped silicon-based layer are prone to blistering because hydrogen contained in the silicon-based doped layer evolves quickly during thermal treatment, forming hydrogen bubbles and delaminating one or more layers of the layer stack. The addition of the matrix phase can release stress during deposition and during thermal treatment as described above. Further, it can broaden the temperature range at which hydrogen evolves, as also described above. The combination of these two effects is thus especially effective in reducing the risk of blister formation or delamination of the layer stack during a thermal treatment.

The heterogeneous layer 4 consists of silicon oxide, hereinafter called SiOx, containing percolating phases of doped microcrystalline Si (μc-Si), as shown in Figure 3. In such an embodiment case, the heterogeneous material is denoted SiOx/μc-Si. The μc-Si phase 4a can be oriented in growth direction, forming conductive filaments or pillars surrounded by $SiO_x$ phases 4b. As further described, the heterogeneous layer 4 can be grown by plasma-enhanced chemical vapor deposition (PECVD) and a subsequent annealing step, for example a thermal annealing step at 300°C-1100°C for 1s-600min. The filament structure can be present already prior to the annealing step or be created during annealing. The matrix phase (4b), silicon oxide, may have a very low refractive index. This is the essence of the invention as it combines the optical advantages and the excellent temperature stability of a PERC rear side comprising surface passivation with efficient current transport to the metallization of the cell without the need of layer structuring steps. One aspect of the invention is that the heterogeneous layer 4 acts as optical layer, for example as an optical rear reflector, and light that is incident from the wafer on the rear side is thus reflected at the heterogeneous layer before it interacts with another layer, for example a conductive layer prepared directly or indirectly on top of the heterogeneous layer, said conductive layer being an optically absorbing layer for the incident light. As in this case the light is reflected at the heterogeneous layer before it reaches the absorbing layer, the insertion of the heterogeneous layer reduces light absorption in said conductive layer. As described above, light is reflected by the heterogeneous layer, acting as an optical layer, before it reaches the conductive layer 6, and the heterogeneous layer 4 can thus reduce parasitic optical absorption, for example free carrier absorption, and consequently short circuit current losses.

Due to the potentially transparent nature of the heterogeneous layer-based passivating contact, it can also be employed on the side of the solar cell oriented towards the illumination source, i.e. the side that receives a higher irradiance. For front side application it is especially beneficial to adapt the composition and structure of the heterogeneous layer (matrix portion and conductive portion) such that a refractive index value is achieved which enables the heterogeneous layer to reducing the front side reflection as described in the prior art section.

In a preferred embodiment the structure and composition of the heterogeneous layer are graded over the layer such that the refractive index is graded, the refractive index attaining higher values towards the side oriented towards the silicon absorber wafer and lower values towards to the other side.

In another variant, the heterogeneous layer consists of percolating crystalline Si phases 4a in a SiNx or SiCx matrix 4b. Further variants are percolating crystalline or amorphous SiCx phases in a SiOx or SiNx matrix or crystalline SiCx in an amorphous SiCx matrix, or combinations of said materials.

The inclusions of the conductive phase in the heterogeneous layer typically have a size of 0.5-100nm, preferentially 2-30nm. Preferentially, their extension is larger in sagittal direction than in the plane of the heterogeneous layer 4.

Two spatially separated inclusions of the conductive phase can still be electrically connected if their separation is small enough. Even in case the matrix phase 4b is a dielectric, such electrical connection is possible, for example by defect-assisted transport, hopping, or tunneling. The maximum possible separation for which adjacent conductive phases are still electrically connected depends on the material of the matrix phase. For example, if the matrix phase consists of SiOx, two inclusions that are less than 5nm, preferentially less than 3nm, preferably less than 2nm, apart can still be electrically connected.

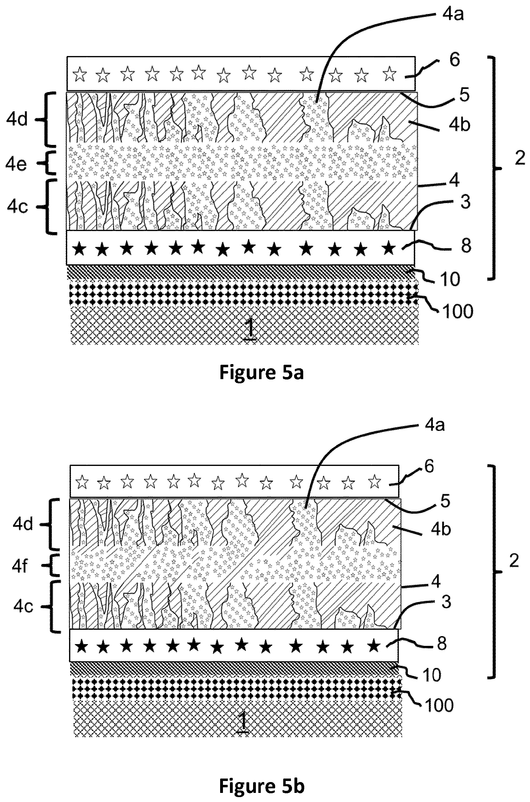

The heterogeneous layer can be realized as a heterogeneous multilayer as illustrated in Fig. 5. More in detail, the heterogeneous mutlilayer may comprise at least two different or similar heterogeneous layers (4c, 4d), possibly separated by layers of the conductive phase 4e as illustrated in figure 5a. In other words, the heterogeneous layer can contain portions of the matrix phase in several sublayers of the heterogeneous layer which are not necessarily in direct contact with each other. As an example, figure 5a shows a heterogeneous multilayer comprising a sublayer consisting of the conductive phase only and two sublayers 4d and 4c comprising the conductive phase and the matrix phase. The sublayer with a lower fraction of the matrix phase may contain no matrix phase, as illustrated in Figure 5a as sublayer 4e, or contain some matrix phase, as illustrated in Figure 5b as sublayer 4f. The fabrication of such multi layers is described further.

The heterogeneous layer can be grown on top of a conformal buffer layer 10. For instance, the buffer layer can be a SiOx layer as described in: F. Feldmann, M. Bivour, C. Reichel, M. Hermle, and S. W. Glunz, "Passivated rear contacts for high-efficiency n-type Si solar cells providing high interface passivation quality and excellent transport characteristics," Solar Energy Materials ans Solar Cells, vol. 120, Part A, pp. 270-274, 2014/01// 2014.

In a variant, a buffer layer may be a SiOx layer and it can also contain N (SiOxNy layer).

The heterogeneous nature of the heterogeneous layer is caused by very special growth conditions. It is beneficial to choose the layer arranged between the surface 1a, 1b of the absorber 1 and the heterogeneous layer such that it fosters heterogeneous growth of the heterogeneous layer, or perform a pretreatment of that layer. For example for silicon as conductive phase, it is beneficial to grow the conductive phase in a crystalline form, because crystalline growths implies selective incorporation of silicon atoms at already existing silicon crystallites, but suppression of the growth of silicon tissue anywhere else, i.e. on the rest of the growth surface. Consequently, the matrix phase can grow on the rest of the growth surface, and silicon is incorporated selectively at the pre-existing growth sites. Key to growing the heterogeneous layer is thus to create selective sites of preferential growth for one of the at least two phases of the heterogeneous layer. This can be achieved by properly choosing the growth substrate or growth surface or pre-treating the growth surface.

Crystalline growth of silicon proceeds especially well on a hydrogen-terminated silicon surface. To define preferential growth sites, a hydrogen-terminated silicon wafer surface can in a first step be partially covered with a material that inhibits crystalline silicon growth, for example be partially covered with an amorphous layer, which for examples leaves some spots uncovered such that these spots define preferential growth sites.

In general crystalline growth starts at nucleation sites. For example, crystalline growth of the silicon conductive phase can be fostered by growing on a silicon oxide surface. For arranging a heterogeneous layer comprising a silicon conductive matrix on a buffer layer 10, it is thus beneficial to choose a silicon oxide buffer layer 10 as growth surface.

If the heterogeneous layer has to be grown on a layer which does not exhibit preferential growth sites, for example on an amorphous silicon layer, this layer can be treated to create preferential growth sites. For example, treating an amorphous silicon layer with an oxygen-containing plasma creates preferential growth sites for crystalline growth of silicon.

The invention includes also the preparation of the heterogeneous passivation layer directly on the Si surface, i.e. without the buffer layer 10. In this case, the buffer layer 10 can eventually form in a subsequent annealing step, for example in a reaction of the heterogeneous layer with the light absorbing silicon layer. However, if there is no buffer layer 10 in the solar cell the conductive layers 6, 8 or the separation layer 14, 15 described further or the heterogeneous layer 4 are in direct contact with the wafer 1.

Owing to the thermal treatment for the preparation of the passivating contact layer stack, dopant atoms can diffuse during the thermal treatment out of the passivating contact layer stack into the wafer, forming a highly doped region in the wafer of the same polarity as the passivating contact layer stack, as sketched exemplarily as in Fig 3b and 4b. "Highly doped" means hereinafter a concentration of the doping impurity of higher than $1E17cm^{-3}$, preferably higher than $1E18cm^{-3}$, preferably higher than $1E19\ cm^{-3}$. All structures discussed hereinafter can optionally include such a doped region inside the wafer just underneath the wafer surface.

In such an embodiment said highly doped region enhances charge carrier transport from the wafer to the layer stack. This is especially important when the electronic band structure of the layer stack is not identical to the band structure of the wafer. This is due to the effect that doping influences band alignment. High doping on both sides of a thin dielectric layer aligns the maxima of the supply functions in the layers adjacent to the dielectric layer and thus enhances charge carrier transport through the dielectric layer. "Supply function" refers to the charge carrier distribution at the interface with the dielectric layer as described in: Sentaurus™ device user guide, Synopsis, Version I-2013, Mountain View (CA), USA.

As the band structure of the heterogeneous layer 4 can depend on the structural sizes and composition of the inclusions or the matrix phase, it has for most cases a band structure different from the silicon wafer 1, and a band gap different from the silicon wafer band gap. For this reason the alignment effect of the supply function is especially beneficial for the case of the heterogeneous layer.

In an embodiment the passivating contact layer stack 2 has no highly doped region. More in detail, in one embodiment of the invention the diffusion is even minimized by using a thermal treatment with sufficiently low peak temperature and short dwell time in order to avoid the detrimental effects of the highly doped region 100 inside the silicon wafer. Alternatively to changing the thermal treatment to optimize the doping profile, diffusion of dopants from the layer stack to the silicon wafer can also be reduced or completely omitted by an appropriately defined doping profile in the as-prepared layer stack. For example, an undoped, diffusion-hindering layer between the silicon wafer and the layer in the layer stack containing the diffusing species can suppress diffusion of dopants to the silicon wafer. Special treatments of the buffer layer or the separation layer, e.g. a nitridation, for example deposition of a monolayer of nitrogen on the respective layers, can suppress dopant diffusion.

Interestingly, electronic band alignment can also be caused by fixed charges instead or in addition to a highly doped region. An aspect of the invention is to utilize fixed charges to cause band bending such that passivation is enhanced or charge carrier transport is enhanced, especially using fixed charge for influencing the alignment of the charge carrier supply functions. Fixed charges can be stored in any of the layers of the layer stack, especially in the buffer or the heterogeneous or the capping layer or at the layer interfaces. A special aspect of the invention is the charge storage in the heterogeneous layer, for example in the matrix phase 4b or at the interface between the conductive 4a and the matrix phase 4b or in some other layer or at the interface of any of the layers.

Fig. 3a shows a passivating contact layer stack 2 based on a heterogeneous, possibly doped, passivation layer made up of conductive phases 4a (e.g. nanocrystalline Si) and phases of a low-refractive index material (e.g. SiO2) 4b. The heterogeneous layer can also contain hydrogen or fluorine which can passivate the interface to the Si wafer.

Fig. 3b-d illustrates variants which include an additional full-area conductive layer b) on top of, c) underneath, and d) on top of and underneath the heterogeneous layer 4. The wording underneath means situated between the heterogeneous layer 4 and the absorber 1.

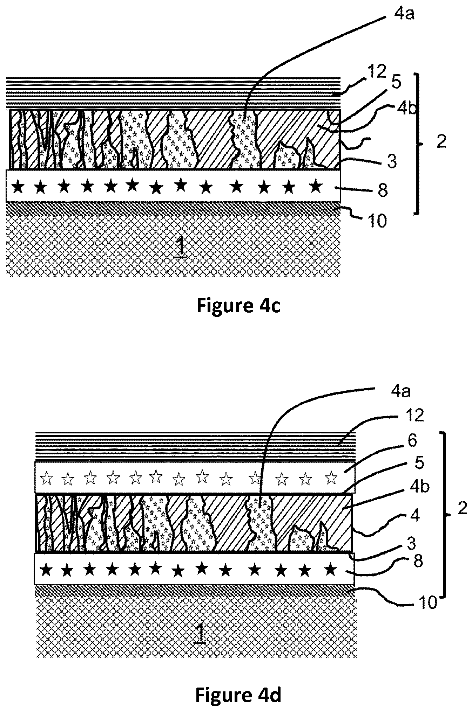

Figure 4a illustrates a passivating contact layer stack structure 2 with the layer stack comprising a capping layer 12. A capping layer 12 has several possible functionalities: It can serve as hydrogen source for in-situ hydrogenation, i.e. for distributing hydrogen to the other layers during an annealing step. Moreover, it might act as hydrogen diffusion barrier, reducing hydrogen effusion from the other layers. Fig 4 b-d illustrate variants including full-area conductive layers.

A capping layer 12 may be arranged on the heterogeneous layer 4. The role of the capping layer 12 is to ensure in-situ hydrogenation or fluorination of the silicon wafer 1, the interface between the wafer 1 and a buffer layer 10, or the interface between the wafer and the adjacent layer, for instance an heterogeneous layer 4 or a separation layer or a conductive layer, or distributes hydrogen or fluorine to some of the other layers of the layer stack.

For this, the capping layer performs at least one of the following functions:

- it reduces the hydrogen or fluorine effusion from the layers underneath;
- it acts as hydrogen or fluorine source;

Said capping layer 12 can be conductive and doped, and may possibly also be a mixed-phase material.

The capping layer 12 can also act as etch-stop and diffusion barrier, facilitating device integration of the passivating contact.

In embodiments some heterogeneous layers, for example heterogeneous layers consisting of SiOx and Si phases, are not chemically stable in hydroflouric acid (HF). HF is used in many process steps in standard silicon solar cell manufacturing. A capping layer with better stability in HF than SiOx (e.g. a Si or SiCx or SiNx layer) can thus protect the heterogeneous layer during solar cell processing.

Another frequently used process in solar cell manufacturing is diffusion of impurity dopants (for example phosphorous, arsenic, boron, aluminum) from an external diffusion source to define highly doped regions in the silicon wafer. Impurity diffusion is usually carried out at elevated temperatures, typically between 700°C and 1000°C. Frequently, the silicon wafer is exposed to a diffusion source (e.g. POCl3, BBr3, BCl3) which acts on all surfaces of the substrate. The diffusion source and the diffused regions in the silicon wafer need then to be removed after the diffusion process everywhere where they are not wanted, typically by etching the diffusion source and also those parts of the silicon wafer. A more elegant solution is to apply a layer to the substrate which reduces the penetration of impurities to the substrate, thus also called diffusion barrier. In that case, the diffusion barrier might be needed to be removed afterwards, but as the diffusion barrier protected the covered substrate area from in-diffusion, the substrate itself does not need to be etched.

With the capping layer acting as diffusion barrier, it protects the layer stack comprising the heterogeneous layer during a diffusion process. Consequently, in the cell manufacture process, it is possible to first prepare the heterogeneous layer stack and the capping layer, and then carry out a diffusion process for example to define a doping profile in some region in the silicon absorber. This is beneficial because the thermal profile of the diffusion process also acts as thermal treatment for the passivating contact layer stack.

In embodiments said capping layer 12 can be made of silicon (Si), silicon carbide (SiCx), silicon nitride (SiNx), silicon oxide (SiOx), silicon oxynitride (SiOxNy), silicon oxycarbide (SiOxCy), silicon carbonitride (SiCxNy), silicon oxycarbonitride (SiOxCyNz), which can all be doped with Boron (B), Aluminum (Al), Gallium (Ga), Indium (In), nitrogen (N), Phosphorous (P), Arsenic (As), Antimony (Sb) and can be hydrogenated (e.g. N-doped SiCx:H). A capping layer 12 can be doped and conductive. It can also be made of a transparent conductive oxide material such as tin oxide, also doped with Fluorine (F) or antimony (Sb), Indium Tin Oxide (ITO), Indium Cerium Oxide (ICO), Indium Tungsten Oxide (IWO), Indium Zinc Oxide (IZO), Zinc Tin Oxide (ZTO), indium Tin Zinc Oxide (ITZO), Indium Gallium Oxide (IGO), Indium Gallium Zinc Oxide (IGZO), Indium Tin Gallium Oxide (ITGO), Zinc Oxide (ZnO), Titanium oxide (TiOx), Titanium nitride (TiNx), aluminum nitrode (AlNx), Aluminum oxide (AlOx), aluminum zinc oxide (AlZnOx), which can all contain hydrogen, Al, B, Ga, or O. A capping layer 12 can also be a double layer of said materials, for instance SiCx:H/SiNx:H, SiNx:H/ZTO, ZTO/ITO etc..

In some embodiments a buffer layer 10 is arranged in the solar cell, preferably directly or indirectly between the silicon wafer and the heterogeneous layer The buffer layer is usually a thin dielectric or passivating layer. For example, thin silicon oxide layer, for example prepared by chemical oxidation, for example in HNO3, 03, or HCl. The buffer layer can be tuned for optimized, and compared to the case without buffer layer reduced, diffusion of dopant atoms from the layer stack to the wafer for example by adapting its thickness, density, chemical bonding configuration and composition. From prior art it is known that for thermal oxidation of silicon the thickness of the grown silicon oxide layer can be controlled precisely be tuning the oxidation temperature, time, ambient, and other process parameters. For chemical oxidation of silicon, for example in HNO3, the process is reported to be self-limiting, i.e. after a certain exposure time, for example 60min, the thickness does not increase further.

Experiments conducted by the inventors have shown, however, that the thickness of a silicon oxide layer grown by exposure to HNO3 depends on the doping concentration in the wafer. Choosing an appropriate surface doping concentration thus permits to control the oxide thickness, and thus also to control diffusion of impurities from the layer stack to the wafer.

Diffusion of dopants from the layer stack to the wafer through said buffer layer can further be influenced for example by altering the buffer layer by plasma, thermal, electrical or chemical treatments. For example, thin silicon oxide layers can be nitrided by exposure to a nitrogen containing plasma or by annealing in nitrogen atmosphere, which reduces diffusion of many elements through the silicon oxide layer. Further, silicon oxide layers can be densified by thermal annealing, also reducing diffusion from the layer stack to the wafer. The density and composition of said buffer layer can also be influenced by exposure to chemical agents, for example exposing a chemical oxide grown in HNO3 to 03.

A given buffer layer 10 can also be restructured with plasma treatments, which can result in a less dense buffer layer, for example a hydrogen plasma treatment of a silicon oxide buffer layer renders the buffer layer less dense and less chemically resistant, and which can also enhance diffusion of dopants from the layer stack to the wafer.

An aspect of the invention is that said buffer layer and the thermal treatment are designed such that dopants which diffuse from the layer stack towards the wafer do not reach the wafer, i.e. do not alter the doping concentration in the wafer.

Another aspect of the invention is that said buffer layer 10 may contain impurity atoms already prior to the thermal treatments. During a thermal treatment in the manufacturing process these impurity atoms can then diffuse from the buffer layer to the wafer or other adjacent layers of the layer stack, where they can act as dopant impurities. This can be especially useful for aligning the energy bands in the wafer and in the layer stack to enhance charge carrier transport through the buffer layer.

Said buffer layer 10 can be amorphous or crystalline. Transport through the buffer layer can proceed via direct transport, or, if the buffer layer is a dielectric layer, by hopping or tunneling, or a combination of all mechanisms.

In embodiments the heterogeneous layer and its adjacent layers react with each other during the at least one thermal treatments, which in some cases can be detrimental for the functionalities of the passivating contact.. This is especially possible if the layer directly or indirectly adjacent to the heterogeneous layer is made of a different material than the materials included in the heterogeneous layer (for example: heterogeneous layer containing $SiO_x$ and $Si$ phases and the conductive layer consisting of $SiC_x$ or $SiN_x$). Reaction is meant as chemical reaction, or in general as any influence of one layer on the other, caused by the presence of the former.

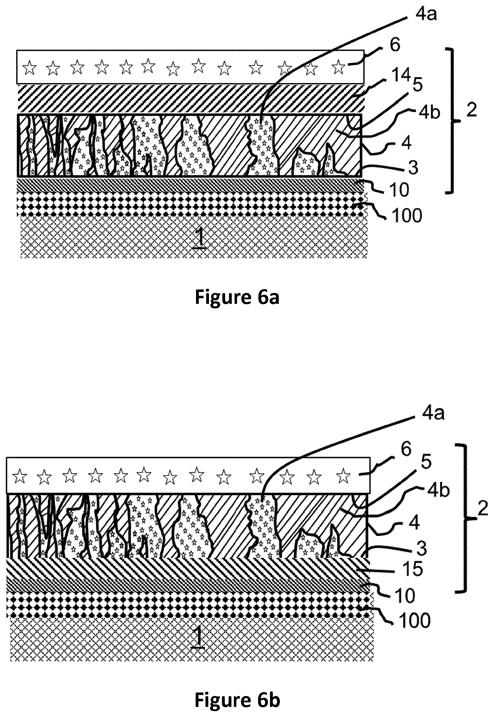

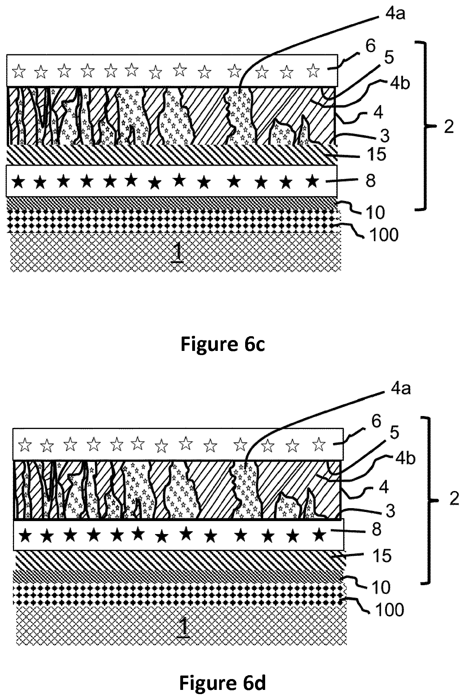

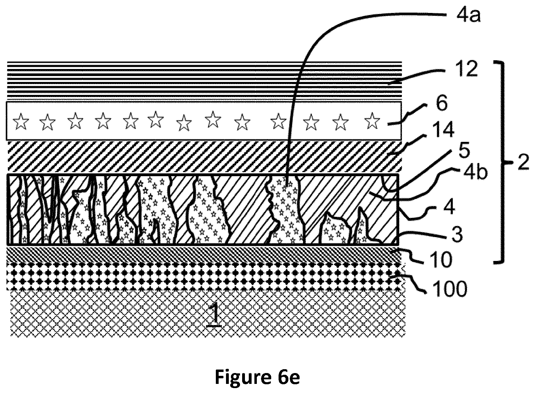

To avoid such a reaction, a separation layer 14, 15 may be provided between the heterogeneous layer 4 and the adjacent layers as shown exemplarily for some configurations in Fig 6.

Said separation layer 14, 15 can be doped or undoped.

Another role of the separation layer can be to avoid diffusion of dopants from the layers deposited on it towards the silicon wafer during the at least one thermal treatment. In this case the separation layer is preferentially undoped in the as-deposited state.

Description of common functionalities

Several beneficial effects can be exploited for several layers contained in the layer stack. The description of the following effects applies to the respective layers independently. The wording "layer" in the following points i to v refers to at least one of a buffer layer, a separation layer, a heterogeneous layer, a conductive layer, a capping layer.

i. Said layer can be a graded layer, i.e. a layer whose physical properties change along the growth direction. For example, this can be the crystallinity or the crystal size, the composition, the doping, the optical properties, or the electrical properties of some components or the layer as a whole. It lies in the nature of the invention that the gradient property can also be created, or be further enhanced, during one of the thermal treatments. More in detail, if said layer is amorphous in the as-deposited state, said layer can partially crystallize during the thermal treatment, starting from one side of said layer, leaving the other side of said layer still mainly amorphous. The side where crystallisation starts can be the side of said layer oriented towards the wafer. This effect can be exploited to reduce junction resistance between the layer and the wafer (improving fill factor). The other case, the layer crystallizing only on the other side, and the side oriented towards the wafer remaining more amorphous, can be used to obtain a more favorable band bending thanks to band offsets between the wafer and said layer, but at the same time a crystalline and thus highly conductive nature of said layer on its other side, reducing contact resistance there.

ii. said layer can contain fluorine or a fluorine compound. During the thermal treatment the fluorine or fluorine compound can diffuse to the interface of the silicon wafer where it can accumulate and passivate electronic defect states. This is especially advantageous as this passivates the interface between the light absorbing substrate 1 and a buffer layer 10, or the interface between the light absorbing substrate 1 and its adjacent layer, which may be for instance the heterogeneous layer, or may be a buffer layer or may be some of the layers in the layer stack even without the supply of an external hydrogen source. For example, if a silicon-containing said layer is grown by PECVD, $SiF_4$ can be used as precursor gas as fluorine and silicon source. To give another example, for the growth of boron-doped films $BF_3$ can be used as precursor gas to introduce boron and fluorine. Especially advantageous is the use of a $SiO_x$ buffer layer because fluor (F) accumulates at the $Si$-$SiO_x$ interface, reducing the interface defect density.

iii. said layer can also be an adhesion-promoting layer, also defined as "sticky layer".

The description of the following effects applies to the respective layers independently, i.e. said layer referring to at least one of: a separation layer, a conductive layer, a second conductive layer, a capping layer.

iv. said layer can be amorphous or crystalline. While in prior art the conductive layer is amorphous in its as-deposited state and the thermal treatment used to promote crystallization, it can also be prepared fully crystalline without any additional thermal treatment. "Fully crystalline" refers to a layer which does not crystallize further during the at least one thermal treatments, i.e. does not exhibit larger grain size after the at least one thermal treatments than before.

v. In another advantageous variant said layer is amorphous in its as deposited state, and no crystallization occurs during the at least one thermal treatment. Or only a fraction of it crystallizes, for instance only the upper part or only the lower part of the layer, leaving the respective other part amorphous, or only the intermediate part of the layer crystallizes, leaving the upper and lower part amorphous.

Table II gives a summary of the properties of some layers of the pasivating contact layer stack and the component of the heterogeneous layer 4 with typical and preferential (in brackets) parameter ranges.

**Table II:** summary of the properties of some layers of the passivating contact layer stack and the component of the heterogeneous layer 4 with typical and preferential (in brackets) parameter ranges.

| Denomination | Thickness (nm) | | Cluster size (nm) | Refractive index |
|---|---|---|---|---|
| Buffer layer 10 | 0-20 | | does not apply | 1.45-3.5 (1.45-2) |
| Heterogeneous layer 4 | 2-2000 (5-40) | | Does not apply | 1.45-3.5 (1.7-2.5) |
| Conductive phase 4a, | does not apply | | 1-1000 (1-20) | Na |
| Matrix phase 4b | does not apply | | 1-1000 (1-20) | 1.45-3 (1.45-2.6) |
| Full area conductive phase 6 | 2-10000 (50-200) | | | 2-3.5 |
| | Full area conductive phase 8 | 2-10000 (50-200) | | 2-3.5 |
| | Capping layer 12 | 2-10000 (10-200) | | 1.45-3.5 (1.8-2.5) |
| | Separation layer (14,15) | 1-100 (1-20) | | |

Table III summarizes possible choises for the materials of the layers

**Table III:** Summary of possible material choices.

| Denomination | Material |
|---|---|
| Buffer layer 10 | Si-based oxides (such as SiOx, SiOxNy, SiOxCy which may also contain further elements), Si-based nitrides (such as SiNx, SiOxNy, SiNxCy), AlOx, HfOx, AlHfOx, AlNx, TiNx, ZrOx, Y2Ox, AlSiOx, HfSiOx, AlHfSiOx, Amorphous Si compounds (a-Si, a-SiCx, a-SiNx, a-SiOx, which all may contain hydrogen, fluorine, phosphorous, boron, and other elements) |
| Heterogeneous layer 4 | see 4a and 4b |
| Conductive phase(4a) | Amorphous or fully crystalline or nanocrystalline or micro-crystalline or partly crystalline Si, SiC, SiCxNy, SiCxOy, which can all be doped B, Al, Ga, In, N, P, As, Sb, and can contain hydrogen or fluorine (e.g. N-doped SiCx:H) |
| Matrix phase 4b | SiCx, SiNx, SiOx, SiOxNy, SiOxCy, SiCxNy, SiOxCyNz, which can all be doped B, Al, Ga, In, N, P, As, Sb, and can contain hydrogen or fluorine (e.g. N-doped SiCx:H). |
| Full area conductive layer 6 | Amorphous or fully crystalline or nanocrystalline or micro-crystalline or partly crystalline Si, SiC, SiCxNy, SiCxOy, which can all be doped B, Al, Ga, In, N, P, As, Sb, and can contain hydrogen or flourine (e.g. N-doped SiCx:H) |
| Full area conductive layer 8 | Amorphous or crystalline or nanocrystalline or micro-crystalline or partly crystalline Si, SiC, SiCxNy, SiCxOy, which can all be doped B, Al, Ga, In, N, P, As, Sb, and can contain hydrogen or fluorine (e.g. N-doped SiCx:H) |

(continued)

| Denomination | Material |
|---|---|
| Separation layer (14,15) | Amorphous or fully crystalline or nanocrystalline or micro-crystalline or partly crystalline Si, SiC, SiCxNy, SiCxOy, which can all be doped B, Al, Ga, In, N, P, As, Sb, and can contain hydrogen or fluorine (e.g. N-doped SiCx:H) Si-based oxides (such as SiOx, SiOxNy, SiOxCy which may also contain further elements), Si-based nitrides (such as SiNx, SiOxNy, SiNxCy), AlOx, HfOx, AlHfOx, AlNx, TiNx, ZrOx, Y2Ox, AlSiOx, HfSiOx, AlHfSiOx, Amorphous Si compounds (a-Si, a-SiCx, a-SiNx, a-SiOx, which all may contain hydrogen, fluorine, phosphorous, boron, and other elements) |
| Capping layer 12 | Si, SiCx, SiNx, SiOx, SiOxNy, SiOxCy, SiCxNy, SiOxCyNz, which can all be doped B, Al, Ga, In, N, P, As, Sb, and can contain hydrogen or fluorine (e.g. N-doped SiCx:H); Tin oxide, also doped with F or Sb, ITO, ICO, IWO, IZO, ZTO, ITZO, IGO, IGZO, ITGO, ZnO, TiOx, TiNx, AlNx, AlOx, AlZnOx, which can all contain hydrogen, Al, B, Ga, or O; metals such as Ti, V, Cr, Mn, Fe, Co, Cu, Zn, Y, Zr, Nb, Mo, Tc, Ru, Rh, Pd, Ag, Cd, In, Sn, , Lu, Hf, Ta, W, , Re, Os, Ir, Pt, Au, Hg, Tl, Pb, Bi, Po and rare earth metals, all of which may contain hydrogen; Metallic hydrides |

**Embodiments of possible cell structures**

The invention is a passivating contact comprising at least one heterogeneous passivation layer and may comprise at least one hydrogen or fluorine donor layer, that can be applied both to the front and the rear side of a solar cell, and can be employed both as electron- and hole-selective contacts (n- and p-contact).

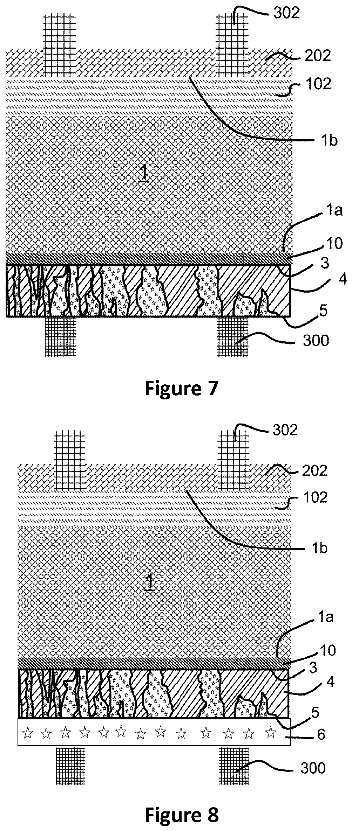

Figure 7 illustrates an embodiment of a solar cell comprising a heterogeneous layer 4 applied to the rear side, the rear side is defined here as being the side away from the incident light, comprising a structured rear metal electrode 300. A solar cell as depicted in Figure 7 can be realized either with a p-type wafer or with a n-type wafer.

In case of an embodiment illustrated in figure 7 and comprising a p-type wafer, the solar cell comprises:

- a Si wafer, p-type of resistivity 0.01-1000Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer 4 , here realized as mixed-phase layer over the full solar cell area, which may contain hydrogen, and is doped at least partially p-type [n-type]- the content of the brackets being explained further- preferably with B, Al, Ga, In [N, P, As, Sb], refractive index 1.45-3.5, thickness 2-2000 nm. The heterogeneous layer consist of at least two phases, preferably of the materials: Amorphous or crystalline or partly crystalline phases of Si, SiC, SiO2, SiOx, SiCxNy, SiCxOy, SiOxCyNz, which are doped preferably with B, Al, Ga, In [N, P, As, Sb]. The heterogeneous layer 4 may contain an undoped or not intentionally doped region, especially at the side oriented towards the Si wafer;
- a metal rear electrode 300, depicted as structured metal rear electrode, but the invention also includes an analogous solar cell with full-area rear electrode;
- a front electrode 302;
- a dielectric layer 202 (for passivation and antireflection) (preferably made of SiOx, TiOx, AlOx, SiNx, SiOxNy, SiCx, SiCxOy, SiCxNy, SiCxNyOz);
- a n-type [p-type] doped region 102 in the Si wafer with doping preferably with N, P, As, Sb [B, Al, Ga, In].

Explanation of contents in brackets: for clarity it is understood in all the described embodiments of Figs.7-21 that the stated doping types have opposite alternatives that are stated in brackets as indicated in the preceding paragraph. For example, the case cited in the preceding paragraph means that the heterogeneous layer may be p-type being doped with preferably with B, Al, Ga, In, in which case the doped region 102 is n-type. In the alternative case that the heterogeneous layer is n-type (in brackets) it is doped with preferably with N, P, As, Sb (in brackets) and the doped region 102 is p-type doped with B, Al, Ga, In (in brackets).

In case of an embodiment illustrated in figure 7 and comprising n-type wafer, the solar cell comprises:

- a Si wafer, n-type or resistivity 0.01-1000 Ohmcm;
- a buffer layer made preferably of SiOx, AlOx, HfOx, AlHfOx, AlN, TiN, SiNx, thickness 0-10nm, refractive index 1.45-3.5;
- a heterogeneous layer 4, here realized as mixed-phase layer over the full solar cell area, which may contain hydrogen

doped at least partially n-type [p-type] preferably with N, P, As, Sb [B, Al, Ga, In], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz, which are doped preferably with N, P, As, Sb [B, Al, Ga, In]. The heterogeneous layer 4 may contain an undoped or not intentionally doped region, especially at the side oriented towards the Si wafer;

- a metal rear electrode 300, depicted as structured metal rear electrode, but the invention also includes an analogous solar cell with full-area rear electrode;
- a front electrode 302;
- a dielectric layer 202 (for passivation and antireflection) (preferably made of SiOx, TiOx, AlOx, SiNx, SiOxNy, SiCx, SiCxOy, SiCxNy, SiCxNyOz);
- A p-type [n-type] doped region 102 in the Si wafer by doping preferably with B, Al, Ga, In [N, P, As, Sb];

Figure 8 illustrates an embodiment of a solar cell comprising a heterogeneous layer 4 and a full-area conductive layer 6. The heterogeneous layer 4 is arranged in Fig. 8 at the rear side of the cell. The rear metal electrode 300 can alternatively also cover the full rear side. Figure 8 depicts more precisely a solar cell with heterogeneous layer 4, and a full-area conductive layer 6, applied to the rear side, and a structured rear metal electrode. A solar cell as depicted in Figure 8 can be realized either with a p-type wafer or with a n-type wafer.

In case that the embodiment of Figure 8 comprises a p-type wafer, the solar cell comprises:

- a Si wafer, p-type or resistivity 0.01-1000 Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer 6, at least one of the two layers may contain hydrogen, doped at least partially p-type [n-type] preferably with B, Al, Ga, In [N, P, As, Sb], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 8 as conductive layer 6, or between the heterogeneous layer 4 and the buffer layer 10 analogously to Figure 3c, conductive layer 8. The heterogeneous layer 4 may contain an undoped or not intentionally doped region, especially at the side oriented towards the Si wafer.
- a metal rear electrode 300, depicted as structured metal rear electrode, but the invention also includes an analogous solar cell with full-area rear electrode
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a n-type [p-type] doped region 102 in the Si wafer by doping preferably with N, P, As, Sb [B, Al, Ga, In].

In case that the embodiment of Figure 8 comprises a n-type wafer, the solar cell comprises

- a Si wafer, n-type or resistivity 0.01-1000 Ohmcm
- a buffer layer 10 made preferably of SiOx, AlOx, HfOx, AlHfOx, AlN, TiN, SiNx, thickness 0-10nm, refractive index 1.45-3.5
- a heterogeneous layer 4 and a full-area conductive layer 6, at least one of the two layers may contain hydrogen, doped at least partially n-type [p-type] preferably with N, P, As, Sb [B, Al, Ga, In], refractive index 1.45-3.5, thickness 2-2000 nm. The mixed phase layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 8 as layer 6, or between the heterogeneous layer 4 and the buffer layer 10 analogously to Figure 3c, layer 8. The heterogeneous layer 4 may contain an undoped or not intentionally doped region, especially at the side oriented towards the Si wafer.
- a metal rear electrode 300, depicted as structured metal rear electrode, but the invention also includes an analogous solar cell with full-area rear electrode;
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a p-type [n-type] doped region 102 in the Si wafer by doping preferably with B, Al, Ga, In [N, P, As, Sb].

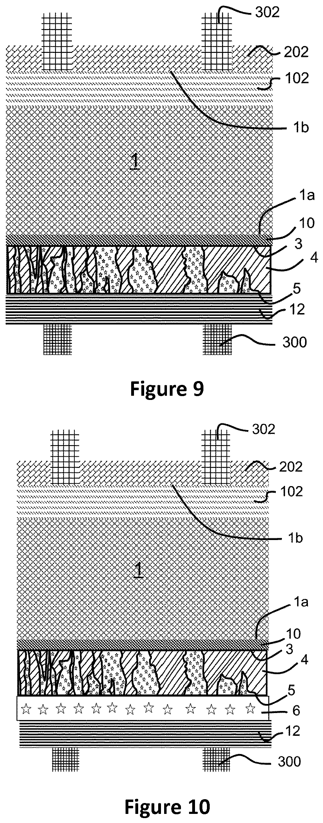

Figure 9 depicts an embodiment of a solar cell with heterogeneous layer 4 and a capping layer 12 applied to the rear side. The rear side comprises a structured rear metal electrode. A solar cell as depicted in Figure 9 can be realized either with a p-type wafer or with a n-type wafer.

In case of an embodiment illustrated in Figure 9 and comprising a p-type wafer, the solar cell comprises :

- a Si wafer, p-type or resistivity 0.01-1000 Ohmcm;
- a buffer layer 10 made preferably of SiOx, AlOx, HfOx, AlHfOx, AIN, TiN, SiNx, thickness 0-10nm, refractive index 1.45-3.5;
- a heterogeneous layer 4 which may contain hydrogen, doped at least partially p-type [n-type] preferably with B, Al, Ga, In [N, P, As, Sb], refractive index 1.45-3.5, thickness 2-2000 nm. The heterogeneous layer 4 consist of at least two phases, preferably of the materials: Amorphous or crystalline or partly crystalline phases of Si, SiC, SiO2, SiOx, SiCxNy, SiCxOy, SiOxCyNz;
- a capping layer 12 made preferably of one of the materials Si, SiCx, SiNx, SiOx, SiCxNy, SiCxOy, IO, ITO, IZO, ZTO, IGZO, ZnO:AI, ZnO:B, ZnO:Ga, TiN. This can also be a double layer made of combinations of the mentioned materials, for instance SiCx/SiNx, SiNx/ZTO, ZTO/ITO etc. All materials may contain hydrogen or oxygen.
- a metal rear electrode 300, depicted as structured metal rear electrode, but the invention also includes an analogous solar cell with full-area rear electrode
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a n-type [p-type] doped region 102 in the Si wafer by doping preferably with N, P, As, Sb [B, Al, Ga, In].

In case of an embodiment illustrated in Figure 9 and comprising a n-type wafer, the solar cell comprises

- a Si wafer, n-type or resistivity 0.01-1000 Ohmcm;
- a buffer layer 10 made preferably of SiOx, AlOx, HfOx, AlHfOx, AIN, TiN, SiNx, thickness 0-10nm, refractive index 1.45-3.5;
- a heterogeneous layer 4, which may contain hydrogen, doped n-type [p-type] preferably with N, P, As, Sb [B, Al, Ga, In], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz;
- a capping layer 12 made preferably of one of the materials Si, SiCx, SiNx, SiOx, SiCxNy, SiCxOy, IO, ITO, IZO, ZTO, IGZO, ZnO:AI, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a metal rear electrode 300, depicted as structured metal rear electrode, but the invention also includes an analogous solar cell comprising a full-area rear electrode;
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a p-type [n-type] doped region 102 in the Si wafer by doping preferably with B, Al, Ga, In [N, P, As, Sb].

Figure 10 depicts an embodiment of a solar cell with heterogeneous layer 4, and a buffer layer 10, and a full-area conductive layer and a capping layer 12. The heterogeneous layer 4 is arranged in Fig. 10 at the rear side of the cell. A solar cell as depicted in Figure 10 can be realized either with a p-type wafer or with a n-type wafer.

In case of an embodiment of Figure 10 comprising a p-type wafer, the solar cell comprises:

- a Si wafer, p-type or resistivity 0.01-1000 Ohmcm
- a buffer layer 10 made preferably of SiOx, AlOx, HfOx, AlHfOx, AIN, TiN, SiNx, thickness 0-10nm, refractive index 1.45-3.5
- a heterogeneous layer 4 and a full-area conductive layer, both of which may contain hydrogen, doped at least partially p-type [n-type] preferably with B, Al, Ga, In [N, P, As, Sb], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The conductive layer can be between the heterogeneous layer 4 and the metallization layer 300 as depicted in Figure 10 as conductive layer 6, or between the heterogeneous layer 4 and the buffer layer 10 analogously to Figure 3c, conductive layer 8. The heterogeneous layer 4 may contain an undoped or not intentionally doped region, especially at the side oriented towards the Si wafer.
- a capping layer 12 preferably made of the materials Si, SiCx, SiNx, SiOx, SiCxNy, SiCxOy, IO, ITO, IZO, ZTO, IGZO, ZnO:AI, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen.
- a metal rear electrode 300, depicted as structured metal rear electrode, but the invention also includes an analogous solar cell with full-area rear electrode.
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a n-type [p-type] doped region 102 in the Si wafer by doping preferably with N, P, As, Sb [B, Al, Ga, In].

In case of the embodiment of figure 10 comprising a n-type wafer, the solar cell comprises:

- a Si wafer, n-type or resistivity 0.01-1000 Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer, 4 and a full-area conductive layer, both of which may contain hydrogen, doped n-type [p-type] preferably with N, P, As, Sb, [B, Al, Ga, In], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz, which are doped preferably with N, P, As, Sb [B, Al, Ga, In]. The full-area conductive layer can be between the heterogeneous layer 4 and the metallization layer 300 as depicted in Figure 10 as conductive layer 6, or between the heterogeneous layer 4 and the buffer layer 10 analogously to Figure 3c, conductive layer 8. The heterogeneous layer 4 may contain an undoped or not intentionally doped region, especially at the side oriented towards the Si wafer.
- a metal rear electrode 300, depicted as structured metal rear electrode, but the invention also includes an analogous solar cell with full-area rear electrode
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a p-type [n-type] doped region 102 in the Si wafer by doping preferably with B, Al, Ga, In [N, P, As, Sb].

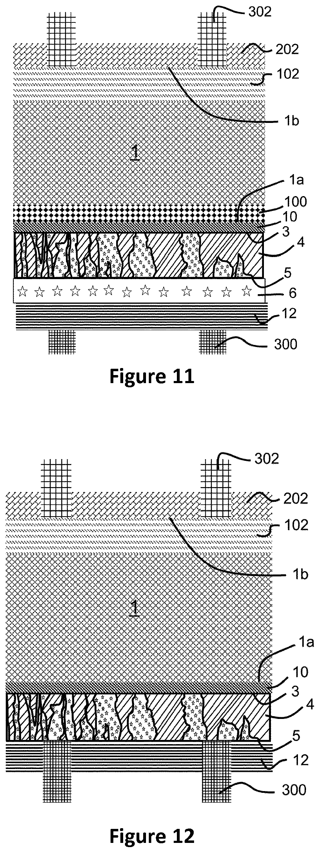

Figure 11 depicts a variant in which a highly doped region 100 is present in the Si wafer on the side of the wafer on which the heterogeneous layer is present. The heterogeneous layer 4 is arranged in Fig. 11 at the rear side of the solar cell. This highly doped region 100 can be present in variants of any of the other embodiments as well, and is illustrated here to give an example. Figure 11 depicts an embodiment of a solar cell with heterogeneous layer 4, and a buffer layer 10, and a full-area conductive layer 6 and a capping layer (12) and a highly doped region inside the Si wafer 100.
A solar cell as depicted in Figure 11 can be realized either with a p-type wafer or with a n-type wafer.
In case of an embodiment of Figure 11 comprising a p-type wafer, the solar cell comprises:

- a Si wafer, p-type or resistivity 0.01-1000 Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer, both of which may contain hydrogen, doped at least partially p-type [n-type] preferably with B, Al, Ga, In [N, P, As, Sb], refractive index 1.45-3.5, thickness 2-2000 nm. The heterogeneous consists of at least two phases, preferably of the materials: Amorphous or crystalline or partly crystalline phases of Si, SiC, SiO2, SiOx, SiCxNy, SiCxOy, SiOxCyNz. The conductive layer can be between the heterogeneous layer 4 and the metallization 300 as depicted in Figure 11 as layer 6, or between the heterogeneous layer 4 and the buffer layer 10 analogously to Figure 3c, layer 8. The heterogeneous layer 4 may contain an undoped or not intentionally doped region, especially at the side oriented towards the Si wafer;
- a capping layer 12 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a highly doped region 100 in the Si wafer doped p-type [n-type] preferably with B, Al, Ga, In [N, P, As, Sb]
- a metal rear electrode 300, depicted as structured metal rear electrode, but the invention also includes an analogous solar cell with full-area rear electrode;
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a n-type [p-type] doped region 102 in the Si wafer by doping preferably with N, P, As, Sb [B, Al, Ga, In].

In case of the embodiment of figure 11 comprising a n-type wafer, the solar cell comprises:

- a Si wafer, n-type or resistivity 0.01-1000 Ohmcm;

- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer, both of which may contain hydrogen, doped n-type [p-type] preferably with N, P, As, Sb, [B, Al, Ga, In], refractive index 1.45-3.5, thickness 2-2000 nm. The heterogeneous layer consists of at least two phases, preferably of the materials: amorphous or crystalline or partly crystalline phases of Si, SiC, SiO2, SiOx, SiCxNy, SiCxOy, SiOxCyNz, which are doped preferably with N, P, As, Sb [B, Al, Ga, In]. The full-area conductive layer can be between the heterogeneous layer 4 and the metallization 300 as depicted in Figure 11 as layer 6 or between the heterogeneous layer 4 and the buffer layer 10 analogously to layer 8 in Figure 3c.

The heterogeneous layer 4 may contain an undoped or not intentionally doped region, especially at the side oriented towards the Si wafer;

- a capping layer 12 preferably made of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen.
- a highly doped region 100 in the Si wafer doped n-type [p-type] preferably with N, P, As, Sb, [B, Al, Ga, In];
- a metal rear electrode 300, depicted as structured metal rear electrode, but the invention also includes an analogous solar cell with full-area rear electrode;
- a front electrode 302;
- a passivation and antireflection layer 202 (preferably made of SiOx, TiOx, AlOx, SiNx, SiOxNy, SiCx, SiCxOy, SiCxNy, SiCxNyOz)
- a p-type [n-type] doped region 102 in the Si wafer by doping preferably with B, Al, Ga, In [N, P, As, Sb].

Figure 12 illustrates an embodiment of a solar cell with a heterogeneous layer 4 comprising a structured capping layer 12 applied to the rear side, the rear side comprising a structured rear metal electrode. The rear metal electrode 300 can alternatively also cover the full rear side. The heterogeneous layer 4 is arranged in Fig. 12 at the rear side of the solar cell.

A solar cell as depicted in Figure 12 can be realized either with a p-type wafer or with a n-type wafer.

In case of the embodiment of figure 12 comprising a p-type wafer, the solar cell comprises:

- a Si wafer, p-type or resistivity 0.01-1000 Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer 4, which may contain hydrogen, doped p-type [n-type] preferably with B, Al, Ga, In [N, P, As, Sb], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz;
- a structured capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of combinations of the mentioned materials, for instance SiCx/SiNx, SiNx/ZTO, ZTO/ITO etc. All materials may contain hydrogen or oxygen;
- a metal rear electrode 300, depicted as structured metal rear electrode, but the invention also includes an analogous solar cell with full-area rear electrode
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a n-type [p-type] doped region 102 in the Si wafer by doping preferably with N, P, As, Sb [B, Al, Ga, In].

In case of an embodiment of figure 12 comprising a n-type wafer, the solar cell comprises:

- a Si wafer, n-type or resistivity 0.01-1000 Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer 4, which may contain hydrogen, doped at least partially n-type [p-type] preferably with N, P, As, Sb, [B, Al, Ga, In], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz;
- a structured capping 12 layer made preferably of the materials Si, SiCx, SiNx, SiOx, SiCxNy, SiCxOy, IO, ITO, IZO, ZTO, IGZO, ZnO:Al, ZnO:B, ZnO:Ga, TiN,. This can also be a double layer made of a combinations of the mentioned materials, for instance SiCx/SiNx, SiNx/ZTO, ZTO/ITO etc. All materials may contain hydrogen or oxygen;
- a metal rear electrode 300, depicted as structured metal rear electrode, but the invention also includes an analogous solar cell with full-area rear electrode;
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a p-type [n-type] doped region 102 in the Si wafer by doping preferably with B, Al, Ga, In [N, P, As, Sb].

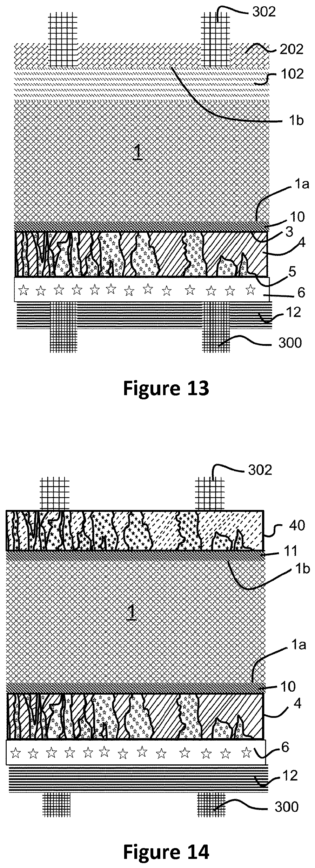

Figure 13 depicts an embodiment of the solar cell with heterogeneous layer 4 and a full-area conductive layer, and a structured capping layer 12 with a structured rear metal electrode 300, applied to the rear side. A solar cell as depicted in Figure 13 can be realized either with a p-type wafer or with a n-type wafer. The heterogeneous layer 4 is arranged in Fig. 13 at the rear side of the solar cell.

In case of the embodiment of figure 13 comprising a p-type wafer, the solar cell comprises:

- a Si wafer, p-type or resistivity 0.01-1000 Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer, both of which may contain hydrogen, doped p-type [n-type] preferably with B, Al, Ga, In [N, P, As, Sb], refractive index 1.45-3.5, thickness 2-2000 nm. The heterogeneous layer 4 consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 13 as conductive layer 6, or between the heterogeneous layer 4 and the buffer layer 10 analogously to layer 8 of Figure 3c. The heterogeneous layer 4 may contain an undoped or not intentionally doped region, especially at the side oriented towards the Si wafer.
- a structured capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combination of the mentioned materials, for instance SiCx/SiNx, SiNx/ZTO, ZTO/ITO etc. All materials may contain hydrogen or oxygen;
- a metal rear electrode 300, depicted as structured metal rear electrode, but the invention also includes an analogous solar cell with full-area rear electrode;
- a front electrode 302;
- a passivation and antireflection layer 202 (preferably made of SiOx, TiOx, AlOx, SiNx, SiOxNy, SiCx, SiCxOy, SiCxNy, SiCxNyOz);
- a n-type [p-type] doped region 102 in the Si by doping preferably with N, P, As, Sb [B, Al, Ga, In].

In case of the embodiment of figure 13 comprising a n-type wafer, the solar cell comprises :

- a Si wafer, n-type or resistivity 0.01-1000 Ohmcm;
- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer, both of which may contain hydrogen, doped at least partially n-type [p-type] preferably with N, P, As, Sb [B, Al, Ga, In], refractive index 1.45-3.5, thickness 2-2000 nm. The heterogeneous layer consist of at least two phases, preferably of the materials: amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 13 as conductive layer 6, or between the heterogeneous layer 4 and the buffer layer 10 analogously to layer 8 in Figure 3c, The heterogeneous layer 4 may contain an undoped or not intentionally doped region, especially at the side oriented towards the Si wafer.
- a structured capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a metal rear electrode 300, depicted as structured metal rear electrode, but the invention also includes an analogous solar cell with full-area rear electrode;
- a front electrode 302;
- a passivation and antireflection layer 202 (preferably made of SiOx, TiOx, AlOx, SiNx, SiOxNy, SiCx, SiCxOy, SiCxNy, SiCxNyOz)
- a p-type [n-type] doped region 102 in the Si wafer by doping preferably with B, Al, Ga, In [N, P, As, Sb].

Figure 14 depicts an embodiment of a solar cell with passivating contact made with a heterogeneous layer 4 on the rear side and a second heterogeneous layer 40 on the front side. All possibilities for a layer stack as explained in Fig. 6 to 13 including also the variants described in Figures 3 to 6 and any combinations thereof apply for each side.

A solar cell as depicted in Figure 14 can be realized either with a p-type wafer or with a n-type wafer.

In case of an embodiment of figure 14 comprising a p-type wafer, the solar cell comprises:

- a Si wafer, p-type or resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5;
- a first heterogeneous layer 4 and a full-area conductive layer on the rear side, both of which may contain hydrogen, doped at least partially p-type [n-type] preferably with B, Al, Ga, In [N, P, As, Sb], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 14 as layer 6, or between the heterogeneous layer 4 and the buffer layer 10 analogously to layer 8 in Figure 3c, The heterogeneous layer 4 may contain an undoped or not intentionally doped region, especially at the side oriented towards the Si wafer.
- a capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen.
- a metal rear electrode 300, depicted as structured metal rear electrode, but the invention also includes an analogous solar cell with full-area rear electrode.;
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, which may contain hydrogen, doped at least partially n-type [p-type] preferably with N, P, As, Sb [B, Al, Ga, In], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The heterogeneous layers 4, 40 , each one to a side of the solar cell, can be different layers and consist of different materials, and have different thicknesses and other properties, or be the same layers. This is valid for all variants of the solar cell comprising at least two heterogeneous layers 4, 40.
- a front electrode 302;

In case of the embodiment of figure 14 comprising a n-type wafer, the solar cell comprises :
a Si wafer, n-type or resistivity 0.01-1000 Ohmcm;

- a first buffer layer 10 made preferably of SiOx, AlOx, HfOx, AlHfOx, AlN, TiN, SiNx, thickness 0-10nm, refractive index 1.45-3.5;
- a first heterogeneous layer 4 and a full-area conductive layer, both of which may contain hydrogen, doped n-type [p-type] preferably with N, P, As, Sb, [B, Al, Ga, In], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 14 as conductive layer 6, or between the heterogeneous layer 4 and the buffer layer 10 analogously to conductive layer 8 in Figure 3c,. The heterogeneous layer 4 may contain an undoped or not intentionally doped region, especially at the side oriented towards the Si wafer.
- a metal rear electrode 300 depicted as structured metal rear electrode, but the invention also includes an analogous solar cell with full-area rear electrode;
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, which may contain hydrogen, doped at least partially p-type [n-type] preferably with B, Al, Ga, In [N, P, As, Sb], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The second heterogeneous layer 40 may contain an undoped or not intentionally doped region, especially at the side oriented towards the Si wafer. The two heterogeneous layer on the two sides of the solar cell can be different layers and consist of different materials, and have different thicknesses and other properties, or be the same layers.
- a front electrode 302;

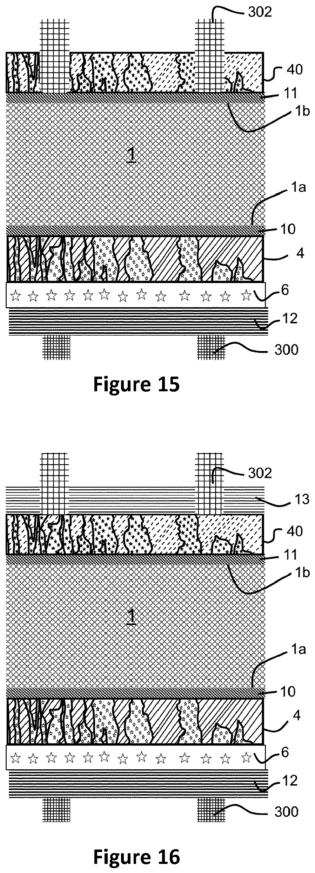

Figure 15 depicts a solar cell with passivating contact made with a heterogeneous layer 4 on the rear side and a structured heterogeneous layer 40 on the front side of the solar cell. All possibilities for the layer stacks as explained in Fig. 6 to 13 including also the variants described in Figures 3 to 6 and any combinations thereof apply for each side.

A solar cell as depicted in Figure 15 can be realized either with a p-type wafer or with a n-type wafer.

In case of the embodiment of Figure 15 comprising a p-type wafer, the solar cell comprises :

- a front electrode 302;
- a Si wafer, p-type or resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5;
- a first heterogeneous layer 4 and a full-area conductive layer, both of which may contain hydrogen, doped at least partially p-type [n-type] preferably with B, Al, Ga, In [N, P, As, Sb] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted as layer 6 in Figure 15 or between the heterogeneous layer 4 and the buffer layer 10 analogously to conductive layer 8 in Figure 3c, The heterogeneous layer 4 may contain an undoped or not intentionally doped region, especially at the side oriented towards the Si wafer.
- a capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This for instance SiCx/SiNx, SiNx/ZTO, ZTO/ITO etc. All materials may contain hydrogen or oxygen.
- a metal rear electrode 300 , depicted as structured metal rear electrode, but the invention also includes an analogous solar cell with full-area rear electrode.
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5
- a second heterogeneous layer 40 on the opposite side of the absorber 1 respective to the first heterogeneous layer 4, being structured , which may contain hydrogen, doped at least partially n-type [p-type] preferably with N, P, As, Sb [B, Al, Ga, In] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The heterogeneous layer 40 may contain an undoped or not intentionally doped region, especially at the side oriented towards the Si wafer.

In a variant the two heterogeneous layers 4,40 can also be a double layer or heterogeneous multilayer made of a combinations of the mentioned materials, layer on the two sides of the solar cell can be different layers and consist of different materials, and have different thicknesses and other properties, or be the same layers.

- a front electrode 302

In case the embodiment of Figure 15 comprising a n-type wafer, the solar cell comprises :

- a Si wafer, n-type or resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5;
- a first heterogeneous layer 4 and a full-area conductive layer, which may contain hydrogen, doped n-type [p-type] preferably with N, P, As, Sb [B, Al, Ga, In] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 15 as layer 6, or between the heterogeneous layer 4 and the buffer layer 10 analogously to Figure 3c, layer 8. The heterogeneous layer 4 may contain an undoped or not intentionally doped region, especially at the side oriented towards the Si wafer.

A capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN, or also be a double layer made of combinations of the mentioned materials, for instance SiCx/SiNx, SiNx/ZTO, ZTO/ITO etc. All materials may contain hydrogen or oxygen.

- a metal rear electrode 300, depicted as structured metal rear electrode, but the invention also includes an analogous solar cell with full-area rear electrode;
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 to the first heterogeneous layer, being structured, which may contain hydrogen, doped at least partially p-type [n-type] preferably with B, Al, Ga, In [N, P, As, Sb] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz, which are doped preferably with B, Al, Ga, In [N, P, As, Sb]. The heterogeneous 40 layer may contain an undoped or not intentionally doped region, especially at the side oriented towards the Si wafer. The two heterogeneous layer 4, 40 on the two sides of the solar cell can be different layers and consist of different materials, and have different thicknesses and other properties, or be the same layers.

- a front electrode 302;

Figure 16 depicts a solar cell with passivating contact made with a second heterogeneous layer 40 and a structured capping layer 13 on the front side. All possibilities for the layer stacks as explained in Fig. 6 to 13 including also the variants described in Figures 3 to 6 and any combinations thereof apply for each side

A solar cell as depicted in Figure 16 can be realized either with a p-type wafer or with a n-type wafer.

In case of the embodiment of Figure 16 comprising a p-type wafer, the solar cell comprises :

- a Si wafer, p-type or resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5;
- a first heterogeneous layer 4 and a full-area conductive layer, both of which may contain hydrogen, doped at least partially p-type [n-type] preferably with B, Al, Ga, In [N, P, As, Sb] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 16 as layer 6, or between the heterogeneous layer 4 and a buffer layer 10 analogously to conductive layer 8 in Figure 3c, The heterogeneous layer 4 may contain an undoped or not intentionally doped region, especially at the side oriented towards the Si wafer.
- a capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen.
- a metal rear electrode 300, depicted as structured metal rear electrode, but the invention also includes an analogous solar cell with full-area rear electrode;
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, which may contain hydrogen, doped at least partially n-type [p-type] preferably with N, P, As, Sb [B, Al, Ga, In] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The second heterogeneous layer 40 may contain an undoped or not intentionally doped region, especially at the side oriented towards the Si wafer. The two heterogeneous layers 4, 40 on the two sides of the solar cell can be different layers and consist of different materials, and have different thicknesses and other properties, or be similar layers.
- a second structured capping layer 13 on the opposite side of the absorber 1 respective to a first capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen.
- a front electrode 302;

In case of the embodiment of Figure 16 comprising a n-type wafer, the solar cell comprises :

- a Si wafer, n-type or resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5;
- a first heterogeneous layer 4 and a full-area conductive layer, which both may contain hydrogen, doped n-type [p-type] preferably with N, P, As, Sb [B, Al, Ga, In] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted as layer 6 in Figure 16 or between the heterogeneous layer 4 and the buffer layer 10 analogously to layer 8 in Figure 3c. The heterogeneous layer 4 may contain an undoped or not intentionally doped region, especially at the side oriented towards the Si wafer.
- A first capping layer 12 made preferably of the materials Si, SiCx, SiNx, SiOx, SiCxNy, SiCxOy, IO, ITO, IZO, ZTO,

IGZO, ZnO:Al, ZnO:B, ZnO:Ga, TiN, or also be a double layer made of combinations of the mentioned materials, for instance SiCx/SiNx, SiNx/ZTO, ZTO/ITO etc. All materials may contain hydrogen or oxygen.

- a metal rear electrode 300, depicted as structured metal rear electrode, but the invention also includes an analogous solar cell with full-area rear electrode
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, which may contain hydrogen, doped at least partially p-type [n-type] preferably with B, Al, Ga, In [N, P, As, Sb] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz, which are doped preferably with B, Al, Ga, In [N, P, As, Sb]. The heterogeneous layer 40 may contain an undoped or not intentionally doped region, especially at the side oriented towards the Si wafer. The two heterogeneous layer on the two sides of the solar cell can be different layers and consist of different materials, and have different thicknesses and other properties, or be the same layers.
- a structured second capping layer 13 on the opposite side of the absorber 1 respective to the first capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a front electrode 302;

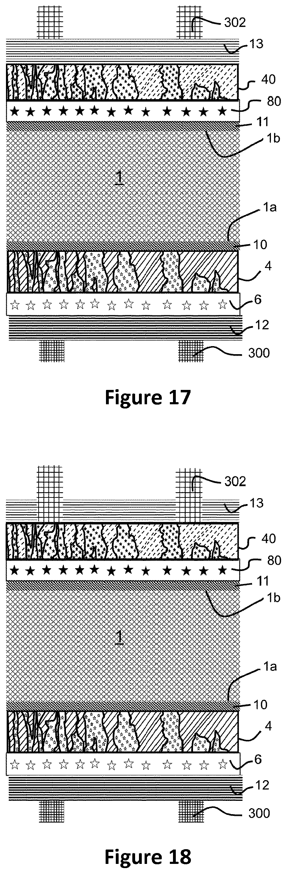

Figure 17 depicts a solar cell with passivating contacts made with a heterogeneous layer 4 on the rear side of the solar cell and a second heterogeneous layer 40 on the front side of the solar cell. All possibilities for the layer stacks as explained in Fig. 6 to 13 including also the variants described in Figures 3 to 6 and any combinations thereof apply for each side.

A solar cell as depicted in Figure 17 can be realized either with a p-type wafer or with a n-type wafer.

In case of an embodiment of figure 17 and comprising p-type wafer, the solar cell comprises:

- a Si wafer, p-type or resistivity 0.01-1000 Ohmcm
- a first buffer layer 10 made preferably of SiOx, AlOx, HfOx, AlHfOx, AlN, TiN, SiNx, thickness 0-10nm, refractive index 1.45-3.5
- a first heterogeneous layer 4 and a first full-area conductive layer, which both may contain hydrogen, doped at least partially p-type [n-type] preferably with B, Al, Ga, In [N, P, As, Sb] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The first full-area conductive layer can be between the first mixed-phase layer 4 and the metallization 300 as depicted in Figure 17, as layer 6, or between the first heterogeneous layer 4 and the buffer layer 10 analogously to Figure 3c, layer 8. The heterogeneous layer 4 may contain an undoped or not intentionally doped region, especially at the side oriented towards the Si wafer.
- a first capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen.
- a metal rear electrode 300, depicted as structured metal rear electrode, but the invention also includes an analogous solar cell with a full area rear electrode;
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, and a further first full-area conductive layer, both of which may contain hydrogen, doped at least partially n-type [p-type] preferably with N, P, As, Sb [B, Al, Ga, In] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 40 and the buffer layer 11 as depicted in Figure 17 as layer 8, or between the heterogeneous layer 40 and the metallization 302 as layer 60, analogously to layer 6 in Figure 3b. The heterogeneous layer 40 may contain an undoped or not intentionally doped region, especially at the side oriented towards the Si wafer.

The two heterogeneous layers on the two sides of the solar cell can be different layers and consist of different materials, and have different thicknesses and other properties, or be the same layers.

- a second capping layer 13 on the opposite side of the absorber 1 respective to the first capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen. In a variant, the second capping layer 13 can also be structured, such as illustrated in Figure 16;

- a front electrode 302;

In case of an embodiment illustrated in figure 17 and comprising an n-type wafer, the solar cell comprises :

- a Si wafer, n-type of resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5 ;
- a first heterogeneous layer 4 and a full-area conductive layer, which both may contain hydrogen, doped n-type [p-type] preferably with N, P, As, Sb, [B, Al, Ga, In] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The first full-area conductive layer can be between the first heterogeneous layer 4 and the metallization 300 as depicted in Figure 17 as layer 6, or between the heterogeneous layer 4 and the buffer layer 10 analogously to Figure 3c, layer 8. The heterogeneous layer 4 may contain an undoped or not intentionally doped region, especially at the side oriented towards the Si wafer.
- a first capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN.This can also be a double layer made of a combinations of the mentioned materials, for instance SiCx/SiNx, SiNx/ZTO, ZTO/ITO etc. All materials may contain hydrogen or oxygen;
- a metal rear electrode 300, depicted as structured metal rear electrode, but the invention also includes an analogous solar cell with full-area rear electrode;
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, and a full-area conductive layer, both of which may contain hydrogen, doped at least partially p-type [n-type] preferably with B, Al, Ga, In [N, P, As, Sb], refractive index 1.45-3.5, thickness 2-2000 nm. The heterogeneous layer consists of at least two phases of the materials: Amorphous or crystalline or partly crystalline phases of Si, SiC, SiO2, SiOx, SiCxNy, SiCxOy, SiOxCyNz, which are doped preferably with B, Al, Ga, In [N, P, As, Sb]. The full-area conductive layer can be between the second heterogeneous layer 40 and the buffer layer 11 as depicted in Figure 17 as layer 80, or between the heterogeneous layer 40 and the metallization 302 as layer 60, analogously to loayer 6 in Figure 3b. The heterogeneous layer 40 may contain an undoped or not intentionally doped region, especially at the side oriented towards the Si wafer. The two heterogeneous layer on the two sides of the solar cell can be different layers and consist of different materials, and have different thicknesses and other properties, or be the same layers;
- a second capping layer 13 on the other side respective to the first capping layer made preferably of the materials Si, SiCx, SiNx, SiOx, SiCxNy, SiCxOy, IO, ITO, IZO, ZTO, IGZO, ZnO:Al, ZnO:B, ZnO:Ga, TiN-. This can also be a double layer made of a combinations of the mentioned materials, for instance SiCx/SiNx, SiNx/ZTO, ZTO/ITO etc. All materials may contain hydrogen or oxygen;
- a front electrode 302.

Figure 18 depicts a solar cell with passivating contact made with a first heterogeneous layer 4 on the rear side and a second heterogeneous layer 40 on the front side of the solar cell. All possibilities for the layer stacks as explained in Fig. 7 to 13 including also the variants described in Figures 3 to 6 and any combinations thereof apply for each side.

A solar cell as depicted in Figure 18 can be realized either with a p-type wafer or with a n-type wafer.

In case of the embodiment of Figure 18 comprising a p-type wafer, the solar cell comprises

- a Si wafer, p-type or resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5;
- a first heterogeneous layer 4 and a full-area conductive layer , both of which may contain hydrogen, doped at least partially p-type [n-type] preferably with B, Al, Ga, In [N, P, As, Sb], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 18, as layer 6, or between the heterogeneous layer 4 and the buffer layer 10 analogously to Figure 3c, layer 8. The heterogeneous layer 4 may contain an undoped or not intentionally doped region, especially at the side oriented towards the Si wafer;
- a first capping layer 12 made preferably of the materials Si, SiCx, SiNx, SiOx, SiCxNy, SiCxOy, IO, ITO, IZO, ZTO,

IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen.

- - a metal rear electrode 300, depicted as structured metal rear electrode, but the invention also includes an analogous solar cell with full-area rear electrode;
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, and a further full-area conductive layer, both of which may contain hydrogen, doped at least partially n-type [p-type] preferably with N, P, As, Sb [B, Al, Ga, In] , refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 40 and the buffer layer 11 as depicted in Figure 18 as layer 80, or between the heterogeneous layer 40 and the metallization 302 as layer 60, analogously to layer 6 in Figure 3b. The heterogeneous layer 40 may contain an undoped or not intentionally doped region, especially at the side oriented towards the Si wafer. The two heterogeneous layers 4, 40 of the two sides of the solar cell 1 can be different layers and consist of different materials, and have different thicknesses and other properties, or be the same layers.
- a structured second capping layer 13 on the other side respective to the first capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;.
- a front electrode 302;

In case of the embodiment of Figure 18 comprising a n-type wafer, the solar cell comprises :

- a Si wafer 1, n-type of resistivity 0.01-1000 Ohmcm;
- a first buffer layer 10 made preferably of SiOx, AlOx, HfOx, AlHfOx, AlN, TiN, SiNx, thickness 0-10nm, refractive index 1.45-3.5 ;
- a first heterogeneous layer 4 and a full-area conductive layer, both of which may contain hydrogen, doped n-type [p-type] preferably with N, P, As, Sb, [B, Al, Ga, In], refractive index 1.45-3.5, thickness 2-2000 nm. The heterogeneous layer consist of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the metallization 300 as depicted in Figure 18, as layer 6, or between the heterogeneous layer 4 and the buffer layer 10 analogously to Figure 3c, layer 8. The heterogeneous layer 4 may contain an undoped or not intentionally doped region, especially at the side oriented towards the Si wafer;
- a first capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN.This can also be a double layer made of a combinations of the mentioned materials, for instance SiCx/SiNx, SiNx/ZTO, ZTO/ITO etc. All materials may contain hydrogen or oxygen;
- a metal rear electrode 300, depicted as structured metal rear electrode, but the invention also includes an analogous solar cell with full-area rear electrode
- a second buffer layer 11 on the opposite side of the absorber 1 respective to the first buffer layer 10 made preferably of SiOx, AlOx, HfOx, AlHfOx, AlN, TiN, SiNx, thickness 0-10nm, refractive index 1.45-3.5;
- a second heterogeneous layer 40 on the opposite side of the absorber 1 respective to the first heterogeneous layer 4, and a further full-area conductive layer , which may contain hydrogen, doped at least partially p-type [n-type] preferably with B, Al, Ga, In [N, P, As, Sb], refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz, which are doped preferably with B, Al, Ga, In [N, P, As, Sb]. The full-area conductive layer can be between the heterogeneous layer 40 and the buffer layer 11 as depicted in Figure 18 as layer 80, or between the heterogeneous layer 40 and the metallization 302 as layer 60, analogously to layer 6 in Figure 3b. The second heterogeneous layer 40 may contain an undoped or not intentionally doped region, especially at the side oriented towards the Si wafer. The two heterogeneous layer on the two sides of the solar cell can be different layers and consist of different materials, and have different thicknesses and other properties, or be the same layers;
- a structured second capping layer 13 on the other side respective to the first capping layer made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a front electrode 302

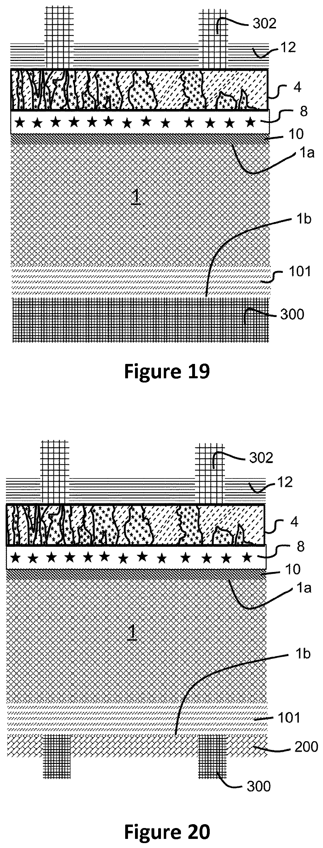

Figure 19 depicts a solar comprising a highly-doped region 101 at the rear side in the Si wafer and a full-area metal electrode 300 (similar to the so-called "Al-BSF cells"). All possibilities explained in Fig 3 to 6 and Fig. 14 to 18 and their variants apply to the layer stack on the front side of the silicon absorber 1.

A solar cell as depicted in Figure 19 can be realized either with a p-type wafer or with a n-type wafer.

In case of an embodiment illustrated in Figure 19 comprising a p-type wafer, the solar cell comprises :

- a Si wafer, p-type or resistivity 0.01-1000 Ohmcm;
- a highly doped region 101 of the Si wafer, doped p-type [n-type] preferably with B, Al, Ga, In [N, P, As, Sb];
- a metal electrode 300 , depicted as full-area metal electrode, but the invention also includes an analogous solar cell with structured metal electrode.
- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer, both of which may contain hydrogen, doped at least partially n-type [p-type] preferably with N, P, As, Sb [B, Al, Ga, In] refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be arranged between the heterogeneous layer 4 and the buffer layer 10 as depicted in Figure 19, layer 8, or between the heterogeneous layer 4 and the metallization 302 analogously to Figure 3b, layer 6. The heterogeneous layer 4 may contain an undoped or not intentionally doped region, especially at the side oriented towards the Si wafer.
- a structured capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of combinations of the mentioned materials, for instance SiCx/SiNx, SiNx/ZTO, ZTO/ITO etc. All materials may contain hydrogen or oxygen.
- a front electrode 302.

In case of an embodiment illustrated in Figure 19 comprising an n-type wafer, the solar cell comprises :

- a Si wafer, n-type or resistivity 0.01-1000 Ohmcm;
- a highly doped region 101 of the Si wafer, doped p-type [n-type] preferably with B, Al, Ga, In [N, P, As, Sb];
- a metal electrode 300 , depicted as full-area metal electrode, but the invention also includes an analogous solar cell with structured metal electrode.
- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer, both of which may contain hydrogen, doped at least partially n-type [p-type] preferably with N, P, As, Sb [B, Al, Ga, In] refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the buffer layer 10 as depicted in Figure 19, layer 8, or between the heterogeneous layer 40 and the metallization 302 analogously to Figure 3b, layer 6. The heterogeneous layer 4 may contain an undoped or not intentionally doped region, especially at the side oriented towards the Si wafer;
- a structured capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a front electrode 302

Figure 20 depicts a solar cell with with a dielectric passivation layer 200 and local contacts at the rear side (as in the so-called "PERC cells"). All possibilities explained in Fig 3 to 6 and Fig. 14 to 18 and their variants apply to the other side of the silicon absorber 1.

The side of the wafer opposite to the side with the heterogeneous layer can also have a full-area metallization instead of the structured metallization 300. In another variant, the doped region 101 on the rear side can be realized locally at the contacts, or be completely absent.

A solar cell as depicted in Figure 20 can be realized either with a p-type wafer or with a n-type wafer.

In case of an embodiment illustrated in Figure 20 comprising a p-type wafer, the solar cell comprises :

- a Si wafer, p-type or resistivity 0.01-1000 Ohmcm
- a highly doped region 101 of the Si wafer, doped p-type [n-type] preferably with B, Al, Ga, In [N, P, As, Sb]
- a metal electrode 300 , depicted as structured metal electrode, but the invention also includes an analogous solar cell with full-area metal electrode.
- a buffer layer 10 made preferably of SiOx, AlOx, HfOx, AlHfOx, AlN, TiN, SiNx, thickness 0-10nm, refractive index 1.45-3.5

- a heterogeneous layer 4 and a full-area conductive layer, both of which may contain hydrogen, doped at least partially n-type [p-type] preferably with N, P, As, Sb [B, Al, Ga, In] refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 40 and the buffer layer 10 as depicted in Figure 20, layer 8, or between the heterogeneous layer 4 and the metallization 302 analogously to Figure 3b, layer 6. The heterogeneous layer 4 may contain an undoped or not intentionally doped region, especially at the side oriented towards the Si wafer.
- a structured capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a front electrode 302.

In case of an embodiment illustrated in Figure 20 comprising an n-type wafer, the solar cell comprises :

- a Si wafer, n-type or resistivity 0.01-1000 Ohmcm;
- a highly doped region 101 of the Si wafer, doped n-type [p-type] preferably with N, P, As, Sb [B, Al, Ga, In];
- a metal electrode 300 , depicted as full-area metal electrode, but the invention also includes an analogous solar cell with structured metal electrode.
- a buffer layer 10 made preferably of SiOx, AlOx, HfOx, AlHfOx, AlN, TiN, SiNx, thickness 0-10nm, refractive index 1.45-3.5;
- a heterogeneous layer 4 and a full-area conductive layer, both of which may contain hydrogen, doped at least partially p-type [n-type] preferably with N, P, As, Sb [B, Al, Ga, In] refractive index 1.45-3.5, thickness 2-2000 nm. The heterogeneous layer consists of at least two phases, preferably of the materials: Amorphous or crystalline or partly crystalline phases of Si, SiC, SiO2, SiOx, SiCxNy, SiCxOy, SiOxCyNz. The full-area conductive layer can be between the heterogeneous layer 4 and the buffer layer 10 as depicted in Figure 20, layer 8, or between the heterogeneous layer 4 and the metallization 302 analogously to Figure 3b, layer 6. The heterogeneous layer 4 may contain an undoped or not intentionally doped region, especially at the side oriented towards the Si wafer.
- a structured capping layer 12 made preferably of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a front electrode 302.

Further preferred embodiments comprise a passivating contact layer stack in at least one of the contacts of a back contacted solar cell. The other contact may be a contact known from the prio art, for example a diffused homojucntion as described in Granek et al., or a silicon heterojunction, or also a passivation contact layer stack according to the invention. The back contacted solar cell is preferentially realized with an interdigitated grid, as described in Granek et al.

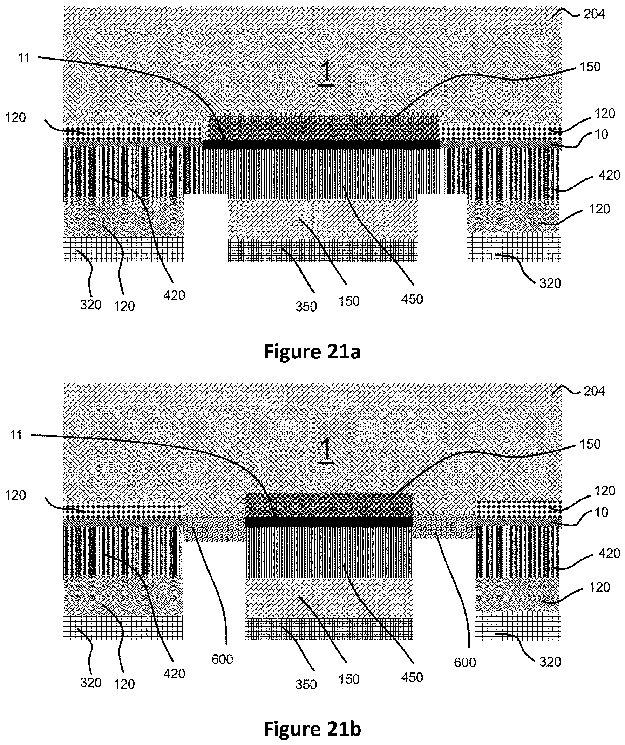

Figure 21 depicts embodiments of back contacted solar cells in which both of the electron and hole contacts is realized as a passivating contact layer stack according to the invention. The passivating contact layer stack can be realized according to the spirit of any of the variants explained above, especially in figure 3 to 6 and Figure 7 to 13 and any combinations thereof.

In the embodiments depicted in Figure 21a and 21b the contacts of both polarities are arranged on the rear side and the wafer is illuminated from the front side. The front side is covered with a dielectric layer 204 (for passivation and antireflection) (preferably made of SiOx, TiOx, AlOx, SiNx, SiOxNy, SiCx, SiCxOy, SiCxNy, SiCxNyOz).

For the sake of clarity the layers of the passivating contact layer stack comprising a heterogeneous layer as described above with the exceptions of the buffer layers and the capping layers are summarized as elements 420 and 450, and referred to as heterogeneous layer-containing element hereinafter.

In the embodiment depicted in figure 21a the metallization 320, 350 and the capping layers 120, 150 and the heterogeneous layer-containing elements 420, 450 are structured.

A solar cell as depicted in Figure 21a can be realized either with a p-type wafer or with a n-type wafer.

In case of an embodiment illustrated in Figure 21a comprising a p-type wafer, the solar cell comprises :

- a Si wafer, p-type of resistivity 0.01-1000 Ohmcm;
- a dielectric layer 204 (for passivation and antireflection) (preferably made of SiOx, TiOx, AlOx, SiNx, SiOxNy, SiCx, SiCxOy, SiCxNy, SiCxNyOz);
- a first buffer layer 10 made preferably of SiOx, AlOx, HfOx, AlHfOx, AlN, TiN, SiNx, thickness 0-10nm, refractive index 1.45-3.5;
- a first heterogeneous layer-containing element 420, doped at least partially p-type [n-type] preferably with B, Al, Ga, In [N, P, As, Sb]
- a first capping layer 120 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a first highly doped region 120 in the Si wafer doped p-type [n-type] preferably with B, Al, Ga, In [N, P, As, Sb]
- a first metal rear electrode 320;
- a second buffer layer 11 arranged between said first buffer layer 10 as shown in Fig.21a made preferably of SiOx, AlOx, HfOx, AlHfOx, AlN, TiN, SiNx, thickness 0-10nm, refractive index 1.45-3.5;
- a second heterogeneous layer-containing element 450, doped at least partially n-type [p-type] preferably with N, P, As, Sb [B, Al, Ga, In];
- a second capping layer 150 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a second highly doped region 150 in the Si wafer doped n-type [p-type] preferably with N, P, As, Sb [B, Al, Ga, In];
- a second metal rear electrode 350 ;

In case of an embodiment illustrated in Figure 21a comprising a n-type wafer, the solar cell comprises :

- a Si wafer, n-type of resistivity 0.01-1000 Ohmcm;
- a dielectric layer 204 (for passivation and antireflection) (preferably made of SiOx, TiOx, AlOx, SiNx, SiOxNy, SiCx, SiCxOy, SiCxNy, SiCxNyOz);
- a first buffer layer 10 made preferably of SiOx, AlOx, HfOx, AlHfOx, AlN, TiN, SiNx, thickness 0-10nm, refractive index 1.45-3.5;
- a first heterogeneous layer-containing element 420, doped at least partially p-type [n-type] preferably with B, Al, Ga, In [N, P, As, Sb];
- a first capping layer 120 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a first highly doped region 120 in the Si wafer doped p-type [n-type] preferably with B, Al, Ga, In [N, P, As, Sb]
- a first metal rear electrode 320;
- a second buffer layer 11 arranged between said first buffer layer 10 as shown in Fig.21a, made preferably of SiOx, AlOx, HfOx, AlHfOx, AlN, TiN, SiNx, thickness 0-10nm, refractive index 1.45-3.5;
- a second heterogeneous layer-containing element 450, doped at least partially n-type [p-type] preferably with N, P, As, Sb [B, Al, Ga, In]
- a second capping layer 150 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a second highly doped region 150 in the Si wafer doped n-type [p-type] preferably with N, P, As, Sb [B, Al, Ga, In];
- a second metal rear electrode 350;

A solar cell as depicted in Figure 21b can be realized either with a p-type wafer or with a n-type wafer.
In case of an embodiment illustrated in Figure 21b comprising a p-type wafer, the solar cell comprises :

- a Si wafer, p-type of resistivity 0.01-1000 Ohmcm;
- a dielectric layer 204 (for passivation and antireflection) (preferably made of SiOx, TiOx, AlOx, SiNx, SiOxNy, SiCx, SiCxOy, SiCxNy, SiCxNyOz);
- a first buffer layer 10 made preferably of SiOx, AlOx, HfOx, AlHfOx, AlN, TiN, SiNx, thickness 0-10nm, refractive index 1.45-3.5;
- a first heterogeneous layer-containing element 420, doped at least partially p-type [n-type] preferably with B, Al, Ga, In [N, P, As, Sb]
- a first capping layer 120 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a first highly doped region 120 in the Si wafer doped p-type [n-type] preferably with B, Al, Ga, In [N, P, As, Sb]
- a first metal rear electrode 320;
- a second buffer layer 11 arranged between said first buffer layer 10 as shown in Fig.21b, made preferably of SiOx, AlOx, HfOx, AlHfOx, AlN, TiN, SiNx, thickness 0-10nm, refractive index 1.45-3.5;
- a second heterogeneous layer-containing element 450, doped at least partially n-type [p-type] preferably with N, P, As, Sb [B, Al, Ga, In];
- a second capping layer 150 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a second highly doped region 150 in the Si wafer doped n-type [p-type] preferably with N, P, As, Sb [B, Al, Ga, In];
- a second metal rear electrode 350;
- a passivation layer 600 in the area not covered by any of the heterogeneous layer-containing elements.

In case of an embodiment illustrated in Figure 21b comprising a n-type wafer, the solar cell comprises :

- a Si wafer, n-type of resistivity 0.01-1000 Ohmcm;
- a dielectric layer 204 (for passivation and antireflection) (preferably made of SiOx, TiOx, AlOx, SiNx, SiOxNy, SiCx, SiCxOy, SiCxNy, SiCxNyOz);
- a first buffer layer 10 made preferably of SiOx, AlOx, HfOx, AlHfOx, AlN, TiN, SiNx, thickness 0-10nm, refractive index 1.45-3.5;
- a first heterogeneous layer-containing element 420, doped at least partially p-type [n-type] preferably with B, Al, Ga, In [N, P, As, Sb];
- a first capping layer 120 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a first highly doped region 120 in the Si wafer doped p-type [n-type] preferably with B, Al, Ga, In [N, P, As, Sb];
- a first metal rear electrode 320;
- a second buffer layer 11 arranged between said first buffer layer 10 as shown in Fig.21b, made preferably of SiOx, AlOx, HfOx, AlHfOx, AlN, TiN, SiNx, thickness 0-10nm, refractive index 1.45-3.5;
- a second heterogeneous layer-containing element 450, doped at least partially n-type [p-type] preferably with N, P, As, Sb [B, Al, Ga, In]
- a second capping layer 150 preferably made of one of the materials Si, SiCx, SiNx, SiOx, SiCxNy, SiCxOy, IO, ITO, IZO, ZTO, IGZO, ZnO:Al, ZnO:B, ZnO:Ga, TiN. This can also be a double layer made of a combinations of the mentioned materials, for instance SiCx/SiNx, SiNx/ZTO, ZTO/ITO etc. All materials may contain hydrogen or oxygen;
- a second highly doped region 150 in the Si wafer doped n-type [p-type] preferably with N, P, As, Sb [B, Al, Ga, In];
- a second metal rear electrode 350;

a passivation layer 600 in the area not covered by any of the heterogeneous layer-containing elements.
The invention is also achieved by a method of fabrication of the solar cell.
In an embodiment of the method of fabrication the realization of a passivating contact layer stack, comprising said heterogeneous layer 4, comprises the following steps: .

- providing a doped silicon wafer having a doping concentration smaller than $1E17cm^{-3}$;
- applying a surface texture on at least one side of the silicon wafer;
- cleaning the silicon wafer in several chemical solutions. Typically, these are solutions in water of one of the following components H2SO3, HNO3, HF, HCl, H2O2, NH4OH, which create a thin surface oxide layer on the silicon absorber wafer surface.
- removing said surface oxide, preferably by exposure to HF, preferably by dipping the silicon absorber wafer in a solution containing HF;
- optionally growing a thin layer of controlled thickness, preferably of a thickness of 0.5nm to 5nm, further preferably 1nm to 2nm, for example a SiOx layer, is grown, for example by exposure to HNO3, UV light, 03, or a oxygen-containing plasma, or 02 or H2O while providing a thermal treatment;
- growing a layer stack comprising at least a heterogeneous layer 4 , for example by plasma-enhanced chemical vapour deposition (PECVD) or low-pressure chemical vapour deposition (LPCVD) or sputtering and optionally a capping layer; The capping layer can be grown at the same time with the other layers of the stack 2 or may be grown after a first annealing step.
- carrying out a first annealing step at 300°C-1100°C for 1s-600min. As an alternative, the heterogeneous nature may also be formed during the annealing step;
- optionally performing a pre-annealing step between growing the heterogeneous layer and growing the capping layer;
- optionally growing a capping layer after performing said first annealing step and performing a second annealing step at 300°C-1100°C for 1s-600min;
- transmitting hydrogen or fluorine through the heterogeneous layer 4, or distributing hydrogen or fluorine from the heterogeneous layer to the silicon absorber wafer 1 or to the buffer layer 10 or to the interface between the silicon absorber wafer and the adjacent layer, or to some other layer between the silicon absorber wafer and the heterogeneous layer, preferably during said first annealing step or said second annealing step.

- optionally exposing the heterogeneous layer stack to a hydrogen atmosphere, preferably at elevated temperatures, preferably at temperatures between 200°C and 700°C, preferably exposing to a hydogen plasma or a hydrogen-containing atmosphere.

It is understood that the growth of the heterogeneous layer is preferably done in specialized growth conditions, preferably conditions that foster crystalline growth of the conductive phase. For example, if a heterogeneous layer with Si conductive portion and SiOx matrix portion is grown by PECVD, preferably gas mixtures of silane (SiH4), hydrogen, carbon dioxide (CO2) and N2O are used, preferably mixtures of SiH4, hydrogen and CO2, preferably using growth regime of crystalline growth of silicon preferably using hydrogen to silane flow ratios of >50, especially, if deposition is done at temperatures <250°C;

It is understood that before or after growth of the heterogeneous layer, additional layers may be formed in the layer stack, preferably full-area conductive layers and/or separation layers can be grown, underneath or on top of the heterogeneous layer, respectively (cf. Fig 3 and Fig. 4).

There are different options to transmit and transfer hydrogen or fluorine through the heterogeneous layer 4. For example, during the first or second annealing step, the capping layer can release hydrogen or fluorine which is transmitted by the heterogeneous layer to the silicon absorber wafer 1 or to the buffer layer 10 or to the interface between the silicon absorber wafer and an adjacent layer, or to any layer between the silicon absorber wafer and the heterogeneous layer. Also the heterogeneous layer can release hydrogen or fluorine in at least one of the two annealing steps, which can also be transmitted to the silicon absorber wafer 1 or to the buffer layer 10 or to the interface between the silicon absorber wafer and the adjacent layer, or to some other layer between the silicon absorber wafer and the heterogeneous layer. Eventually the heterogeneous layer and capping layer are made such that hydrogen or fluorine passes through the entire wafer, reaching also the wafer side that is opposed to the passivating contact layer stack from which the hydrogen is released. A hydrogen or fluorine containing layer can also be prepared on the side of the wafer that is opposed to the passivating contact layer stack, such that hydrogen or fluorine is released during the at least one thermal treatment and passes through the silicon absorber wafer to the buffer layer 10 or to the interface between the silicon absorber wafer and the adjacent layer, or to some other layer between the silicon absorber wafer and the heterogeneous layer. During the annealing steps, dopants, and also other elements included in the layer stack or the buffer layer such as oxygen, carbon, nitrogen, can diffuse from the buffer layer or the layer stack to the wafer, creating possibly a highly doped region 100 in the wafer (see Figure 4b). Moreover, the different layers can crystallize partially during annealing and the different chemical phases can separate further or intermix. More in detail, in a layer consisting of SiCx, annealing can lead to re-structuring of the layer or incorporation of C to the atomic network, i.e. increasing the number of Si-C bonds. Annealing can also lead to partial separation of SiCx to Si and SiC. Annealing can also re-configure hydrogen bonding in the layer, for instance annealing can cause rupture of Si-H bonds but foster formation of C-H bonds, i.e. influence preferential bonding of hydrogen. Annealing can also change the properties of the buffer layer, for instance the thin silicon oxide layer.

Annealing can also be a local process, for instance laser or microwave annealing, i.e. exposing a local portion of the layer stack to laser or microwave radiation. Part of the invention is to use local annealing to form the heterogeneous layer, or to promote locally the diffusion of dopants from the layer stack to the wafer.

In an embodiment of the method of fabrication, the buffer layer, e.g. a thin SiOx layer 10 illustrated in Fig. 3) can be formed during a thermal annealing step.

In an embodiment of the method of fabrication, the heterogeneous layer is prepared directly on the Si surface, i.e. without the buffer layer 10. In this case, the buffer layer 10 can eventually be formed in a subsequent annealing step.

In an embodiment of the method a heterogeneous multilayer comprising a plurality of heterogeneous layers 4 are realized. Such a heterogeneous layer consisting of sublayers can be advantageously prepared: For example, when PECVD is used to prepare the heterogeneous layer, the PECVD conditions can be chosen such that the conductive phase mainly grows crystalline, for example microcrystalline silicon grown from mixtures of silane, hydrogen and possibly dopant gases. Injection of CO2 to the plasma leads to the growth of a SiOx phase in some regions on the surface, while in other regions growth of silicon still continues. Possibly, over time the area of the SiOx regions increases, and the area of the silicon regions decreases, and the silicon regions would possibly even vanish completely after some sufficiently long time. In this case it is beneficial to switch off CO2 and thus the growth of SiOx regions before the silicon regions vanish in order to foster growth of the silicon regions again. Repetition of this procedure thus yields a layer with an electrically interconnected silicon portion, the layer being built up as a heterogeneous multilayer, the sublayers of which are layers which contain the conductive portion or the conductive and the matrix portion, for example the sublayers being silicon layers or layers that contain silicon and SiOx portions.

**Economic potential**

The innovative layers presented here allow the develop of the next generation of double-side contacted Si solar cells with carrier selective junctions, targeting efficiencies > 25% on cell area >100cm2 and > 22 % on module level, by using existing production processes and equipements with the aim to reach an LCOE of 0.04 - 0.07 $/kWh and a production cost of 40$ct/Wp. In the medium term, with upscaling and continuous improvement we further expect a decrease of around 10% for the cost of electricity and the module manufacturing costs.

**Experimental results**

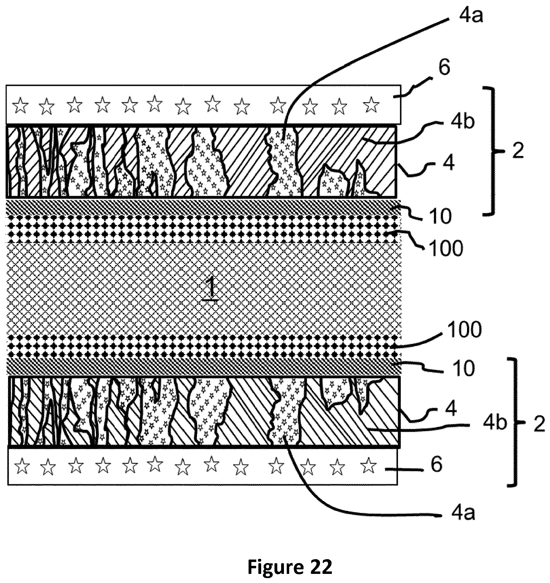

A couple of experiments with a solar cell comprising the layer stack 2 of the inventionhas been performed as show in Figure 22. In this experiment, the layer stack comprises:

- a full-area SiOx layer prepared by wet-chemical oxidation (10 in Fig 3);
- a heterogeneous layer (4 in Fig. 3) comprising a SiOx layer (4a in Fig. 3) with $\mu$c-Si phases (4a in Fig. 3);
- and a $\mu$c-Si layer on top (6 in Fig. 3).

The latter two layers are prepared by a PECVD technique and are in some experiments doped either by phosphorous or boron. The layer stack was prepared on both sides of the sample to allow evaluation of the emitter saturation current density. After deposition of the layer stack the samples were annealed at temperatures of 750°C to 950°C, during which the dopants may diffuse into the wafer 1 forming the highly doped region 100 on both sides of the wafer with same dopant. The capping layer 12 was omitted here for simplicity. It has to be noted that after thermal annealing, i.e. without any hydrogenation, the passivation quality was already good. However, an additional hydrogenation step improves the passivation quality.

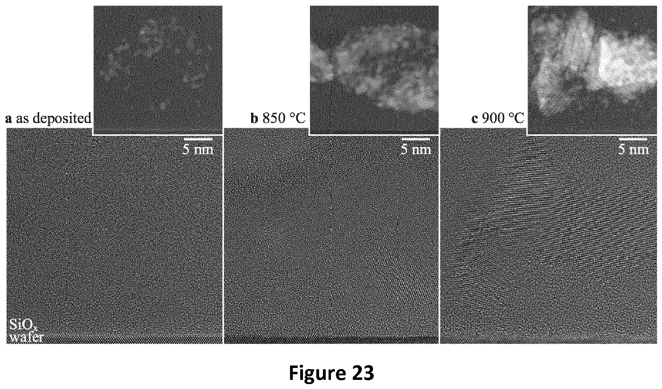

Figure 23 illustrates High-resolution transmission electron (HRTEM) micrographs of the contact structure as described in figure 22 doped with phosphorous in a state, as deposited (Fig.23a), annealed at 850 °C (Fig.23b) and annealed at 900 °C (Fig.23c). In the smaller images, the micrographs are overlaid with inverse Fourier transforms of selected reflections, to illustrate crystalline silicon phases.

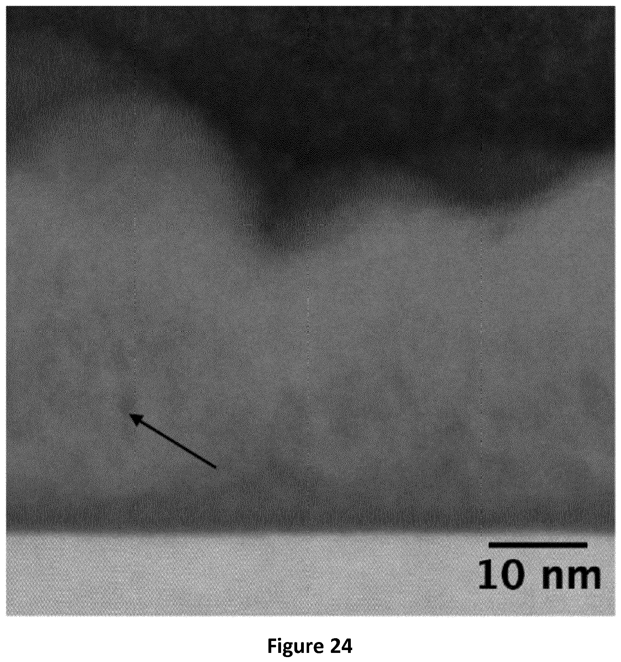

Figure 24 illustrates Transmission electron micrographs in high angle annular dark field (HAADF) of the structure described in figure 22 doped with phophorous in the as-deposited state. The dark area show SiOx phases. The buffer layer 10 can clearly be seen as well as SiOx inclusions in the Si layer (black arrow).

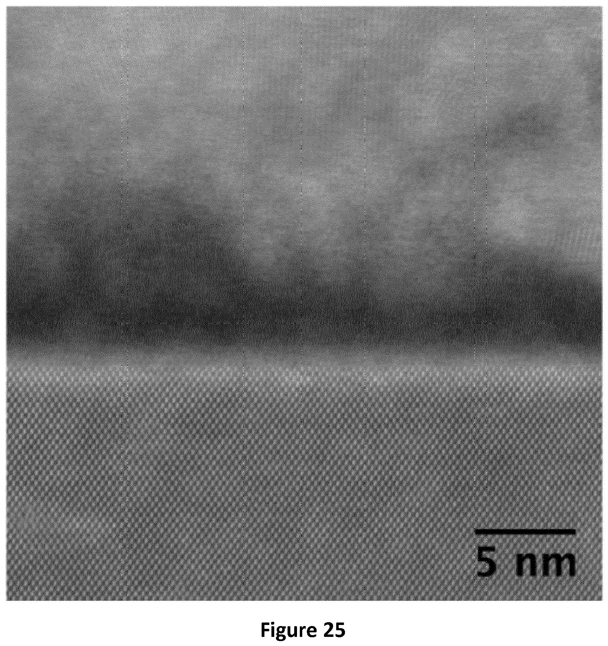

Figure 25 illustrates Transmission electron micrographs in high angle annular dark field (HAADF) of the structure described in figure 22 doped with phophorous in the annealed state. The dark area show SiOx phases. The SiOx phases are more clearly visible than in the as-deposited state and extend further into the Si layer.

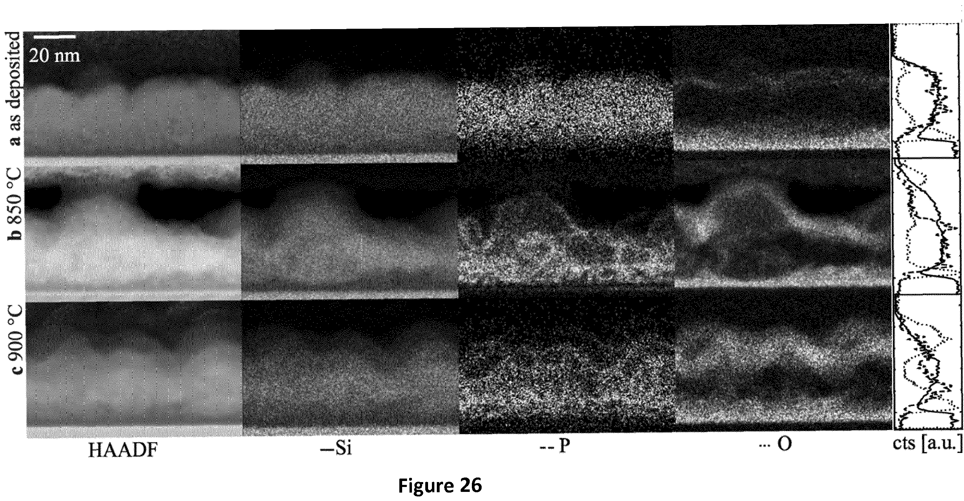

Figure 26 illustrates transmission electron micrographs of a structure as described in figure 22 doped with phophorous in high angle annular dark field (HAADF) and electron dispersive x-ray (EDX) mode in the as-deposited state (top row, (a)), after annealing at 850°C (middle row (b)), and after 900°C annealing (bottom row, (c)). The EDX images show the elemental distribution of Si, P and O throughout the layer, bright contrast corresponding to a high concentration. At the interface of the Si wafer (0nm in the EDX profile shown right), a full-aera O-rich be distinguished, which corresponds to buffer layer 10 in Fig. 3. On top of that layer, there is a layer with inhomogenous O content and inhomogenous thickness, corresponding to the heterogeneous layer 4 in Fig. 4. The O content drops to about 0at% at 12nm from the wafer surface, which is followed by a full-area Si layer, which corresponds to the conductive layer (6) in Fig. 4.

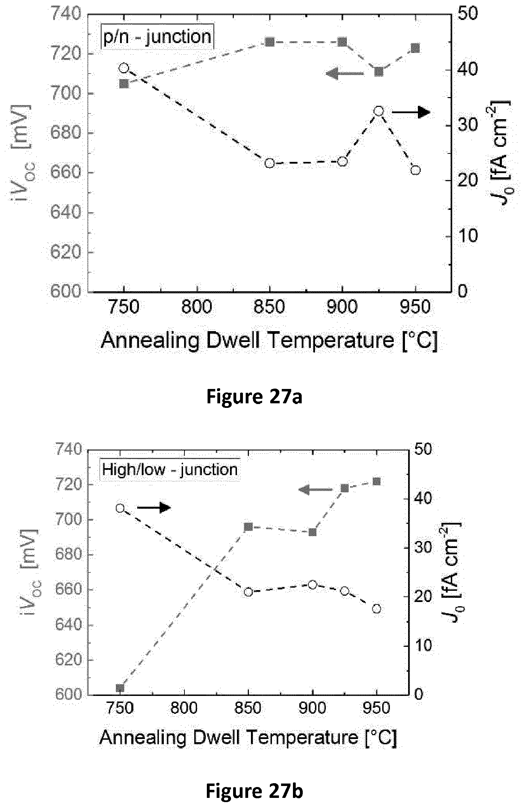

Figure 27a illustrates implied open-circuit voltage iVOC and emitter saturation current density J0 for several annealing dwell temperatures between 750°C and 950°C.with the a layer stack described in figure 22 doped with phosphorous on p-type wafers. An increase of the anneal dwell temperature leads to an increase in passivation seen as an increase in iVOC and a decrease in J0. It is important to note that also for temperatures above 900°C good passivation is achieved which we relate to the additional oxygen in the matrix of the heterogeneous layer.

Figure 27b illustrates implied open-circuit voltage iVOC and emitter saturation current density J0 for several annealing dwell temperatures between 750°C and 950°C with the layer stack described in figure 22 doped with phosphorous on n-type wafers. An increase of the anneal dwell temperature leads to an increase in passivation seen as an increase in iVOC and a decrease in J0. It is important to note that also for temperatures above 900°C good passivation is achieved which we relate to the additional oxygen in the matrix of the heterogeneous layer.

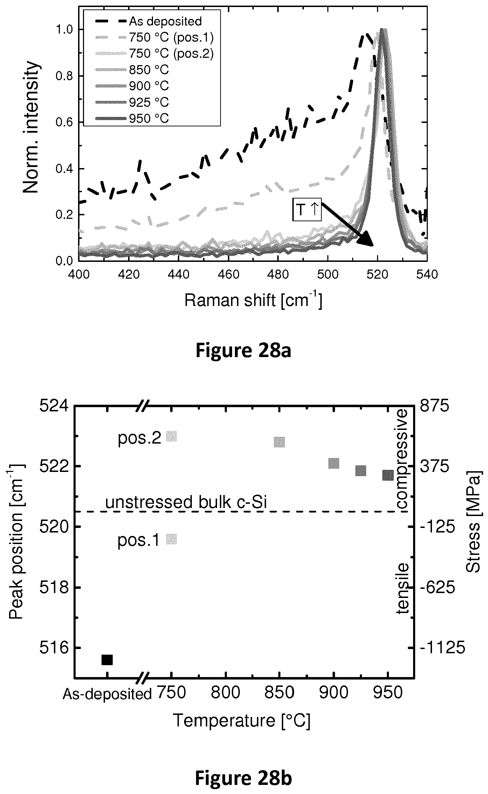

Figure 28a illustrates Raman spectra of the layer stack, as sketched in fig. 3b and also described in fig 23-26, as a function of the annealing peak temperature. The amorphous contribution, visible as peak shoulder for lower raman shifts (below 520 cm$^{-1}$), is very small already in the as-deposited state, and vanishes completely for annealing temperatures > 750°C. This indicates a highly crystalline nature of all Si phases.

Figure 28b illustrates the peak positions of the Raman spectra of figure 28a. The shift of peak position is a measure for stress in the layer stack. In the as-deposited state the layer stack is in tensile stress which is then changed to compressive stress in the annealed state (except for the anneal at 750°C which shows two different stress levels at two different positions on the same sample pointing towards a lateral inhomogeneity). By increasing the anneal temperature the compressive stress is decreasing. We relate this stress release to a rearrangement of the conductive (here: Si(n)) and the matrix (here: SiOx) phase in the heterogeneous layer. This shows that this layer can handle stress well and can be used as an interlayer between two layers with different stress levels to compensate stress due to its heterogeneous structure and its opportunity to rearrange.

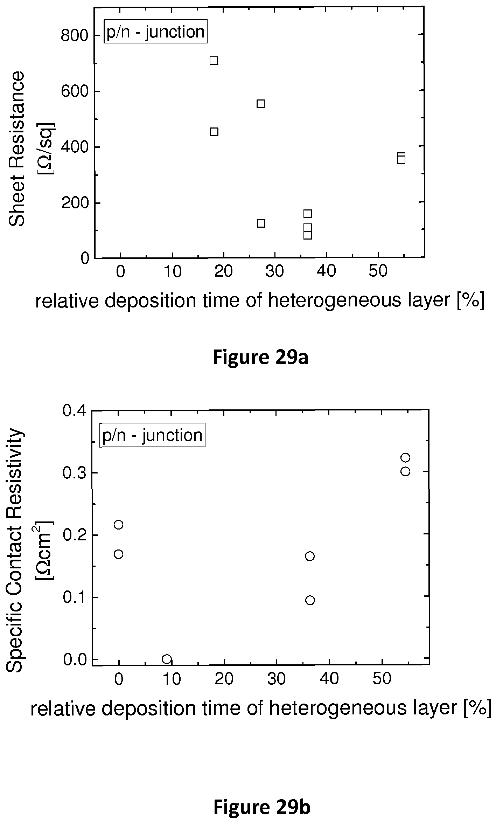

Figure 29a illustrates the sheet resistance of the layer stack as sketched in fig. 3b for which the thickness of the heterogeneous layer 4 (here SiOx(n)) is varied and compensated by the thickness of the conductive layer (here: Si(n)) on top (keeping the whole PECVD deposition time constant). The layer stack is metalized with coplanar Al pads on a p-type wafer and measured with transmission line measurement. The decrease of the sheet resistance with the thickness of the heterogeneous $\mu$c-SiOx layer indicates stronger in-diffusion of phosphorous.

Figure 29b illustrates the specific constant resistivity of the layer stack as sketched in fig. 3b for which the thickness of the heterogeneous layer hl (here SiOx(n)) is varied and compensated by the thickness of the conductive layer (here: Si(n)) on top (keeping the whole PECVD deposition time constant). The layer stack is metalized with coplanar Al pads on a p-type wafer and measured with transmission line measurement.

Specific contact resistivities of 0.1 $\Omega$cm2 have been obtained.

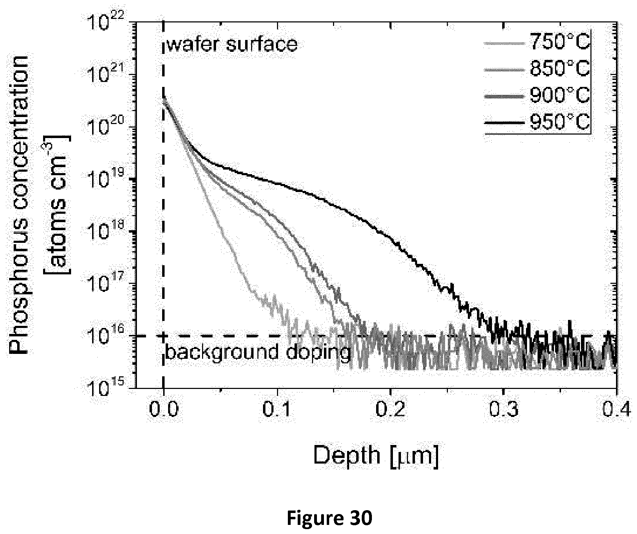

Figure 30 illustrates secondary ion mass spectroscopy (SIMS) profiles of the highly doped region (100) in the Si wafer directly underneath the wafer surface (0 $\mu$m corresponds in the figure 30 to the wafer surface). The profiles show that phosphorous diffuses into the wafer upon thermal annealing. Higher anneal dwell temperature leads to higher phosphorous concentration and deeper profiles.

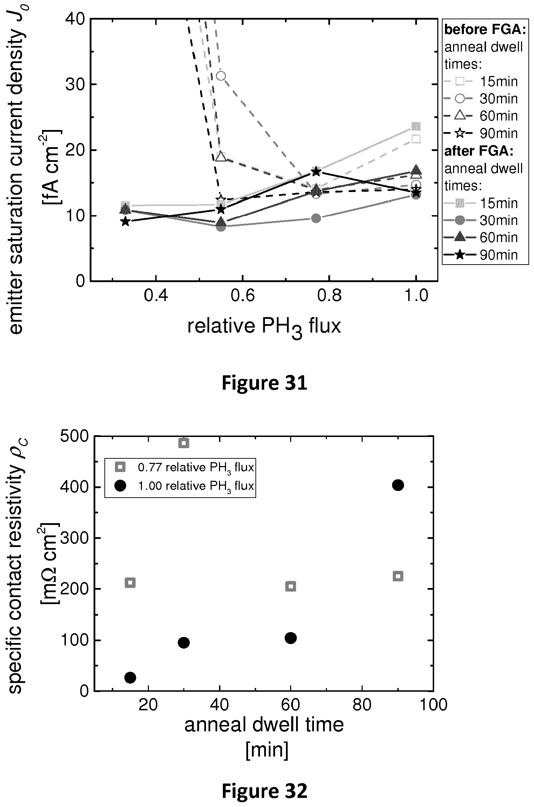

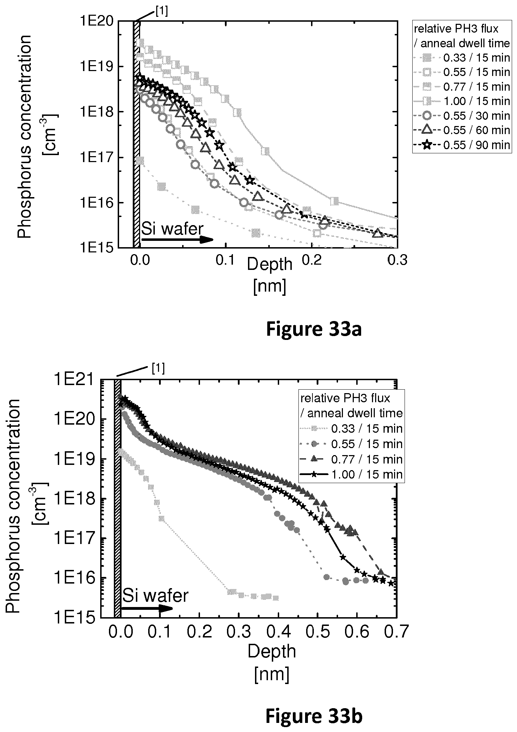

Figure 31 shows the dependence of the emitter saturation current density (J0) on the PH3 gas flow during the PECVD deposition. J0 was extracted from measurements of the minority carrier lifetime of n-type silicon wafers coated on both sides with a layer stack as sketched in Figure 22.The higher the PH3 flow during deposition, the higher the phosphorous concentration in the layer stack. All samples were annealed at 900°C for dwell times between 15min and 90min. The emitter saturation current density J0 after an annealing at 900°C is strongly dependent on the phosphorous concentration in the deposited layer stack. Whereas before hydrogenation the optimum (lower J0) lies towards higher phosphorous content, the optimum shifts towards lower phosphorous content after hydrogenation by a forming gas anneal (FGA). The anneal dwell time also influences the in-diffusion and therefore passivation quality and characteristics. A longer anneal dwell time leads to stronger in-diffusion of P from the deposited layers to the wafer (see Figure 33a) and thus lower minority charge carrier density at the interface, i.e. lower interface recombination rates. We explain the worse passivation (higher J0 value) which is seen in Figure 31 for very high doping with stronger Auger recombination caused by the high doping concentration in the highly doped region (100) in the silicon wafer.

Figure 32 shows the specific contact resistivity $\rho_c$ as a function of anneal dwell time at 900°C for different PH3 gas flows during PECVD deposition. The same samples as in Fig (31) are used and the specific contact resistivity $\rho_c$ is measured with aluminum as metallization. $\rho_c$ depends on the doping concentration in the layer stack which is increased by an increase of the flow of the precursor gas PH3 during PECVD deposition. The results show that a high phosphorous concentration in the deposited layer is beneficial for attaining a lower $\rho_c$, which means more efficient extraction of charge carriers. The increase in $\rho_c$ with a longer anneal dwell time could be explained by two effects: a decrease of the concentration of phosphorous within the layer resulting in a higher contact resistivity between the metal and the deposited stack, or a more complete phase separation from SiOx to Si and SiO2, accompanied by larger but fewer Si particles, resulting in an interrupted network of the conductive phase in the matrix phase, i.e. interrupted conductive pathways through the matrix phase.

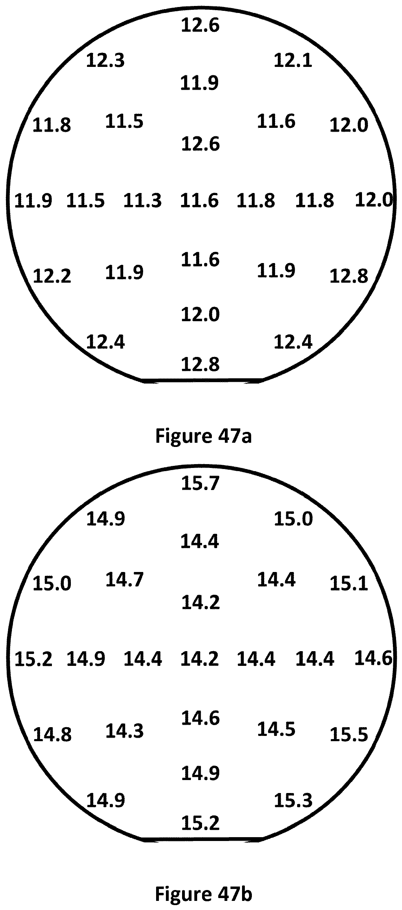

Figure 33a shows the phosphorous concentration measured by electrochemical capacitance voltage measurements (ECV) as a function of the depth in the n-type wafer. The surface of the silicon wafer is at the position 0nm. The same samples as in Fig (31) are used. After the annealing at 900°C for anneal dwell times between 15 - 90 min in which the in-diffusion of dopants from the deposited heterogeneous layer (here: SiOx(n)) and conductive layer (here: Si(n)) took place, the samples were measured by ECV after the layer stack had been removed by HF. The doping profile depends on the annealing conditions (dwell time, dwell temperature, heating and cooling ramps, in case of RTP or flash lamp annealing also photon fluxes and wavelength) and the phosphorous concentration in the deposited layer. Here, the influence of the phosphorous concentration in the deposited heterogeneous (SiOx) and conductive (Si) layer is dominating the effect, whereas the anneal dwell time has less influence. A higher relative phosphorous flow during deposition (here shown for 15min anneal dwell time) results in a higher surface concentration in the wafer and a deeper profile. A longer anneal dwell time (here shown for a relative PH3 flow of 0.55) also leads to a higher surface concentration and a deeper profile than a shorter anneal dwell time but less pronounced than the influence of the phosphorous flow during PECVD deposition. Remarkable is the difference between n-type wafer (Figure 33a) and p-type wafer (Figure 33b), respectively. Even though all samples were co-processed (chemical cleaning, growth of the chemical oxide, PECVD deposition, anneal) phosphorous diffuses much deeper and with higher concentration into p-type wafer. This is most probably due to a difference in the growth of the chemical oxide due to a different wafer doping (see figure 47a for p-type wafer and figure 47b for n-type wafer).

Figure 33b shows the phosphorous concentration measured by electrochemical capacitance voltage measurements (ECV) as a function of the depth in the p-type wafer. The surface of the silicon wafer is at the position 0nm. The same sample structure as for samples in Fig (31) but on p-type wafers are used. After the annealing at 900°C for anneal dwell times of 15min during which phosphorous diffused from the deposited layer stack (heterogeneous (here: SiOx(n)) and conductive (here: Si(n)) layer) to the wafer, the layer stack was removed by etching in HF and the samples were then measured by ECV. The doping profile depends on the annealing conditions (dwell time, dwell temperature, heating and cooling ramps, in case or RTP or flash lamp annealing also photon fluxes and wavelength) and the phosphorous concentration in the deposited layer. It can be seen in the figure that a higher relative phosphorous flow during deposition results in a higher surface concentration in the wafer and a deeper phosphorous profile in the wafer. More in detail, a threefold increase of the PH3 flow results in a twentyfold increase of the surface concentration.

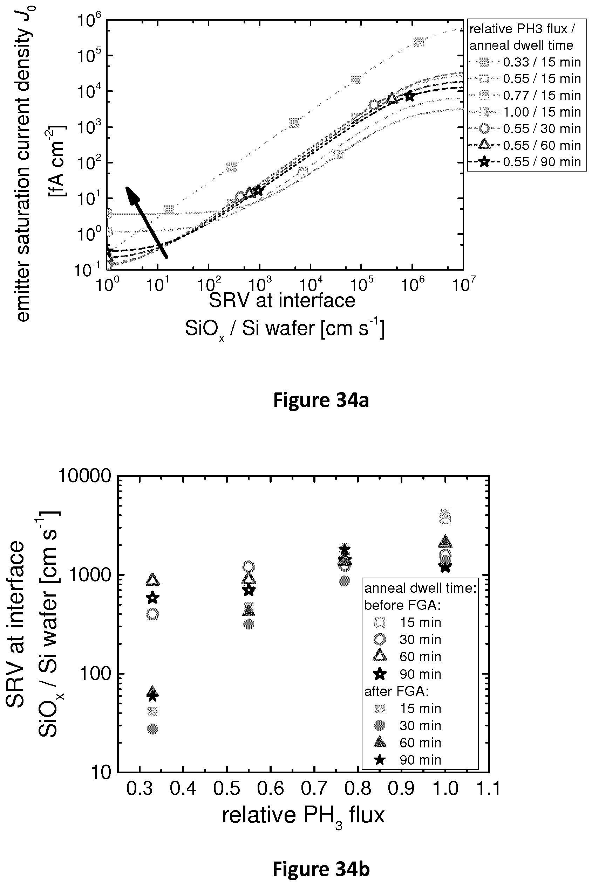

Figure 34a shows surface recombination velocities (SRV) at the interface between the buffer layer and the Si wafer as a function of the emitter saturation current density (J0) obtained from EDNA2- simulations [PVLighthouse.com.au, 2016] of the recombination properties in the samples using the measured phosphorous doping profiles shown in Figure 33a. For higher phosphorous concentrations, the minimal possible J0 (with low SRV) is higher than for lower phosphorous concentrations (indicated by the arrow). Furthermore the figure shows that J0 is less sensitive to SRV in case of high PH3 flows, which allows to reach a lower J0 at a certain SRV than with smaller PH3 flow. The dependence of J0 and SRV shown in this figure allows to determine the SRV for a measured J0 value, which was done to obtain the SRV values shown in Figure 34b.

Figure 34b shows the SRV values extracted from simulations shown in Figure 34a. Lower PH3 fluxes show lower SRV values and the influence of the FGA to decrease SRV is more pronounced for lower PH3 fluxes during deposition.

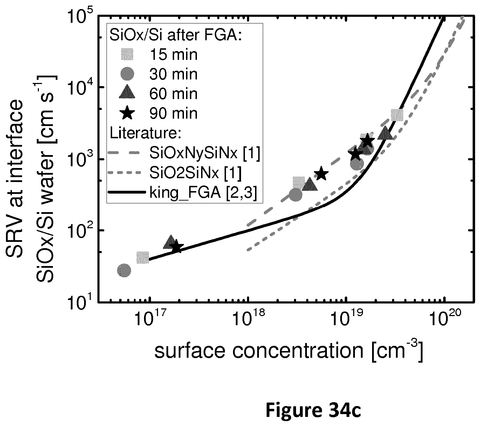

Figure 34c shows the SRV values extracted from the samples discussed in Figures 31 to 34, determined from EDNA-based simulations as explained for Figure 34a. Here the SRV values are plotted versus the phosphorous concentration at the silicon wafer surface (symbols), together with SRV values for dielectric passivation layers reported in the literature:

[1]: A. Kimmerle, Md. M. Rahman, S. Werner, S. Mack, A. Wolf, A. Richter, and H. Haug, "Precise parameterization of the recombination velocity at passivated phosphorus doped surfaces," Jorunal of Applied Physics, vol 119, 2016
[2]: R. R. King, R. A. Sinton, and R. M. Swanson, "Studies of Diffused Phosphorus Emitters: Saturation Current, Surface Recombination Velocity, and Quantum Efficiency," IEEE Transactions on Electron Devices, vol 37, 1990
[3]: P. P. Altermatt, J. O. Schumacher, A. Cuevas, M. J. Kerr, S. W. Glunz, R. R. King, G. Heiser, and A. Schenk, "Numerical modeling of highly doped Si:P emitters based on Fermi-Dirac statistics and self-consistent material parameters," Journal of Applied Physics, vol 92, 2002

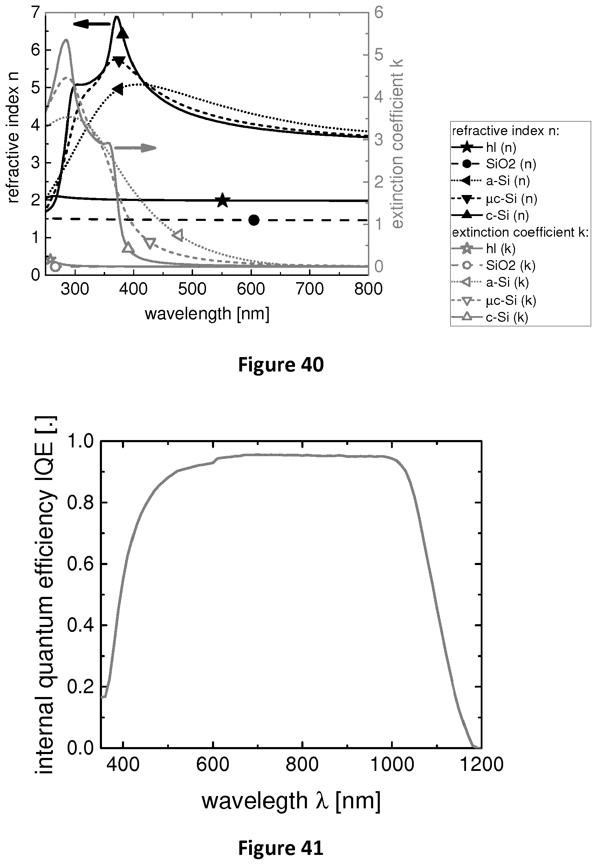

Dielectric passivation layers are electrically insulating and thus do not allow to establish an electrical contact to the charge carriers in the silicon wafer. The SRV values obtained with our passivating contact layer stack (consisting of a heterogeneous SiOx layer and a Si layer as described in Figure 22 follow the same dependence on phosphorous surface concentration. In addition, our layer stack also acts as electrical contact to the silicon wafer. This proofs the concept of the heterogeneous layer: The heterogeneous layer provides a) as good passivation as dielectric layer consisting of the matrix phase, b) a lowered refractive index than the refractive index of the conductive portion (see Figure 40) and c) an electrical contact to charge carriers in the silicon wafer (see figure 32).

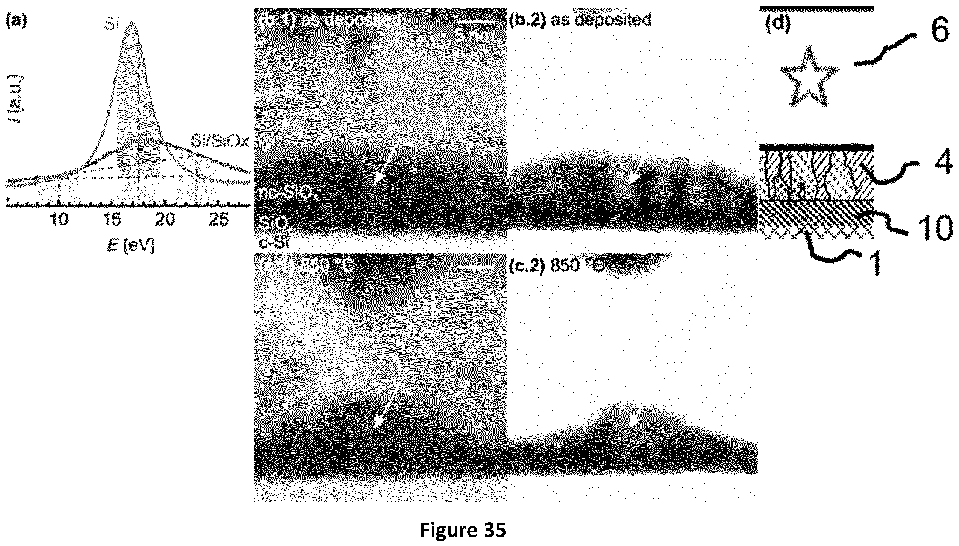

Figure 35 shows in (a) the Electron energy-loss spectroscopy (EELS) spectra of c-Si and phase-separated Si/SiOx regions which are used to produce an image shown in (b2 and c2). The samples with a layer stack as sketched in Figure 22 and as figure d having a Si wafer (1), a SiO2 buffer layer (10) anda SiOx(n) heterogeneous layer (4) and a Si(n) conductive layer (6) deposited by PECVD. The samples are analyzed in the as-deposited state (b1-2) and after an annealing at 850°C for 15min (c1-2). In (b.1) scanning TEM (STEM) high-angle annular dark field (HAADF) and corresponding (b.2) EELS spectrum image of plasmons after background subtraction (colored region of the spectrum shown in (a)) of the as-deposited sample; (c1-2) STEM HAADF and plasmons EELS spectrum image of the sample annealed at 850 °C. The heterogeneous nature with silicon phases (arrow, bright) within the Silicon oxide matrix (dark) are well visible in the as deposited samples as well as in the annealed state. The conductive inclusions (here: Si) are oriented in saggital direction and the width is in the range of 1-4nm. The inclusions are embedded in a matrix (here: SiOx), and the distance between two neighboring inclusions is also in the range of 1-4nm.

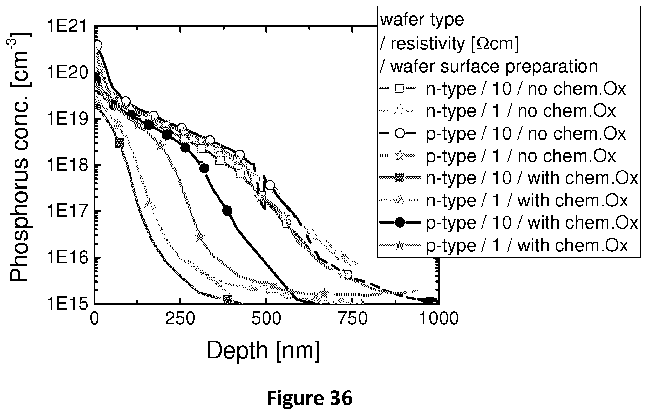

Figure 36 shows the phosphorous doping concentrations as function of depth in the Si wafer measured by ECV. A design like described in Figure 22 (with and without buffer layer 10) is used on flat substrates where both the deposited heterogeneous layer (here: SiOx(n) and the deposited conductive layer (here: Si(n)) are doped with phosphorous. ECV doping profiles are shown for samples after annealing at 900°C for 15min and after the buffer layer, the heterogeneous layer and the conductive layer is removed by HF. All presented samples in this figure were co-processed (chemical cleaning, growth of the chemical oxide, PECVD deposition, anneal). The only difference between the samples were the wafer polarity, wafer doping concentration and a removal of the chem. SiOx buffer layer before PECVD deposition. When the buffer layer (layer 10 in Figure 22) is removed by HF before PECVD deposition (layer 4 and layer 6) the in-diffusion of phosphorous is similar for n- and p-polarity of the wafer and does not depend on doping concentration of the wafer. But when a chemical oxide buffer layer is present the differences between doping type and concentration has a strong influence on the in-diffusion of phosphorous which we relate to a different growth of the buffer layer, such as different density, structure or thickness. On p-type wafers the in-diffusion is stronger (deeper and with higher concentration) than on n-type wafers pointing towards a thinner buffer layer. By changing the concentration of the base/surface doping of the wafer, the in-diffusion is also changing (related again to a different buffer layer growth) where a higher doping for p-type wafers reduces the in-diffusion. For n-type wafers this is the opposite with a higher doping concentration showing a deeper diffusion.

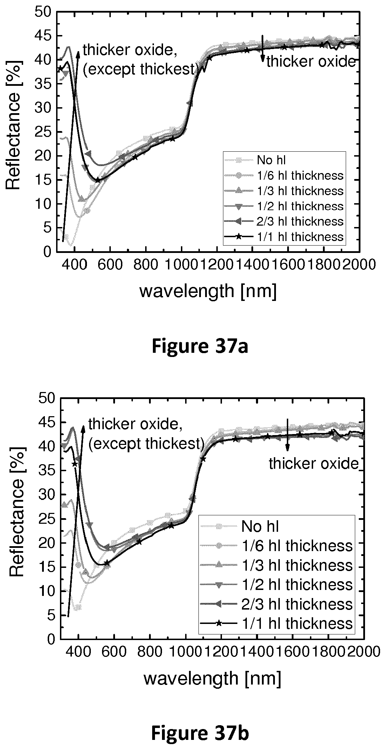

Figure 37a shows the reflectance as a function of wavelength. A design like described in Figure 22 is used with n-type wafers as substrate and for which the thickness of the heterogeneous layer hl (here SiOx(n)) is varied and compensated by the thickness of the conductive layer (here: Si(n)) on top (keeping the whole PECVD deposition time constant). A strong increase below 600nm is visible by increasing the heterogeneous layer thickness up to a certain maximum (2/3 relative heterogeneous layer thickness) before the reflectance decreases again. At longer wavelength ( > 1000nm) a slightly decreased reflectance results with thicker heterogeneous layer. By tuning the heterogeneous layer thickness and properties the internal reflectance can be optimized for the use e.g. as back reflector.

Figure 37b shows the reflectance as a function of wavelength. A design like described in Figure 22 is used with p-type wafers as substrate and for which the thickness of the heterogeneous layer hl (here SiOx(n)) is varied and compensated by the thickness of the conductive layer (here: Si(n)) on top (keeping the whole PECVD deposition time constant). A strong increase below 600nm is visible by increasing the heterogeneous layer thickness up to a certain maximum (2/3 relative heterogeneous layer thickness) before the reflectance decreases again. At longer wavelength ( > 1000nm) a slightly decreased reflectance results with thicker heterogeneous layer. By tuning the heterogeneous layer thickness and properties the internal reflectance can be optimized for the use e.g. as back reflector.

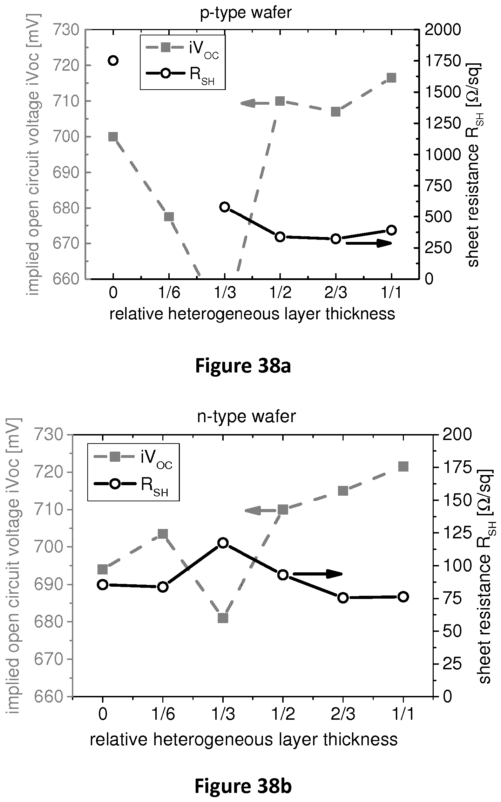

Figure 38a shows on the left axis the implied open circuit voltage (iVoc) and on the right axis the sheet resistance $R_{SH}$ as a function of the relative heterogeneous layer thickness. A design like described in Figure 22 is used with p-type wafers as substrate and for which the thickness of the heterogeneous layer (here SiOx(n)) is varied and compensated by the thickness of the conduction layer (here: Si(n)) on top (keeping the whole PECVD deposition time constant). The sheet resistance is a measure for the in-diffusion of phosphorous during the annealing at 900°C for 15min. The iVoc is increasing towards the two extremes, so either having a thin heterogeneous layer (or no heterogeneous layer) or when the heterogeneous layer is getting thicker. The sheet resistance is decreasing with thicker heterogeneous layer pointing towards a deeper in-diffusion of phosphorous. This shows that the heterogeneous layer acts as doping source during the at least one thermal treatment.

Figure 38b shows on the left axis the implied open circuit voltage (iVoc) and on the right axis the sheet resistance $R_{SH}$ as a function of the relative heterogeneous layer thickness. A design like described in Figure 22 is used with n-type wafers as substrate and for which the thickness of the heterogeneous layer (here SiOx(n)) is varied and compensated by the thickness of the conductive layer (here: Si(n)) on top (keeping the whole PECVD deposition time constant). The sheet resistance is a measure for the in-diffusion of phosphorous during the annealing at 900°C for 15min. The iVoc is increasing towards a thicker heterogeneous layer. The sheet resistance is decreasing with thicker heterogeneous layer pointing towards a deeper in-diffusion of phosphorous. Please note that as the wafer doping is phosphorous, the sheet resistance reported here refers to the entire wafer thickness and is affected by two-dimensional transport effects. This is also the reason why the dependence on the thickness of the heterogeneous layer is less pronounced than in Figure 38a.

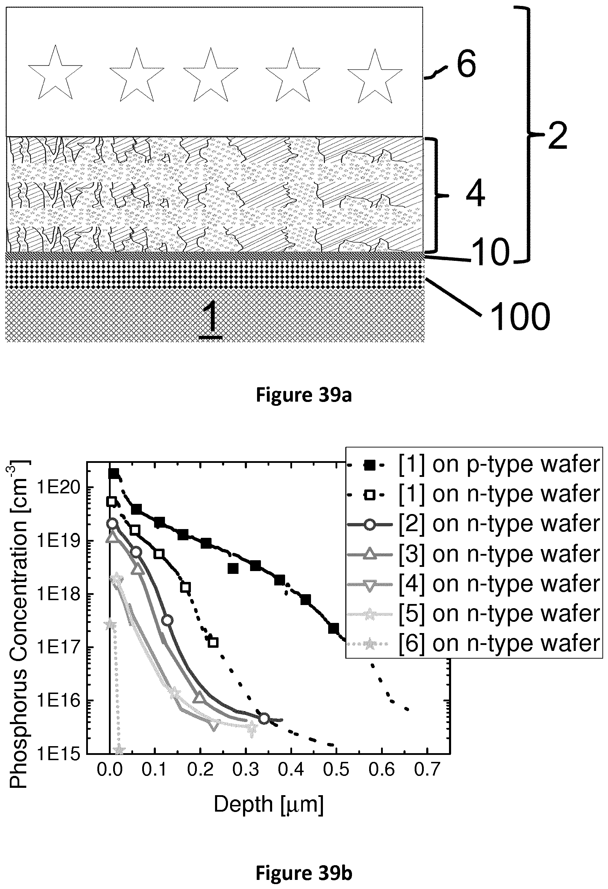

Figure 39a shows a sketch of the heterogeneous multilayer structure as described in Figure 5 used for samples in Figure 39b. The heterogeneous layer 4 is prepared as a heterogeneous multilayer consisting of layers of the conductive phase (without the matrix phase) and layers containing the conductive and the matrix phase. In this example we show a heterogeneous layer with a deposited heterogeneous layer ratio (dhlr) of 2/3, meaning that the heterogeneous layer contains 3 times a layer containing the conducting and the matrix phase and 2 times a layer containing only the conductive phase. This definition of the deposited heterogeneous layer ratio is used to describe the layer structure.

Figure 39b shows the ECV profiles of phosphorous in the wafer (0 is the wafer surface) after an annealing at 900°C for 15 min. Different deposited layer stacks, in which the heterogeneous layer and the conductive layer are doped with phosphorous are described by: [1] is a structure as described in Figure 22; [2] is a structure as described in figure 39a with a deposited heterogeneous layer ratio (dhlr) of 1/3; [3] is a structure as described in figure 39a with a dhlr of 1/2; [4] is a structure as described in figure 39a with a dhlr of 2; [5] is a structure as described in figure 39a with a dhlr of 2/3; [5] is a structure as described in figure 39a with a dhlr of 2/3, like [5], but the heterogeneous layer is kept intrinsic during PECVD deposition. The measured profile for layer [1] shows the highest concentration and deepest profile, which we relate to the absence of a layer within the heterogeneous layer containing only the conductive phase. The deeper profile on p-type wafer than on n-type is a confirmation of results shown in Figure 36. The profile depth and concentration for the different deposited layers [2-5] show, that the dhlr is not the only factor that determines the doping profile for phosphorous. Even more a shallow profile can be reached either with a high dhlr [4] or with a low dhlr [5]. A deep profile with higher concentrations can also be reached with a low dhlr [3] as well as with a high dhlr [2]. This gives the possibility to tune the doping profile independently on the dhlr and therefor on the ratio between the conductive phase and the matrix phase, giving the possibility to tune this layer for optical properties. Comparing [5] and [6], the doping profile of [5] is deeper, whereas keeping the heterogeneous layer intrinsic [6], the phosphorous in-diffusion is drastically decreased.

Figure 40 shows the refractive index n (black, left axis) and the extinction coefficient k (grey, right axis), extracted from ellipsometry measurements, for a structure described in Figure 3a with phosphorous doped heterogeneous layer (hi) 4 (here: SiOx(n)) after an annealing at 900°C for 15min. As comparison the refractive index and the extinction coefficient of crystalline Silicon (c-Si), microcrystalline silicon ($\mu$c-Si), amorphous silicon (a-Si) and silicon oxide (SiO2) are added to the figure. The refractive index n for the heterogeneous layer in this case is between 2.0-2.1 for 250nm < $\lambda$ < 350nm and decreases for longer wavelengths to 1.96. This is close to SiO2 with 1.45 < n < 1.55 and much lower than silicon with a maximum of n between 5 and 7 depending on its crystallinity state. At longer wavelength n is not decreasing below 3 for silicon. The extinction coefficient k of the heterogeneous layer (hi) is between 0.25 and 0.025 for 250 < $\lambda$ < 300nm and decreases with higher wavelengths Also k is close to SiO2 for which k is 0. For silicon in its different crystallinity states, k is above 2.5 for 250 < $\lambda$ < 350nm.

Figure 41 shows the internal quantum efficiency [IQE] of a co-diffused cell with a contact structure similar to the one described Figure 17. The difference to figure 17 is that the solar cell has a conductive layer 60 in analogy to element 6 in figure 3b but without conductive layer 80. The solar cell is realized on a flat n-doped wafer comprising, from the rear, with

- aluminum as full area rear electrode 300;
- ITO as capping layer 12;
- Si(p) as conductive layer 6;
- SiOx(p) as heterogeneous layer 4 on the rear side of the solar cell;
- SiO2 as buffer layer 10;
- n-type wafer as 1 with an firs doped layer 100 doped with boron at the rear and a second highly doped layer doped with phosphorous at the front;
- SiO2 as buffer layer 11;
- SiOx(n) as heterogeneous layer 40;
- conductive layer 60, consisting of Si(n) ;
- ITO as further capping layer 13;
- Ag fingers as front electrode 302.

This proof of concept cell has a Voc of 680mV, a Jsc of 34.1 mA/cm$^2$, a FF of 78.6% leading to a conversion efficiency of 18.3 %.Especially the blue response is strong with an IQE of 0.79 at $\lambda$ = 450nm.

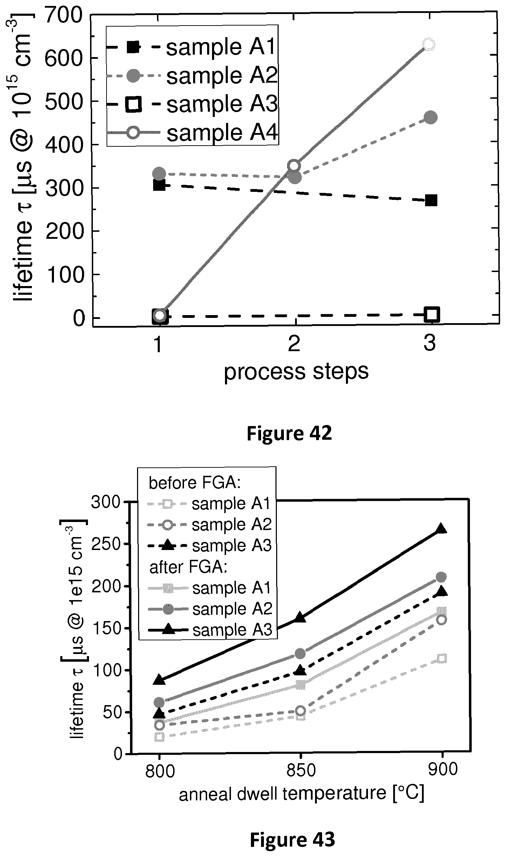

Figure 42 shows the evolution of the effective lifetime measured by Photoconductance Decay (PCD) measurements of symmetrical samples after 3 processing steps. All samples have seen the same process before process step 1 including an annealing at 900°C for 15min. At this stage the structure is similar to figure 4b. At process step 1 sample A1 and A2 got a FGA, sample A3 and A4 not. This leads to an increase in lifetime for sample A1 and A2. At process step 2 a capping layer is deposited on both surfaces of the samples A2 and A4 by PECVD, samples A1 and A3 are kept on condition after process step 1. This increases the lifetime for sample A4, but not for A1-A3. At process step 3 all samples A1-A4 are annealed at 450°C for 30 min in a nitrogen atmosphere. This increases the lifetime for sample A2 from 322 $\mu$s to 457 $\mu$s and for sample A4 from 347 $\mu$s to 625 $\mu$s. The lifetime of sample A1 is slightly decreasing from 306 $\mu$s after process step 1 to 265 $\mu$s after process step 3. The lifetime of sample A1 is staying after all process steps below 3 $\mu$s. The increase in lifetime for sample A2 and A4 after process step 3 is explained by a release of hydrogen out of the capping layer which is diffused to the interface between buffer layer and wafer.

Figure 43 shows the effective minority carrier lifetimes and its dependence on Boron concentration in the heterogeneous layer and anneal dwell temperature. For this study, symmetrical samples with a structure as sketched in Figure 22 were used with a buffer layer (here: SiO2), a heterogeneous layer (here: SiOx(p)) and a conductive layer (here: Si(p)) on both sides of the p-type wafer. The heterogeneous layer was varied by keeping a part close to the buffer layer intrinsic. For sample A1 the whole heterogeneous layer is doped with boron. The heterogeneous layer of sample A2 is intrinsic the first 1/4 of deposition time and the heterogeneous layer of sample A3 is intrinsic the first 3/4 of deposition time. The overall deposition and anneal time is the same for all the samples. After the first anneal at 800°C to 900°C a second anneal in forming gas atmosphere was performed to hydrogenate the samples. The lower the concentration of Boron (B) in the heterogeneous layer, the higher the passivation quality of the contact, before and after FGA. Additionally, an increase of the annealing dwell temperature from 800°C to 900°C, which causes stronger in-diffusion of boron to the silicon wafer and leads to an increase of the lifetime meaning an increase of passivation quality for a heterogeneous layer doped with Boron.

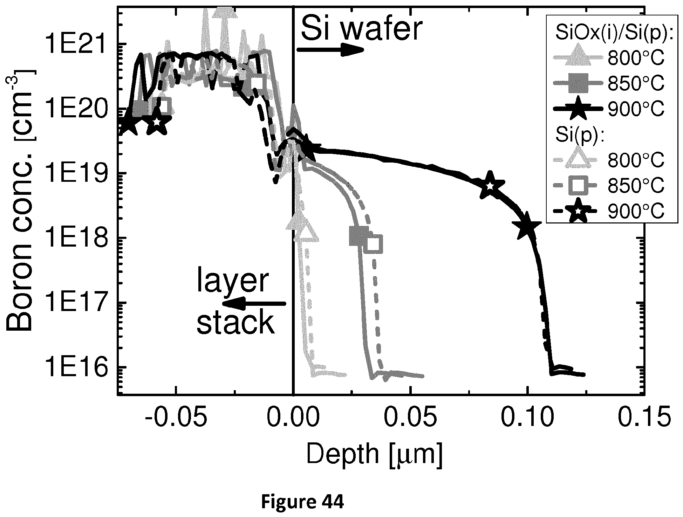

Figure 44 represent the B concentration as function of depth with 0 $\mu$m being the interface between the buffer layer and the Si wafermeasured by electrochemcial capacitance voltage profiling (ECV) for 3 different anneal dwell temperatures. The samples marked "SiOx(i)/Si(p)" refer to a structure as sketched in Figure 22 , which comprises a buffer layer (here: SiO2), a heterogeneous layer and a conductive layer (here: Si(p)) on a p-type wafer. The heterogeneous layer is prepared without doping in the first 3/4 of the layer thickness, and with boron doping in the last 1/4 of layer thickness. The samples marked "Si(p)" are prepared analogously but the heterogeneous (SiOx(i) layer is omited here. The overall deposition time for both structures are the same. The anneal time at the 3 different anneal dwell temperatures was 15min. The diffusion profile between the two layer structures for each anneal dwell temperature are very similar. This shows that an intrinsic SiOx(i) interlayer between doping source layer (Si(p)) and wafer is not hindering the boron in-diffusion dramatically. Please also note that the boron profile in the layer stack is oscillating by a factor of 12, but is smoother for longer annealing. This could be explained by a reduction of dopant segregation within the layer due to an increase of the temperature of annealing.

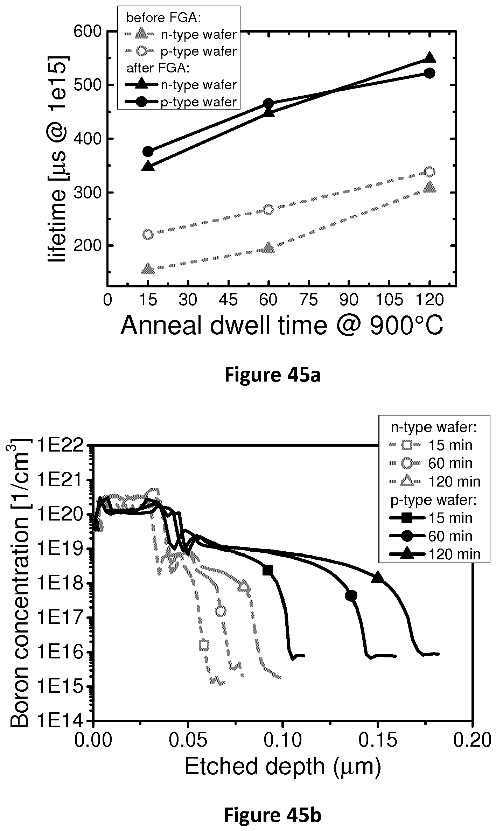

Figure 45a shows the effective minority carrier lifetimes for annealing dwell times between 15-120 min at 900°C. Symmetrical samples with a structure like described in Figure 39a is used on flat substrates where the deposited heterogeneous layer is prepared as an intrinsic heterogeneous multilayer with a dhlr of 1 (here: SiOx(i)) and the deposited conduction layer (here: Si(p)) doped with Boron on both sides of p-type wafers as well as on n-type wafers. An increased anneal dwell time leads on both wafer types to an increased passivation (seen as increase in lifetime) before a hydrogenation by FGA is processed and afterwards.

Figure 45b shows the Boron doping profiles after an annealing at 900°C for a dwell time between 15-120 min. Samples with a structure like described in Figure 39a is used on flat substrates where the deposited heterogeneous layer is prepared as an intrinsic heterogeneous multilayer with a dhlr of 1 (here: SiOx(i)) and the deposited conduction layer (here: Si(p)) doped with Boron on both sides of p-type wafers as well as on n-type wafers.. A longer anneal dwell time leads to a deeper profile on both wafer types. As seen for Phosphorous diffusion in Figure 33a and Figure 33b, also Boron diffuses deeper and with higher concentration into p-type wafer than n-type wafer.

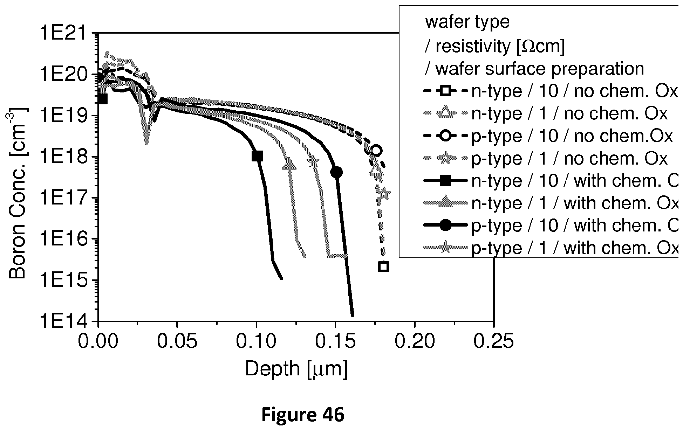

Figure 46 shows the Boron doping concentrations as function of depth in the Si wafer measured by ECV. A design like described in Figure 39a (with and without buffer layer 10) is used on flat substrates where the deposited heterogeneous layer is prepared as an intrinsic heterogeneous multilayer with a dhlr of 2 (here: SiOx(i)) and the deposited conduction layer (here: Si(p)) doped with Boron. The shown ECV doping profiles were measured after samples had been annealed at 900°C for 15min. All presented samples in this figure were co-processed (growth of the chemical oxide, PECVD deposition, anneal). The only difference between the samples were the wafer doping type, concentration and a removal of the chem. SiOx buffer layer before PECVD deposition. When the buffer layer (layer 10 in Figure 39b) is removed by HF before PECVD deposition (layer 4 and layer 6) the in-diffusion of Boron is similar for the different doping types and concentration types of the wafer. But when a chemical oxide buffer layer is present the differences between doping type and concentration has a strong influence on the in-diffusion of Boron which we relate to a different growth of the buffer layer, mainly resulting in a different thickness. On p-type wafers the in-diffusion is stronger (deeper and with higher concentration) than on n-type wafers pointing towards a thinner buffer layer. By changing the concentration of the base/surface doping of the wafer, the in-diffusion is also changed. For p-type wafers we observe that the higher the doping the weaker the in-diffusion of boron. For n-type wafers this is the opposite with a higher wafer doping concentration showing a deeper diffusion profile of boron. These results demonstrate that choosing an appropriate surface concentration of the silicon wafer allows to adjust the silicon oxide buffer layer thickness and consequently the profile of in-diffused species (here boron).

Figure 47a depicts thickness (Å) maps of the silicon oxide buffer layer prepared on a 2.8 Ohmcm p-type wafer. The layer thickness was measured by variable angle spectral ellipsometry and is reported in Angstroms. Silicion oxide layer was grown in a 69% HNO3 solution at 80 °C for 10 minutes. The delay between HNO3 exposure and measurement was the same for the two wafers shown in Figure 44a and Figure 44b. The thickness average is 12.1 Å for the p-type wafer.

Figure 47b depicts thickness maps of the silicon oxide buffer layer prepared on a 2.8 Ohmcm n-type wafer. The layer thickness was measured by variable angle spectral ellipsometry and is reported in Angstroms. Silicion oxide layer was grown in a 69% HNO3 solution at 80 °C for 10 minutes. The delay between HNO3 exposure and measurement was the same for the two wafers shown in Figure 44a and Figure 44b. The thickness average is 14.8 Å for the n-type wafer. This confirms that the differences in dopant in-diffusion reported in Figure 33a, Figure 33b, Figure 36, Figure 39b, Figure 46 and Figure 45b is indeed caused by a thickness difference of the buffer layer which changes by the (surface) doping concentration of the wafer used.

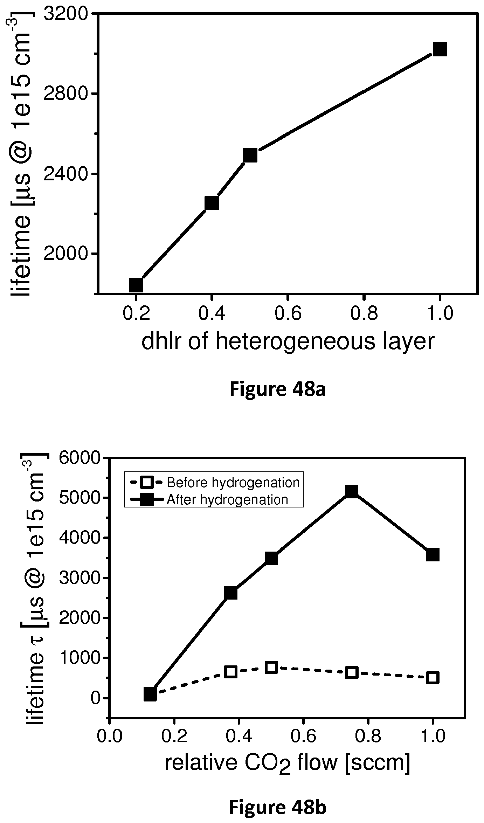

Figure 48a shows the effective minority charge carrier lifetime measured by Photoconductance Decay (PCD) measurements of symmetrical samples as described in Figure 22 after an annealing at 900°C for 15min with a deposited structure as described in Figure 39a on both sides of the wafer. The structure contains in the as deposited state a p-type silicon wafer 1, a SiOx buffer layer10, SiOx(i) as heterogeneous multilayer with varying dhlr and Boron doped SiOx(p) as 6. An increase of the dhlr from 0.2 to 1 leads to an increase in lifetime from 1845 $\mu$s to 3021 $\mu$s. Since a higher dhlr means in this case a higher oxygen content in the heterogeneous layer, this results point out the beneficial effect of the additional oxide portion of the heterogeneous layer on the passivation behavior.

Figure 48b shows the effective minority charge carrier lifetime measured by Photoconductance Decay (PCD) measurements of symmetrical samples after an annealing at 900°C for 15min with a deposited structure as described in Figure 39a on both sides of the wafer. The structure contains in the as deposited state a p-type silicon wafer as 1, $SiO_2$ as 10, SiOx(i) as heterogeneous multilayer with a dhlr of 2 and boron doped Si(p) as 6. In this experiment, the relative flow of the precursor gas $CO_2$ during the PECVD deposition of the heterogeneous layer was varied from 1/8 to 1. Without any further treatment after the 900°C anneal, the addition of $CO_2$ lead to an increase in lifetime from 88 $\mu$s to 763 $\mu$s at a relative $CO_2$ flow of ½, and a decrease for relative $CO_2$ flows between ½ and 1. After an additional hydrogenation by annealing in forming gas at 500°C, the lifetime increases from 117 $\mu$s for a relative $CO_2$ flux of 1/8 up to 5158 $\mu$s for a relative $CO_2$ flux of 3/4. Since a higher relative $CO_2$ flux during the deposition leads to a higher oxygen content in the heterogeneous layer, this result points out the beneficial effect of an additional oxide compound on the passivation behavior obtained after the 900°C anneal.

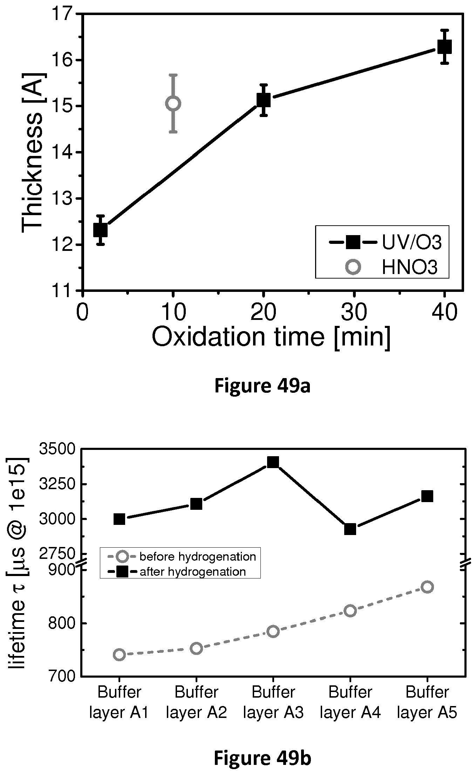

Figure 49a shows the thickness, measured by ellipsometry, as a function of the silicon oxidation time in an 03 atmosphere produced by a UV lamp after the surface was conditioned by an 60 s dip in 5% HF solution. By increasing the oxidation time from 2 min to 40 min the thickness is increased from 12.3 to 16.3 Angstrom. For comparison, an oxide prepared by a solution of 69% $HNO_3$ at 80°C for 10 minutes, is shown to lead to a similar thickness like 20 min in 03 atmosphere. The silicon oxide layer prepared by exposure to 03 or $HNO_3$ are possible layers to be used as buffer layer.

Figure 49b shows the shows the effective minority charge carrier lifetime measured by Photoconductance Decay (PCD) measurements of symmetrical samples after an annealing at 900°C for 15min. A structure as described in 39a was fabricated on both sides of the wafer for which all samples contain the same heterogeneous layer (here: SiOx(i)) and the same boron doped conductive layer (here: Si(p)). The difference between the samples is the buffer layer. Buffer layer A1 is grown by immersion of the silicon wafer in a solution of 69% $HNO_3$ at 80°C for 10 minutes, buffer layer A2 is grown by the same process employed for A1 followed by a treatment by UV and 03 of 10min, buffer layer A3 is grown by the same process employed for A1 plus a treatment by UV and 03 of 20min, buffer layer A4 is grown by a treatment of UV and 03 of 10min, buffer layer A5 is grown by a treatment of UV and 03 of 20min. The lifetime before hydrogenation is increasing from sample with buffer layer A1 to sample with buffer A5, i.e. the lifetime increase correlates with the silicon oxide layer thickness. After hydrogenation by FGA the lifetime is increasing from samples with buffer layer A1 to buffer layer A3, which shows the highest lifetime of all 5 buffer layers. Sample with buffer layer A5 shows higher lifetime after hydrogenation than sample with buffer layer A4. This shows the influence of the buffer layer thickness, density and characteristics described in figure 49a and figure 49b on the passivation.

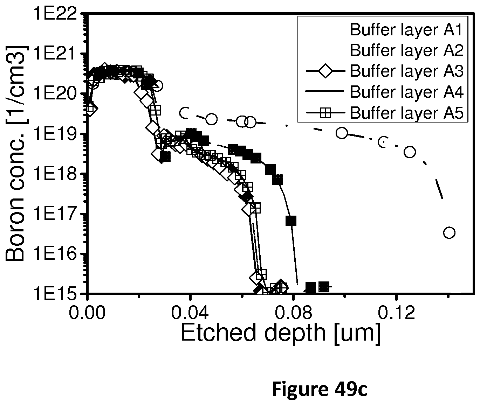

Figure 49c shows the boron doping concentrations as function of depth in the Si wafer measured by ECV for 5 different buffer layers where 0 nm is the surface of the conductive layer (here: Si(p)). A structure as described in 39a was fabricated for which all samples contain the same heterogeneous layer (here: SiOx(i)) and the same boron doped conductive layer (here: Si(p)). The difference between the samples are the buffer layer. Buffer layer A1 is grown by a solution of 69% $HNO_3$ at 80°C for 10 minutes, buffer layer A2 is grown by a solution of 69% $HNO_3$ at 80°C for 10 minutes plus a treatment by UV and 03 of 10min, buffer layer A3 is grown by a solution of 69% $HNO_3$ at 80°C for 10 minutes plus a treatment by UV and 03 of 20min, buffer layer A4 is grown by a treatment of UV and 03 of 10min, buffer layer A5 is grown by a treatment of UV and 03 of 20min. The doping profile of the sample with buffer layer A1 shows the deepest profile which is clearly shallower for sample with buffer layer A2 and A3, pointing towards a thicker and denser buffer layer by adding oxidation time in 03 atmosphere. The same can be seen comparing buffer layer A4 and buffer layer A5 where the sample with buffer layer A4 shows a deeper doping profile. Comparing the samples with buffer layer A1 and sample with buffer layer A4, which both have the same thickness (see figure 49a), a deeper profile is observed for sample with buffer layer A1. This evidences the stronger diffusion barrier function of the buffer layer prepared by UV and 03 (buffer layer A4) treatment compared to the buffer layer prepared in $HNO_3$ (buffer layer A), probably to be explained with a higher density.

## Claims

1. A solar cell comprising a light absorbing silicon layer (1), having a first surface (1a) and a second surface (1b) opposite to said first surface (1a), wherein it further comprises a heterogeneous layer (4) arranged on said first surface (1a) and/or on said second surface (1b), having a front surface (5) and a back surface (3) opposite to each other, said back surface (3) being oriented to the side of said first surface (1a), the heterogeneous layer (4) comprising an electrically low-conducting matrix (4b) made of silicon oxide, said matrix (4b) having a refractive index lower than 3, the heterogeneous layer (4) further comprising electrically conducting inclusions (4a) in said matrix (4b), **characterized in that** said inclusions (4a) are silicon filaments extending through said heterogenous layer (4), at least a portion of said inclusions (4a) being electrically interconnected such that they form a charge carrier transport path from said back surface (3) to said front surface (5), so that said back surface (3) is electrically connected to said front surface (5).

2. Solar cell according to claim 1 wherein the heterogeneous layer (4) has a higher electrical conductivity in a direction intersecting the plane of said heterogeneous layer (4).

3. Solar cell according to any one of claims 1 to 2, wherein the solar cell comprises a first heterogeneous layer (4) arranged on said first surface (1a) and a second heterogeneous layer (40) on said second surface (1b).

4. A method of fabrication of a solar cell according to one of claims 1 to 3 comprising the steps of:

a) providing a doped silicon wafer having a doping concentration smaller than 1E1 cm$^{-3}$;

b) applying a surface texture on at least one side of the silicon wafer;

c) cleaning the silicon wafer in a chemical solution;

d) growing a layer stack (2) containing at least one heterogeneous layer (4) comprising an electrically low-conducting matrix (4b) and electrically-conducting inclusions (4a), preferably by a PECVD or LPCVD or sputtering technique;

e) providing a first annealing step within a temperature range of 300°C-1100°C during 1s to 600min.

5. Method of fabrication according to claim 4 wherein, during step d) or e), or after step e), hydrogen or fluorine is transmitted through the heterogeneous layer (4) to the silicon wafer absorber (1), or to at least one of any layer deposited on the silicon wafer absorber (1).

6. Method of fabrication according to claim 4 or 5, wherein hydrogen or fluorine is distributed by a capping layer (12) and/or by the heterogeneous layer (4) to at least one of the layers deposited on said silicon absorber (1), and/or to said first surface (1a) or said second surface (1b) and/or to the inside of the silicon absorber wafer (1).

7. Method of fabrication according to any one of claims 4 to 6, wherein between step c) and d) additional steps are carried out, comprising the steps c1-c2:

c1) removing a surface oxide layer created by the cleaning carried out in step c);

c2) arranging a thin buffer layer (10) on said first surface (1a) or said second surface (1b), said thin buffer layer preferentially comprising one of the materials: Si-based oxides (such as SiOx, SiOxNy, SiOxCy which may also contain further elements), Si-based nitrides (such as SiNx, SiOxNy, SiNxCy), AlOx, HfOx, AlHfOx, AlNx, TiNx, ZrOx, Y2Ox, AlSiOx, HfSiOx, AlHfSiOx,

amorphous Si compounds such as a-Si, a-SiCx, a-SiNx, a-SiOx, of which at least one compound may contain hydrogen, fluorine, phosphorous, boron, and other elements.

8. Method of fabrication according to claim 7, wherein step c2) is replaced or followed by a further step c3) comprising the exposition of said first surface (1a) and/or said second surface (1b) to HNO3 and/or UV light and/or O$_3$, and/or an oxygen-containing plasma and/or 02 and/or or H2O.

9. Method of fabrication according to one of claims 4 to 8 wherein step d) comprises arranging a capping layer (12) on the formed layer stack (2).

10. Method of fabrication according to any one of claims Z 4 to 9 wherein after step e) further steps e1-e2 are carried out:

e1) arranging at least one capping layer (12) on said formed layer stack (2);

e2) performing a second annealing step within a temperature range of 300° C-1100°C during 1s to 600min, wherein hydrogen or fluorine is distributed from a capping layer (12) or the heterogeneous layer (4) to anyone of the layers deposited on said silicon absorber (1), or to said first surface (1a) or said second surface (1b) or to the inside of the silicon absorber wafer (1).

11. Method of fabrication according to any one of claims 4 to 10 wherein:

- before step e) or e1) or e2) a hydrogen containing layer is arranged on said second surface (1b) and

- said hydrogen containing layer releases hydrogen during at least one of steps e or e1 or e2, and the hydrogen is transmitted by said silicon absorber 1 to said first surface (1a).

12. Method of fabrication according to claim 4 to 11 wherein:

   - before step e) or e1) or e2) a fluorine containing layer is arranged on said second surface (1b) and
   - said fluorine containing layer releases fluorine during at least one of steps e or e1 or e2, and the fluorine is transmitted by said silicon absorber (1) to said first surface (1a).

13. Method of fabrication according to any one of claims 4 to 12 comprising a step of removing at least partially said capping layer (12) after transmitting hydrogen and/or fluorine through the heterogeneous layer (4) to the silicon wafer absorber (1) or any layer formed on the silicon wafer absorber (1).

14. Method of fabrication according to any one of claims 4 to 13 wherein after step c) further steps are carried out comprising defining sites of preferential growth of said inclusions (4a) on said first surface (1a), preferably by treating said first surface (1a) with an oxygen-containing plasma.


**Patentansprüche**

1. Solarzelle, umfassend eine lichtabsorbierende Siliciumschicht (1), die eine erste Oberfläche (1a) und eine zweite Oberfläche (1b) gegenüber der ersten Oberfläche (1a) aufweist, wobei sie ferner eine heterogene Schicht (4) umfasst, die auf der ersten Oberfläche (1a) und/oder der zweiten Oberfläche (1b) angeordnet ist und die eine vorderseitige Oberfläche (5) und eine rückseitige Oberfläche (3), die einander gegenüberliegen, aufweist, wobei die rückseitige Oberfläche (3) zu der Seite der ersten Oberfläche (1a) gerichtet ist, wobei die heterogene Schicht (4) eine elektrisch wenig leitfähige Matrix (4b) aus Siliciumoxid umfasst, wobei die Matrix (4b) einen Brechungsindex von unter 3 aufweist, wobei die heterogene Schicht (4) ferner elektrisch leitfähige Einschlüsse (4a) in der Matrix (4b) umfasst, **dadurch gekennzeichnet, dass** die Einschlüsse (4a) Siliciumfilamente sind, die durch die heterogene Schicht (4) verlaufen, wobei wenigstens ein Teil der Einschlüsse (4a) elektrisch miteinander verbunden sind, so dass sie einen Ladungsträgertransportweg von der rückseitigen Oberfläche (3) zu der vorderseitigen Oberfläche (5) bilden, so dass die rückseitige Oberfläche (3) elektrisch mit der vorderseitigen Oberfläche (5) verbunden ist.

2. Solarzelle gemäß Anspruch 1, wobei die heterogene Schicht (4) eine höhere elektrische Leitfähigkeit in einer Richtung, die die Ebene der heterogenen Schicht (4) schneidet, aufweist.

3. Solarzelle gemäß einem der Ansprüche 1 bis 2, wobei die Solarzelle eine erste heterogene Schicht (4), die auf der ersten Oberfläche (1a) angeordnet ist, und eine zweite heterogene Schicht (40) auf der zweiten Oberfläche (1b) umfasst.

4. Verfahren zur Herstellung einer Solarzelle gemäß einem der Ansprüche 1 bis 3, umfassend die Schritte:

   a) Bereitstellen eines dotierten Siliciumwafers mit einer Dotierstoffkonzentration von weniger als 1E17 cm$^{-3}$;
   b) Aufbringen einer Oberflächentextur auf wenigstens eine Seite des Siliciumwafers;
   c) Reinigen des Siliciumwafers in einer chemischen Lösung;
   d) Aufbringen eines Schichtstapels (2), der wenigstens eine heterogene Schicht (4) umfasst, die eine elektrisch wenig leitfähige Matrix (4b) und elektrisch leitfähige Einschlüsse (4a) enthält, vorzugsweise durch ein PECVD- oder LPCVD- oder Sputterverfahren;
   e) Durchführen eines ersten Temperschritts in einem Temperaturbereich von 300 °C bis 1100 °C während 1 s bis 600 min.

5. Verfahren zur Herstellung gemäß Anspruch 4, wobei während Schritt d) oder e) oder nach Schritt e), Wasserstoff oder Fluor durch die heterogene Schicht (4) auf den Siliciumwafer-Absorber (1) oder auf wenigstens eine auf dem Siliciumwafer-Absorber (1) aufgebrachte Schicht übertragen wird.

6. Verfahren zur Herstellung gemäß Anspruch 4 oder 5, wobei Wasserstoff oder Fluor von einer Deckschicht (12) und/oder von der heterogenen Schicht auf wenigstens eine der auf den Siliciumabsorber (1) aufgebrachten Schichten und/oder auf die erste Oberfläche (1a) oder die zweite Oberfläche (1b) und/oder in das Innere des Siliciumabsorberwafers (1) verteilt wird.

7. Verfahren zur Herstellung gemäß einem der Ansprüche 4 bis 6, wobei zwischen Schritt c) und d) zusätzliche Schritte durchgeführt werden, umfassend die Schritte c1-c2:

> c1) Entfernen einer durch das bei Schritt c) durchgeführte Reinigen erzeugten Oberflächenoxidschicht;
> c2) Aufbringen einer dünnen Pufferschicht (10) auf die erste Oberfläche (1a) oder die zweite Oberfläche (1b), wobei die dünne Pufferschicht vorzugsweise eines der Materialen umfasst: Oxide auf Si-Basis (wie z.B. $SiO_x$, $SiO_xN_y$, $SiO_xC_y$, die auch weitere Elemente enthalten können), Nitride auf Si-Basis (wie z.B. $SiN_x$, $SiO_xN_y$, $SiN_xC_y$), $AlO_x$, $HfO_x$, $AlHfO_x$, $AlN_x$, $TiN_x$, $ZrO_x$, $Y_2O_x$, $AlSiO_x$, $HfSiO_x$, $AlHfSiO_x$, amorphe Si-Verbindungen, wie z.B. a-Si, $a\text{-}SiC_x$, $a\text{-}SiN_x$, $a\text{-}SiO_x$, wovon wenigstens eine Verbindung Wasserstoff, Fluor, Phosphor, Bor und andere Elemente enthalten kann.

8. Verfahren zur Herstellung gemäß Anspruch 7, wobei Schritt c2) durch einen weiteren Schritt c3) ersetzt ist oder davon gefolgt wird, umfassend Exponieren der ersten Oberfläche (1a) und/oder der zweiten Oberfläche (1b) gegenüber $HNO_3$ und/oder UV-Licht und/oder $O_3$ und/oder einem sauerstoffhaltigen Plasma und/oder $O_2$ und/oder $H_2O$.

9. Verfahren zur Herstellung gemäß einem der Ansprüche 4 bis 8, wobei Schritt d) das Aufbringen einer Deckschicht (12) auf den gebildeten Schichtstapel (2) umfasst.

10. Verfahren zur Herstellung gemäß einem der Ansprüche 4 bis 9, wobei nach Schritt e) weitere Schritte e1-e2 durchgeführt werden:

> e1) Aufbringen wenigstens einer Deckschicht (12) auf den gebildeten Schichtstapel (2);
> e2) Durchführen eines zweiten Temperschritts in einem Temperaturbereich von 300 °C bis 1100 °C während 1 s bis 600 min, wobei Wasserstoff oder Fluor von einer Deckschicht (12) oder der heterogenen Schicht (4) auf eine der auf den Siliciumabsorber (1) aufgebrachten Schichten oder auf die erste Oberfläche (1a) oder die zweite Oberfläche (1b) oder in das Innere des Siliciumabsorberwafers (1) verteilt wird.

11. Verfahren zur Herstellung gemäß einem der Ansprüche 4 bis 10, wobei:

> - vor Schritt e) oder e1) oder e2) eine wasserstoffhaltige Schicht auf die zweite Oberfläche (1b) aufgebracht wird und
> - die wasserstoffhaltige Schicht während wenigstens einem der Schritte e) oder e1) oder e2) Wasserstoff freigibt und der Wasserstoff von dem Siliciumabsorber (1) auf die erste Oberfläche (1a) übertragen wird.

12. Verfahren zur Herstellung gemäß Anspruch 4 bis 11, wobei:

> - vor Schritt e) oder e1) oder e2) eine fluorhaltige Schicht auf die zweite Oberfläche (1b) aufgebracht wird und
> - die fluorhaltige Schicht während wenigstens einem der Schritte e) oder e1) oder e2) Fluor freigibt und das Fluor von dem Siliciumabsorber (1) auf die erste Oberfläche (1a) übertragen wird.

13. Verfahren zur Herstellung gemäß einem der Ansprüche 4 bis 12, umfassend einen Schritt des wenigstens teilweisen Entfernens der Deckschicht (12) nach Übertragen von Wasserstoff und/oder Fluor durch die heterogene Schicht (4) auf den Siliciumwafer-Absorber (1) oder eine auf dem Siliciumwafer-Absorber (1) gebildete Schicht.

14. Verfahren zur Herstellung gemäß einem der Ansprüche 4 bis 13, wobei nach Schritt c) weitere Schritte durchgeführt werden, umfassend das Definieren von Stellen mit bevorzugtem Wachstum der Einschlüsse (4a) auf der ersten Oberfläche (1a), vorzugsweise durch Behandeln der ersten Oberfläche (1a) mit einem sauerstoffhaltigen Plasma.

## Revendications

1. Cellule solaire comprenant une couche de silicium absorbante de lumière (1), ayant une première surface (1a) et une deuxième surface (1b) à l'opposé de ladite première surface (1a), comprenant en outre une couche hétérogène (4) disposée sur ladite première surface (1a) et/ou sur ladite deuxième surface (1b), ayant une surface avant (5) et une surface arrière (3) à l'opposé l'une de l'autre, ladite surface arrière (3) étant orientée vers le côté de ladite première surface (1a), la couche hétérogène (4) comprenant une matrice à faible conductivité électrique (4b) fait en oxyde de silicium, ladite matrice (4b) ayant un indice de réfraction inférieur à 3, la couche hétérogène (4) comprenant en outre des inclusions électriquement conductrices (4a) dans ladite matrice (4b), **caractérisée en ce que** lesdites inclusions (4a) sont des filaments de silicium s'étendant à travers ladite couche hétérogène (4), au moins une partie desdites inclusions (4a) étant interconnectées électriquement de telle sorte qu'elles forment un chemin de transport de porteurs de charge depuis ladite surface arrière (3) jusqu'à ladite surface avant (5), de telle sorte que ladite surface arrière (3) est reliée électriquement à ladite surface avant (5).

2. Cellule solaire selon la revendication 1 dans laquelle la couche hétérogène (4) a une plus forte conductivité électrique dans une direction coupant le plan de ladite couche hétérogène (4).

3. Cellule solaire selon l'une quelconque des revendications 1 à 2, la cellule solaire comprenant une première couche hétérogène (4) disposée sur ladite première surface (1a) et une deuxième couche hétérogène (40) sur ladite deuxième surface (1b).

4. Procédé de fabrication d'une cellule solaire selon une des revendications 1 à 3, comprenant les étapes de :

   a) obtention d'une tranche de silicium dopé ayant une concentration de dopage inférieure à $1.10^{17}$ cm$^{-3}$ ;
   b) application d'une texture de surface sur au moins un côté de la tranche de silicium ;
   c) nettoyage de la tranche de silicium dans une solution chimique ;
   d) croissance d'un empilement de couches (2) contenant au moins une couche hétérogène (4) comprenant une matrice à faible conductivité électrique (4b) et des inclusions électriquement conductrices (4a), de préférence par une technique de PECVD ou de LPCVD ou de pulvérisation cathodique ;
   e) application d'une première étape de recuit dans une gamme de températures de 300 °C-1100 °C pendant 1 s à 600 min.

5. Procédé de fabrication selon la revendication 4 dans lequel, pendant l'étape d) ou e), ou après l'étape e), de l'hydrogène ou du fluor est transmis à travers la couche hétérogène (4) à la tranche de silicium absorbante (1), ou à au moins une couche quelconque déposée sur la tranche de silicium absorbante (1).

6. Procédé de fabrication selon la revendication 4 ou 5, dans lequel de l'hydrogène ou du fluor est distribué par une couche de couverture (12) et/ou par la couche hétérogène à au moins une des couches déposées sur ledit absorbeur en silicium (1), et/ou à ladite première surface (1a) ou ladite deuxième surface (1b) et/ou à l'intérieur de la tranche de silicium absorbante (1).

7. Procédé de fabrication selon l'une quelconque des revendications 4 à 6 dans lequel, entre les étapes c) et d), des étapes supplémentaires sont réalisées, comprenant les étapes c1-c2 :

   c1) retrait d'une couche d'oxyde de surface créée par le nettoyage réalisé à l'étape c) ;
   c2) mise en place d'une couche mince tampon (10) sur ladite première surface (1a) ou ladite deuxième surface (1b), ladite couche mince tampon comprenant de préférence un des matériaux suivants : oxydes à base de Si (tels que $SiO_x$, $SiO_xN_y$, $SiO_xC_y$ qui peuvent également contenir d'autres éléments), nitrures à base de Si (tels que $SiN_x$, $SiO_xN_y$, $SiN_xC_y$), $AlO_x$, $HfO_x$, $AlHfO_x$, $AlN_x$, $TiN_x$, $ZrO_x$, $Y_2O_x$, $AlSiO_x$, $HfSiO_x$, $AlHfSiO_x$, composés de Si amorphes tels que a-Si, a-SiC$_x$, a-SiN$_x$, a-SiO$_x$, dont au moins un composé peut contenir de l'hydrogène, du fluor, du phosphore, du bore, et d'autres éléments.

8. Procédé de fabrication selon la revendication 7, dans lequel l'étape c2) est remplacée ou suivie par une étape supplémentaire c3) comprenant l'exposition de ladite première surface (1a) et/ou ladite deuxième surface (1b) à $HNO_3$ et/ou un rayonnement UV et/ou $O_3$, et/ou un plasma contenant de l'oxygène et/ou $O_2$ et/ou $H_2O$.

9. Procédé de fabrication selon une des revendications 4 à 8 dans lequel l'étape d) comprend la mise en place d'une couche de couverture (12) sur l'empilement de couches formé (2).

10. Procédé de fabrication selon l'une quelconque des revendications 4 à 9 dans lequel, après l'étape e), les étapes supplémentaires e1-e2 sont réalisées :

   e1) mise en place d'au moins une couche de couverture (12) sur ledit empilement de couches formé (2) ;
   e2) réalisation d'une deuxième étape de recuit dans une gamme de températures de 300 °C-1100 °C pendant 1 s à 600 min, dans laquelle de l'hydrogène ou du fluor est distribué depuis une couche de couverture (12) ou la couche hétérogène (4) à l'une quelconque des couches déposées sur ledit absorbeur en silicium (1), ou à ladite première surface (1a) ou ladite deuxième surface (1b) ou à l'intérieur de la tranche de silicium absorbante (1).

11. Procédé de fabrication selon l'une quelconque des revendications 4 à 10 dans lequel :

- avant l'étape e) ou e1) ou e2), une couche contenant de l'hydrogène est mise en place sur ladite deuxième surface (1b) et
- ladite couche contenant de l'hydrogène libère de l'hydrogène pendant au moins une des étapes e) et e1) et e2), et l'hydrogène est transmis par ledit absorbeur en silicium (1) à ladite première surface (1a).

12. Procédé de fabrication selon l'une quelconque des revendications 4 à 11 dans lequel :

- avant l'étape e) ou e1) ou e2), une couche contenant du fluor est mise en place sur ladite deuxième surface (1b) et
- ladite couche contenant du fluor libère du fluor pendant au moins une des étapes e) et e1) et e2), et le fluor est transmis par ledit absorbeur en silicium (1) à ladite première surface (1a).

13. Procédé de fabrication selon l'une quelconque des revendications 4 à 12 comprenant une étape de retrait au moins partiel de ladite couche de couverture (12) après transmission d'hydrogène et/ou de fluor à travers la couche hétérogène (4) à la tranche de silicium absorbante (1) ou n'importe quelle couche formée sur la tranche de silicium absorbante (1).

14. Procédé de fabrication selon l'une quelconque des revendications 4 à 13 dans lequel, après l'étape c), des étapes supplémentaires sont réalisées, comprenant la définition de sites de croissance préférentielle desdites inclusions (4a) sur ladite première surface (1a), de préférence par traitement de ladite première surface (1a) avec un plasma contenant de l'oxygène.

**Figure 1a**

**Figure 1b**

Figure 1c

**Figure 2a**

**Figure 2b**

**Figure 3a**

**Figure 3b**

Figure 3c

Figure 3d

Figure 4a

Figure 4b

Figure 4c

Figure 4d

**Figure 5a**

**Figure 5b**

**Figure 6a**

**Figure 6b**

**Figure 6c**

**Figure 6d**

**Figure 6e**

Figure 7

Figure 8

302

202

102

1b

1

1a

10

3

4

5

12

300

**Figure 9**

302

202

102

1b

1

1a

10

3

4

5

6

12

300

**Figure 10**

302
202
102
1b
1
1a
100
10
3
4
5
6
12
300

**Figure 11**

302
202
102
1b
1
1a
10
3
4
5
12
300

**Figure 12**

302
202
102
1b
1
1a
10
3
4
5
6
12
300

**Figure 13**

302
40
11
1b
1
1a
10
4
6
12
300

**Figure 14**

**Figure 15**

**Figure 16**

EP 3 446 339 B1

Figure 17

Figure 18

63

Figure 19

Figure 20

**Figure 21a**

**Figure 21b**

**Figure 22**

a as deposited
b 850 °C
c 900 °C
5 nm
5 nm
5 nm
SiO$_x$ wafer

**Figure 23**

**Figure 24**

**Figure 25**

Figure 26

**Figure 27a**

**Figure 27b**

**Figure 28a**

**Figure 28b**

**Figure 29a**

**Figure 29b**

**Figure 30**

**Figure 31**

**Figure 32**

Figure 33a

Figure 33b

Figure 34a

Figure 34b

**Figure 34c**

Figure 35

EP 3 446 339 B1

**Figure 36**

**Figure 37a**

**Figure 37b**

**Figure 38a**

**Figure 38b**

**Figure 39a**

**Figure 39b**

**Figure 40**

**Figure 41**

**Figure 42**

**Figure 43**

**Figure 44**

**Figure 45a**

**Figure 45b**

**Figure 46**

Figure 47a

Figure 47b

**Figure 48a**

**Figure 48b**

**Figure 49a**

**Figure 49b**

**Figure 49c**

**EP 3 446 339 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- International Technology Roadmap forPhotovoltaics(ITRPV). *2014: SEMI,* 31 August 2015, http://www.itrpv.net/Reports/Downloads/2014
- Crystalline silicon solar cells: state-of-the-art and future developments. **S. W. GLUNZ ; R. PREU ; D. BIRO.** Comprehensive renewable energy. Elsevier, 2012, vol. 1, 353-87
- **A. CUEVAS.** Physical model of back line-contact front-junction solar cells. *Journal of Applied Physics,* 2013, vol. 113, 164502
- **K. MASUKO ; M. SHIGEMATSU ; T. HASHIGUCHI ; D. FUJISHIMA ; M. KAI ; N. YOSHIMURA et al.** Achievement of More Than 25% Conversion Efficiency With Crystalline Silicon Heterojunction Solar Cell. *IEEE Journal of Photovoltaics,* November 2014, vol. 4, 1433-1435
- **S. DE WOLF ; M. KONDO.** Boron-doped a-Si:H/c-Si interface passivation: Degradation mechanism. *Applied Physics Letters,* 2007, vol. 91, 112109-1, 3
- **S. DE WOLF ; A. DESCOEUDRES ; Z. C. HOLMAN ; C. BALLIF.** High-efficiency silicon heterojunction solar cells: a review. *Green,* 2012, vol. 2
- **O. SCHULTZ-WITTMANN ; D. DECEUSTER.** *high-efficiency solar cell structures and methods of manufacture,* 2009
- **O. SCHULTZ-WITTMANN ; D. DECEUSTER.** *shielded electrical contact and doping through a passivating dielectric layer in a high-efficiency crystalline solar cell,* 2011
- **F. FELDMANN ; M. HERMLE.** *photoactive semiconductor component and method for producing a photoactive semiconductor component,* 2015
- **F. FELDMANN ; M. BIVOUR ; C. REICHEL ; M. HERMLE ; S. W. GLUNZ.** Passivated rear contacts for high-efficiency n-type Si solar cells providing high interface passivation quality and excellent transport characteristics. *Solar Energy Materials and Solar Cells,* January 2014, vol. 120, 270-274

- **F. GRANEK ; C. REICHEL.** Back-contact back-junction silicon solar cells under UV illumination. *Solar Energy Materials and Solar Cells,* 2010, vol. 94, 1734-40
- **F. FELDMANN ; M. BIVOUR ; C. REICHEL ; H. STEINKEMPER ; M. HERMLE ; S. W. GLUNZ.** *Solar Energy Materials and Solar Cells,* 2014, vol. 131, 46-50
- **F. FELDMANN ; M. SIMON ; M. BIVOUR ; C. REICHEL ; M. HERMLE ; S. W. GLUNZ.** Efficient carrier-selective p- and n-contacts for Si solar cells. *Solar Energy Materials and Solar Cells,* vol. 131, 100-104
- **G. R. WOLSTENHOLME ; N. JORGENSEN ; P. ASHBURN ; G. R. BOOKER.** *Journal of Applied Physics,* 01 January 1987, vol. 61, 225-233
- **F. FELDMANN ; M. BIVOUR ; C. REICHEL ; M. HERMLE ; S. W. GLUNZ.** Passivated rear contacts for high-efficiency n-type Si solar cells providing high interface passivation quality and excellent transport characteristics. *Solar Energy Materials ans Solar Cells,* January 2014, vol. 120, 270-274
- **A. KIMMERLE ; MD. M. RAHMAN ; S. WERNER ; S. MACK ; A. WOLF ; A. RICHTER ; H. HAUG.** Precise parameterization of the recombination velocity at passivated phosphorus doped surfaces. *Jorunal of Applied Physics,* 2016, vol. 119
- **R. R. KING ; R. A. SINTON ; R. M. SWANSON.** Studies of Diffused Phosphorus Emitters: Saturation Current, Surface Recombination Velocity, and Quantum Efficiency. *IEEE Transactions on Electron Devices,* 1990, vol. 37
- **P. P. ALTERMATT ; J. O. SCHUMACHER ; A. CUEVAS ; M. J. KERR ; S. W. GLUNZ ; R. R. KING ; G. HEISER ; A. SCHENK.** Numerical modeling of highly doped Si:P emitters based on Fermi-Dirac statistics and self-consistent material parameters. *Journal of Applied Physics,* 2002, vol. 92